# EUROPEAN PATENT SPECIFICATION

(11) **EP 2 760 264 B1**
(45) Date of publication and mention of the grant of the patent: **24.10.2018**
(21) Application number: 12832830.9
(22) Date of filing: 06.09.2012
(51) Int. Cl.: H05K 13/04, H05K 13/02, H05K 13/08

(54) **ELECTRONIC CIRCUIT COMPONENT MOUNTER**
KOMPONENTENHALTERUNG FÜR EINE ELEKTRONISCHE SCHALTUNG
ÉLÉMENT DE MONTAGE D'UN COMPOSANT DE CIRCUIT ÉLECTRONIQUE

(30) Priority: 21.09.2011 JP 2011206452
(43) Date of publication of application: 30.07.2014
(73) Proprietor: FUJI Corporation, Chiryu Aichi (JP)
(72) Inventor: NOZAWA, Mizuho, Chiryu-shi Aichi 472-8686 (JP); OKADA, Takehito, Chiryu-shi Aichi 472-8686 (JP)
(74) Representative: Grünecker Patent- und Rechtsanwälte PartG mbB
(86) International application number: PCT/JP2012/072710
(87) International publication number: WO 2013/042544

(56) References cited:
- JP-A- H1 146 088
- JP-A- 2001 341 846
- JP-A- 2002 280 793
- JP-A- 2003 037 393
- JP-A- 2004 087 650
- US-A- 5 852 869

## Description

The present invention relates to an electronic-circuit-component placement machine and in particular to an electronic-circuit-component placement machine in which a pickup nozzle and a component supplier are moved together relative to a circuit substrate.

Examples of electronic-circuit-component placement machines include a placement machine described in JP-A-9-199890 below in which a placement unit including pickup nozzles and a bulk feeder as a component supplier is moved by a moving device with respect to a circuit board in an X-axis direction and a Y-axis direction to place electronic circuit components onto the circuit board. The bulk feeder and the pickup nozzles are respectively provided at a component receiving station and a component supplying station set on a placement-unit body. The electronic circuit components to be supplied from the bulk feeder are transferred to the pickup nozzles by a transferring wheel which is provided on the placement-unit body so as to be rotatable in a vertical axis. When the transferring wheel is rotated, a plurality of component holding compartments formed around a rotation axis of the transferring wheel are moved one by one to the component receiving station, and electronic circuit components are fed into each component holding compartment from the bulk feeder. The component holding compartment having received the electronic circuit components are moved to the component supplying station at which the electronic circuit components stored in the component holding compartment are picked up by the pickup nozzles, and the electronic circuit components are moved out of the component holding compartment and placed onto the circuit board.

Also, JP-A-2006-120676 describes an electronic-circuit-component placement machine in which a circuit board is moved in an X-axis direction by a relative-movement device, and a bulk feeder is moved in a Y-axis direction to place electronic circuit components onto a circuit board. This bulk feeder is provided upright in an up and down direction on a rotary body provided on a placement-unit body so as to be rotatable about a vertical axis. The electronic circuit components transferred from an accommodating portion to a supply portion by a component transferring portion are pushed out by a pushing member provided on the bulk feeder and placed onto the circuit board. The rotary body is provided with not only the bulk feeder but also pickup nozzles whose positions in the X-axis direction are changed by rotation of the rotary body, and the pickup nozzles sequentially receive the electronic circuit components from a plurality of tape feeders as component suppliers provided on a placement-machine body, to place the received electronic circuit components onto the circuit board.

In the above-described construction in which the bulk feeder is moved with respect to the circuit board, and the electronic circuit components supplied from the bulk feeder are placed onto the circuit board, efficiency of placement can be improved when compared with a construction in which the bulk feeder is provided at a fixed position, and the pickup nozzles are moved between the bulk feeder and the circuit board to receive and place the electronic circuit components.

Also, JP 2002 280793 A discloses an electronic component placement machine with a movement electronic component supply apparatus that includes a pickup section where a suction nozzle section can descend, an accommodation section for accommodating the electronic components, and a supply section for successively supplying the electronic components that are accommodated into the accommodation section to the pickup section, and is supported by a head for freely moving with the head.

Also, US 5 852 869 A discloses method and apparatus for automatically supplying surface mount chip components from a bulk feeder and placing the chip components on a substrate. The apparatus includes a base frame, a substrate feeding mechanism, a placement head, and a placement head positioning system. The placement head is translationally movable with respect to the base frame and includes a component supplying and placing mechanism, to supply components and place components on a substrate in a desired location. The component supplying and placing mechanism includes a component transfer mechanism, a component feeder, and a vacuum spindle. The transfer mechanism includes a rotatable wheel with a plurality of component holding compartments, a plurality of angularly disposed stations, and a drive mechanism for sequentially moving the compartments to at least a component receiving station and a component delivery station.

### PROBLEM TO BE SOLVED BY THE INVENTION

However, there is still room for improvements in the above-described conventional electronic-circuit-component placement machines. For example, in the electronic-circuit-component placement machine described in Patent Document 1, the bulk feeder and the pickup nozzles are provided such that their relative positions are not changed, and in the electronic-circuit-component placement machine described in Patent Document 2, the pushing member for placing the electronic circuit components onto the circuit board is provided on the bulk feeder. Thus, the pickup nozzles and the pushing member can only place the electronic circuit components supplied by the bulk feeder, onto the circuit board, leading to low usability. In addition, the pickup nozzles described in Patent Document 2 can only place the electronic circuit components received by the tape feeders, onto the circuit board, leading to low usability.

These problems also arise in a case where the electronic circuit components are supplied by a component supplier that differs from the bulk feeder and that is moved with the pickup nozzles.

This invention has been developed in view of the above-described situations, and it is an object of the present invention to improve usability of an electronic-circuit-component placement machine in which a component supplier and a pickup nozzle are moved together relative to a circuit board.

### MEANS FOR SOLVING PROBLEM

The above-described problem is solved by an electronic-circuit-component placement machine according to any of the appended claims 1-10.

### EFFECT OF THE INVENTION

In the electronic-circuit-component placement machine according to the present invention, the pickup nozzle and the supply portion of the component supplier are moved together relative to the circuit substrate. Accordingly, the pickup nozzle can receive the electronic circuit component from the component supplier during the movement, or the pickup nozzle can receive the electronic circuit component in a state in which the pickup nozzle and the supply portion are located at appropriate positions with respect to the circuit substrate, whereby the electronic circuit component can be efficiently received and placed onto the circuit substrate. In addition, since the pickup nozzle and the supply portion of the component supplier are moved relative to each other in the direction intersecting the axial direction of the pickup nozzle, the pickup nozzle can be moved off the supply portion in the direction intersecting the axial direction of the pickup nozzle. Accordingly, the pickup nozzle can perform an operation other than receipt of the electronic circuit component from the supply portion of the component supplier held by the placement-unit body, for example. For example, the pickup nozzle can take out the electronic circuit component from the component supplier held by the placement-machine body without being held by the placement-unit body, and an image of the electronic circuit component held by the pickup nozzle can be taken, resulting in higher efficiency of placement and higher usability of the electronic-circuit-component placement machine. Furthermore, since the pickup nozzle and the component supplier are moved relative to the circuit substrate being in the stationary state, the first relative-movement device can be constructed in a simple manner when compared with a construction in which both of the circuit substrate holder, and the pickup nozzle and the component supplier are moved.

### FORMS OF THE INVENTION

There will be described by way of examples forms of embodiments. The forms are numbered and depend on another form or forms, where appropriate. This is for easier understanding of the claimed invention.

In the following forms, the form 6, when it depends on form (2), meets the terms of claim 1, the form (3) introduces the additional features of claim 2, the form (5) introduces the additional features of claim 3, the form (7) introduces the additional features of claim 4, and the form (8) introduces the additional features of claim 5. A form in which a component-image taking device in the form (10) is replaced with a component supply device described in the explanation for the form (10) corresponds to claim 6. The form 14 introduces the additional features of claim 7, the form 15 introduces the additional features of claim 8, the form 17 introduces the additional features of claim 9, and the form 18 introduces the additional features of claim 10.
(1) An electronic-circuit-component placement machine, comprising:
   a placement-machine body;
   a circuit substrate holder held by the placement-machine body and capable of holding a circuit substrate;
   a placement unit which places the electronic circuit component onto the circuit substrate held by the circuit substrate holder; and
   a first relative-movement device capable of moving the placement unit relative to the circuit substrate holder in a direction parallel to a component-placement surface of the circuit substrate held by the circuit substrate holder,
   the electronic-circuit-component placement machine being configured to cause the placement unit to place the electronic circuit component onto the component-placement surface of the circuit substrate held by the circuit substrate holder,
   the placement unit being characterized by comprising:
      a placement-unit body;
      a pickup nozzle held by the placement-unit body and advanceable and retractable in an axial direction of the pickup nozzle, the pickup nozzle comprising a pickup portion at a front end portion thereof;
      a component supplier held by the placement-unit body and comprising: an accommodating portion which accommodates a plurality of electronic circuit components; a supply portion which supplies the plurality of electronic circuit components one by one; and a component transferring portion which transfers the plurality of electronic circuit components from the accommodating portion to the supply portion;
      a second relative-movement device held by the placement-unit body and capable of moving the pickup nozzle and the supply portion of the component supplier relative to each other in a direction intersecting the axial direction of the pickup nozzle; and
      a first move-toward/away device held by the placement-unit body and capable of moving the pickup nozzle and the supply portion of the component supplier toward and away from each other,
      the electronic-circuit-component placement machine being characterized by further comprising a second move-toward/away device which moves the pickup nozzle and the circuit substrate held by the circuit substrate holder toward and away from each other.

   The first relative-movement device may be designed to move the placement unit to a desired position in a plane extending parallel to the component-placement surface of the circuit substrate held by the circuit substrate holder and may be designed to move the placement unit in one of two directions intersecting in a plane extending parallel to the component-placement surface of the circuit substrate held by the circuit substrate holder and move the circuit substrate holder in the other of the two directions.
   The first move-toward/away device may also serve as the second move-toward/away device. In this case, the move-toward/away device serving as both devices is preferably designed to advance or retract the pickup nozzle in its axial direction to move the pickup nozzle toward or away from the component supplier and toward and away from the circuit substrate held by the circuit substrate holder.
   The number of the pickup nozzles of the placement unit may be one or more, and three or more pickup nozzles may be provided.
   Examples of the circuit substrate include (a) a printed wiring board on which no electronic circuit components have been mounted, (b) a printed circuit board having one side on which electronic circuit components have been mounted and electrically joined and the other side on which no electronic circuit components have been mounted, (c) a substrate on which bare chips are to be mounted and which constitutes a chip-mounted board, (d) a substrate on which a component with a ball grid array is to be mounted, and (e) a substrate having a three-dimensional shape instead of a planar plate shape.
   The component supplier may be a component feeder such as a bulk feeder, a tape feeder, and a stick feeder and may be a tray.
(2) The electronic-circuit-component placement machine according to the above form (1), wherein the circuit substrate holder is kept in a stationary state with respect to the placement-machine body at least during the placement operation for placing the electronic circuit component, and the first relative-movement device is configured to move the placement-unit body relative to the circuit substrate holder being in the stationary state, to a position in a plane extending parallel to the component-placement surface of the circuit substrate held by the circuit substrate holder.
   The first relative-movement device may be a device including a moving member movable in two directions intersecting each other, for example, what is called an X-Y robot and may be a horizontal articulated robot called a SCARA (Selective Compliance Assembly Robot Arm) robot.
(3) The electronic-circuit-component placement machine according to the above form (1) or (2), further comprising:
   a second component supplier different from the component supplier as a first component supplier and held by the placement-machine body without being held by the placement-unit body, the second component supplier comprising: an accommodating portion which accommodates a plurality of electronic circuit components; a supply portion which supplies the electronic circuit components one by one; and a component transferring portion which transfers the electronic circuit components from the accommodating portion to the supply portion; and
   a third move-toward/away device configured to move the supply portion of the second component supplier and the pickup nozzle toward and away from each other.

   The third move-toward/away device may serve as at least a portion of at least one of the first move-toward/away device and the second move-toward/away device.
   The second component supplier may be constituted by any of a component feeder and a tray. In the case where the second component supplier is constituted by the tray, the second component supplier is the second component supplier that differs from the first component supplier held by the placement-machine body without being held by the placement-unit body as described in the form (3), and this second component supplier is designed to include the accommodating portion accommodating the plurality of electronic circuit components arranged in a planar fashion.
   The pickup nozzle and the first component supplier are moved relative to each other in the direction intersecting the axial direction of the pickup nozzle and located at different positions. Thus, the same pickup nozzle can receive the electronic circuit component from not only the first component supplier but also the second component supplier to place the electronic circuit component onto the circuit substrate. It is effective in particular to use the first component supplier in a case where a multiplicity of electronic circuit components of the same kind need to be placed on one circuit substrate. The second component supplier is used for supplying electronic circuit components which cannot be supplied by the first component supplier. It is effective in particular to use the second supplier in a case where the electronic circuit components cannot be supplied by the first component supplier due to their shape, dimensions, electric property, or other characteristics.
   In a case where the placement unit includes one pickup nozzle, the pickup nozzle receives the electronic circuit component selectively from one of the first and second component suppliers. This selection may be carried out for one circuit substrate and may be carried out for a different kind of circuit substrate. In the latter case, the placement unit can be considered to be designed such that a placement unit which receives the electronic circuit component from the first component supplier to place the electronic circuit component onto the circuit substrate and a placement unit which receives the electronic circuit component from the second component supplier to place the electronic circuit component onto the circuit substrate are provided integrally with each other.
   In a case where the placement unit includes a plurality of pickup nozzles, the second component supplier is controlled to supply the electronic circuit components to one circuit substrate with the first component supplier, and only one of the first and second component suppliers may be controlled to supply the electronic circuit components. In the former case, for example, some of the plurality of pickup nozzles may be controlled to receive the electronic circuit components from the first component supplier, and the other pickup nozzles may be controlled to receive the electronic circuit components from the second component supplier. Alternatively, the plurality of pickup nozzles may be controlled to receive the electronic circuit components from the first and second component suppliers alternately. In a case where only one of the first and second component suppliers is controlled to supply the electronic circuit components to the one circuit substrate, the placement unit can be considered to be designed such that the two placement units are provided integrally with each other as described above.
   In a case where each of the plurality of pickup nozzles is designed to be capable of receiving the electronic circuit component from any of the first and second component suppliers, all of the plurality of pickup nozzles can be used to receive and place the electronic circuit components even where any component supplier is used to supply the electronic circuit components. In the electronic-circuit-component placement machine disclosed in JP-A-2006-120676, the electronic circuit components supplied by the bulk feeder are placed onto the circuit board by the pushing member provided on the bulk feeder. Thus, the pushing member of course cannot be used to place the electronic circuit components supplied by the tape feeder onto the circuit board, and the pickup nozzle provided on the rotary body with the bulk feeder can perform only the placement of the electronic circuit components supplied by the tape feeder onto the circuit board. Accordingly, in the case where the electronic circuit components supplied by only one of the bulk feeder and the tape feeder are placed on the circuit board, a device for placing the electronic circuit components supplied by the other of the bulk feeder and the tape feeder cannot be used to place the components onto the circuit board, and only some of a plurality of placing functions of the electronic-circuit-component placement machine can be used, resulting in lower usability and lower efficiency of the placement. In the electronic-circuit-component placement machine in the present form, however, the pickup nozzle can receive the electronic circuit component supplied by any component supplier. Thus, all the pickup nozzles can be used to receive the electronic circuit components supplied by any of the first and second component suppliers, resulting in efficient placement of the electronic circuit components. Furthermore, since the second component supplier is provided, and the pickup nozzle can receive the electronic circuit components from any of the first and second component suppliers, the electronic circuit components can be placed onto the circuit substrate in various manners.
(4) The electronic-circuit-component placement machine according to any one of the above forms (1) through (3),
   wherein the second relative-movement device comprises:
   a nozzle holder which holds the pickup nozzle;
   a movable member which holds the nozzle holder such that the nozzle holder is advanceable and retractable in the axial direction of the pickup nozzle held by the nozzle holder; and
   a movable-member driving device which moves the movable member to move the pickup nozzle held by the nozzle holder selectively to one of a component receiving position at which the pickup nozzle is opposed to the supply portion of the component supplier and a deviated position deviating from the component receiving position in a direction intersecting the axial direction of the pickup nozzle, and
   wherein the first move-toward/away device comprises a nozzle-holder advancing and retracting device which advances and retracts the pickup nozzle held by the nozzle holder to move the pickup nozzle toward and away from the supply portion of the component supplier.
   The first move-toward/away device may be designed to move the component supplier toward and away from the nozzle holder. In most cases, however, the nozzle holder is smaller in size than the component supplier, and accordingly advancing and retracting the nozzle holder are easier than moving the component supplier.
(5) The electronic-circuit-component placement machine according to any one of the above forms (1) through (4), further comprising a component-image taking device held by the placement-unit body and configured to take an image of the electronic circuit component picked up by the pickup portion of the pickup nozzle, in the axial direction of the pickup nozzle.
   Based on the image of the electronic circuit component which is taken by the component-image taking device, an error in a holding position at which the pickup nozzle holds the electronic circuit component can be detected, and the electronic circuit component can be placed onto the circuit substrate with a corrected holding position, for example, resulting in improvement of placement accuracy. The relative movement of the component supplier and the pickup nozzle held by the placement-unit body in the direction intersecting the axial direction of the pickup nozzle allows the component-image taking device to take an image of the electronic circuit component held by the pickup nozzle on the placement-unit body. Accordingly, an image of the electronic circuit component can be taken during the movement of the placement unit by the first relative-movement device, for example, resulting in improved efficiency of the placement. In a case where a plurality of pickup nozzles are held by the placement-unit body in particular, an image of the electronic circuit component can be taken concurrently with at least one of the movement of the pickup nozzle and the component supplier toward and away from each other by the first move-toward/away device and the movement of the pickup nozzle and the circuit substrate toward and away from each other by the second move-toward/away device, resulting in more improved efficiency of the placement.
(6) The electronic-circuit-component placement machine according to the above form (4),
   wherein the movable member comprises a rotary body rotatable about a rotation axis of the rotary body and comprising a peripheral portion which holds the nozzle holder such that the nozzle holder is advanceable and retractable in the axial direction of the pickup nozzle held by the nozzle holder, and
   wherein the movable-member driving device comprises a rotary-body driving device which rotates the rotary body to move the pickup nozzle selectively one of the component receiving position and the deviated position.
   The movable member may be designed to move linearly. However, the rotary body requires a smaller amount of space for its movement, and the placement unit can be made compact, leading to a smaller size of the electronic-circuit-component placement machine.
(7) The electronic-circuit-component placement machine according to the above form (6),
   wherein a plurality of component suppliers each as the component supplier are provided such that a plurality of supply portions thereof each as the supply portion are arranged along one straight line touching a curve (e.g., a circle and an oval) opposing a path of turning of the pickup nozzle which is caused by the rotation of the rotary body, and
   wherein the placement unit comprises a third relative-movement device configured to move the plurality of component suppliers relative to the placement-unit body in a direction parallel to the one straight line to selectively position the plurality of supply portions of the plurality of component suppliers one by one to a component supply position opposing the path of turning of the pickup nozzle.
   The third relative-movement device can also serve as the second relative-movement device, in a case where the electronic-circuit-component placement machine is configured such that the third relative-movement device can move each of the plurality of component suppliers to a position at which any of their respective supply portions is not opposed to the turning path of the pickup nozzle, and the pickup nozzle in this state can receive the electronic circuit component from the second component supplier.
   The first move-toward/away device and the second move-toward/away device may be at least partly combined with each other, and the third move-toward/away device may be at least partly combined with the first move-toward/away device.
(8) The electronic-circuit-component placement machine according to the above form (6) or (7), wherein a plurality of component suppliers each as the component supplier are provided such that a plurality of supply portions thereof each as the supply portion are arranged along a curve (e.g., a circle and an oval) opposing a path of turning of the pickup nozzle which is caused by the rotation of the rotary body.
   The pickup nozzle can receive the electronic circuit component at a plurality of positions on the path of turning of the pickup nozzle which is caused by the rotation of the rotary body, making it possible to increase the type or number of electronic circuit components to be supplied.
   Each component supplier in the present form is the first component supplier in a relationship with the second component supplier described in the form (3).
(9) The electronic-circuit-component placement machine according to any one of the above forms (6) through (8), further comprising a component-image taking device held by the placement-unit body and configured to take an image of the electronic circuit component picked up by the pickup portion of the pickup nozzle, in the axial direction of the pickup nozzle.
   The same advantages as obtained in the electronic-circuit-component placement machine according to the above form (5) can be obtained.
(10) The electronic-circuit-component placement machine according to the above form (9), further comprising a distance increasing unit which increases a distance between the pickup portion of the pickup nozzle and the circuit substrate holder with the rotation of the rotary body,
   wherein the component-image taking device is disposed at a position which faces the pickup portion of the pickup nozzle in the state in which the distance has been increased by the distance increasing unit.
   The component-image taking device needs to be provided at a higher height level than that of the circuit substrate holder to avoid a contact with the circuit substrate holder. In a construction in which the distance increasing unit is provided, the component-image taking device can be disposed in a space formed by the distance increasing unit, allowing the component-image taking device to be provided above the circuit substrate holder without a lower position of the circuit substrate holder with respect to the placement unit or without a higher position of the placement unit with respect to the circuit substrate holder. This makes it possible to prevent an increase in a distance required for the second move-toward/away device to move the pickup nozzle and the circuit substrate held by the circuit substrate holder toward and away from each other, avoiding a longer length of time of the relative movement and a lower efficiency of the placement.
   The distance increasing unit is effective also in a case where the pickup nozzle places the electronic circuit component received from the first component supplier, onto the circuit substrate at a position that differs from the receiving position. That is, the first component supplier is provided in a space defined between the pickup portion and the circuit substrate holder by the distance increasing unit.
   A plurality of the component suppliers may be provided such that the supply portions are arranged along a curve opposing a path of turning of the pickup nozzle which is caused by the rotation of the rotary body or such that the supply portions are arranged along a tangent to the curve, and at least a plurality of supply portions are moved in a direction parallel to the tangent to cause each of the plurality of supply portions to be selectively opposed to the pickup nozzle. In a case where a guide passage for guiding the electronic circuit component moved from the accommodating portion to the supply portion is formed of a flexible material, the supply portion can be moved without any movement of the accommodating portion.
(11) The electronic-circuit-component placement machine according to the above form (10), further comprising:
   a cam follower provided on the nozzle holder; and
   a cam comprising a surface which opposes, in an axial direction of the nozzle holder, a path of turning of the cam follower which is caused by the rotation of the rotary body, the surface serving as a cam surface which changes a position of the cam follower by a change of the surface in the axial direction of the nozzle holder,
   wherein the cam follower and the cam constitute the distance increasing unit.
(12) The electronic-circuit-component placement machine according to the above form (10), wherein the distance increasing unit is constituted by a configuration in which the rotation axis of the rotary body is inclined with respect to a direction perpendicular to the component-placement surface of the circuit substrate held by the circuit substrate holder, and the nozzle holder is held so as to be advanceable and retractable along at least one generatrix of a surface of a circular cone whose center line coincides with the rotation axis and whose diameter decreases with increase in distance from the circuit substrate holder.
(13) The electronic-circuit-component placement machine according to the above form (12), wherein one of the at least one generatrix of the surface of the circular cone is perpendicular to the component-placement surface of the circuit substrate held by the circuit substrate holder, and a position at which an axial direction of the nozzle holder is parallel to the one generatrix is a placement position at which the pickup nozzle held by the nozzle holder places the electronic circuit component onto the component-placement surface.
(14) The electronic-circuit-component placement machine according to any one of the above forms (1) through (13), wherein the component supplier comprises a bulk feeder in which the accommodating portion accommodates the plurality of electronic circuit components in an unjoined state, and the component transferring portion arranges the plurality of electronic circuit components in a row and moves the plurality of electronic circuit components to the supply portion.
   In the tape feeder, the electronic circuit components are held by the component holding tape, requiring disposal of the component holding tape after the electronic circuit components are taken out. In the bulk feeder, in contrast, the electronic circuit components are directly accommodated in the accommodating portion, not requiring any action after the electronic circuit components are taken out such as the disposal of the component holding tape. In this regard, the bulk feeder is appropriate for being provided on the placement-unit body. Also, the tape feeder requires splicing of component holding tapes for resupply of the electronic circuit components, but the bulk feeder only requires easy resupply of the electronic circuit components in unjoined state. Also in this regard, the bulk feeder is appropriate for being provided on the placement-unit body.
(15) The electronic-circuit-component placement machine according to the above form (14), further comprising a component loading device held by the placement-machine body and configured to load the plurality of electronic circuit components in the unjoined state into the accommodating portion of the bulk feeder held by the placement-unit body.
   In the accommodating portion of the bulk feeder, the electronic circuit components are usually moved relatively to arrange the electronic circuit components being in the unjoined state, thereby causing blackening. Accordingly, a minimum necessary amount of electronic circuit components are preferably accommodated in the accommodating portion, and it is effective to provide the component loading device held by the placement-machine body.
   The feature described in this form is effective in particular in a form including the feature described in the form (2). In the electronic-circuit-component placement machine according to the above form (2), the placement unit is moved relative to the circuit substrate holder being in the stationary state, and the blackening also occurs due to the movement. Thus, the feature described in this form is effective in particular.
(16) The electronic-circuit-component placement machine according to the above form (15), further comprising a communicating and interrupting device which establishes a component loading state in which a component receiving opening of the bulk feeder communicates with a component output opening of the component loading device and an interrupting state in which the communication between the component receiving opening and the component output opening is interrupted.
   Provision of the communicating and interrupting device enables the electronic circuit components to be loaded into the accommodating portion at a desired timing.
(17) The electronic-circuit-component placement machine according to the above form (15) or (16), wherein the circuit substrate holder is configured to be kept in the stationary state at least during the placement operation for placing the electronic circuit component, wherein the first relative-movement device is configured to move the placement-unit body relative to the circuit substrate holder being in a stationary state, to a position in a plane extending parallel to the component-placement surface of the circuit substrate held by the circuit substrate holder, and wherein the electronic-circuit-component placement machine further comprises a component loading controller configured to control the first relative-movement device to move the placement-unit body selectively to one of a component loading position at which a component receiving opening of the bulk feeder opposes a component output opening of the component loading device and a spaced position at which the component receiving opening is spaced apart from the component output opening.
   In the electronic-circuit-component placement machine in the present form, the electronic circuit components can be loaded into the accommodating portion automatically. The electronic circuit components may be loaded into the accommodating portion manually by an operator. However, the automatic loading of the electronic circuit components results in less man-hour and improvement in productivity.
(18) The electronic-circuit-component placement machine according to any one of the above forms (15) through (17), further comprising:
   a target-loading-amount setting unit configured to set a target loading amount which is an amount of electronic circuit components to be loaded into the accommodating portion of the bulk feeder held by the placement-unit body;
   an actual-loading-amount detecting device which detects an actual loading amount which is an amount of electronic circuit components loaded from the component loading device; and
   at least one of (a) a loading completion notifier which, when the actual loading amount detected by the actual-loading-amount detecting device has reached the target loading amount set by the target-loading-amount setting unit, notifies the fact and (b) an automatic loading stopper which automatically stops the loading of the component loading device when the actual loading amount detected by the actual-loading-amount detecting device has reached the target loading amount set by the target-loading-amount setting unit.

   The target loading amount can be set to a predetermined initial loading amount in a state in which no electronic circuit components are held by the bulk feeder held by the placement-unit body, for example, and thereafter each time when an actual supplied amount of electronic circuit components supplied from the bulk feeder has reached a set actual supplied amount, an amount equal to the set actual supplied amount can be set to a supplementary loading amount. The set actual supplied amount of course needs to be equal to or smaller than the initial loading amount.
   In a case where the electronic-circuit-component placement machine includes both of the loading completion notifier and the automatic loading stopper, the loading completion notifier only notifies the operator of the completion of loading of the components. However, in a case where the electronic-circuit-component placement machine includes only the loading completion notifier without including the automatic loading stopper, the loading completion notifier functions as a loading stop indicator which indicates that the operator should stop loading the components in response to the notification.
(19) A circuit-component placement machine, comprising:
   a placement-machine body;
   a circuit substrate holder held by the placement-machine body and capable of holding a circuit substrate;
   a placement unit which places the electronic circuit component onto the circuit substrate held by the circuit substrate holder;
   a placement unit moving device which moves the placement unit in a direction parallel to a component-placement surface of the circuit substrate held by the circuit substrate holder,
   the electronic-circuit-component placement machine being configured to use the placement unit to place the electronic circuit component onto the component-placement surface of the circuit substrate held by the circuit substrate holder,
   the placement unit comprising:
      a placement-unit body; and
      a bulk feeder held by the placement-unit body and comprising: an accommodating portion accommodating a plurality of electronic circuit components in an unjoined state; a supply portion which supplies the plurality of electronic circuit components one by one; and a component transferring portion which transfers the plurality of electronic circuit components from the accommodating portion to the supply portion,
   the electronic-circuit-component placement machine further comprising:
      a target-loading-amount setting unit configured to set a target loading amount which is an amount of electronic circuit components to be loaded into the bulk feeder held by the placement-unit body; and
      a component loading device held by the placement-machine body without being held by the placement-unit body, the component loading device being configured to load the electronic circuit components of the target loading amount set by the target-loading-amount setting unit, into the accommodating portion of the bulk feeder held by the placement-unit body.

   The accommodating portion of the bulk feeder accommodates a plurality of electronic circuit components in an unjoined state. Thus, as described in JP-A-2000-22388 and JP-A-2008-226939, for example, more electronic circuit components can be supplied when comparead with a case where a plurality of electronic circuit components are arranged in a row in an accommodating passage and supplied. Accordingly, the electronic circuit components need to be less frequently loaded into the bulk feeder by the component loading device, leading to efficient placement of the electronic circuit components. In addition, the setting of the target loading amount allows a required number of electronic circuit components to be loaded into the bulk feeder depending upon circumstances, making the electronic-circuit-component placement machine more practical.
(20) The circuit-component placement machine according to the above-described form (19), further comprising:
   a suppliable amount detecting device which detects a suppliable amount which is an amount of electronic circuit components suppliable from the bulk feeder; and
   a loading start controller configured to control the component loading device to start loading the electronic circuit components into the accommodating portion of the bulk feeder held by the placement-unit body, when the suppliable amount detected by the suppliable amount detecting device has decreased to a predetermined set minimum amount.

   The explanation of the suppliable amount detecting device described in the form (21) applies to the suppliable amount detecting device.
(21) An electronic-circuit-component placement machine, comprising:
   a placement-machine body;
   a circuit substrate holder held by the placement-machine body and capable of holding a circuit substrate;
   a placement unit which places the electronic circuit component onto the circuit substrate held by the circuit substrate holder; and
   a placement unit moving device which moves the placement unit in a direction parallel to a component-placement surface of the circuit substrate held by the circuit substrate holder,
   the electronic-circuit-component placement machine being configured to use the placement unit to place the electronic circuit component onto the component-placement surface of the circuit substrate held by the circuit substrate holder,
   the placement unit comprising:
      a placement-unit body; and
      a bulk feeder held by the placement-unit body and comprising: an accommodating portion accommodating a plurality of electronic circuit components in an unjoined state; a supply portion which supplies the plurality of electronic circuit components one by one; and a component transferring portion which transfers the plurality of electronic circuit components from the accommodating portion to the supply portion,
   the electronic-circuit-component placement machine further comprising:
      a component loading device held by the placement-machine body without being held by the placement-unit body and capable of loading the electronic circuit component into the accommodating portion of the bulk feeder held by the placement-unit body;
      a target supply amount setting unit which sets a target supply amount which is an amount of electronic circuit components to be supplied from the bulk feeder held by the placement-unit body;
      a suppliable amount detecting device which detects a suppliable amount which is an amount of electronic circuit components suppliable from the bulk feeder;
      at least one of (a) a loading completion notifier which, when the suppliable amount detected by the suppliable amount detecting device has reached the target supply amount, notifies the fact and (b) an automatic loading stopper which automatically stops the loading of the component loading device when the suppliable amount detected by the suppliable amount detecting device has reached the target supply amount.

   The suppliable amount detecting device may be designed to detect the suppliable number as the suppliable amount by subtracting one from an initial holding number which is the number of electronic circuit components initially held by the bulk feeder held by the placement-unit body, each time when one electronic circuit component is supplied, for example.
   Also, the suppliable amount detecting device may be designed to detect the suppliable amount by detecting a height position of an upper surface of a layer of the electronic circuit components accommodated in the accommodating portion in an unjoined state and may be designed to detect the suppliable amount by detecting a weight of the electronic circuit components accommodated in the accommodating portion in an unjoined state. In the former case, where the transverse cross-sectional area of the accommodating portion in the horizontal direction gradually increases toward its upper portion, the electronic circuit components smoothly move out of the accommodating portion, but the suppliable amount is detected at lower accuracy based on the height position of the upper surface of the layer of the electronic circuit components. Thus, the height position of the upper surface of the layer of the electronic circuit components is preferably detected at a part of the accommodating portion which has a small transverse cross-sectional area in the horizontal direction. From this viewpoint, the loading of the electronic circuit components into the accommodating portion is preferably performed relatively frequently. For example, a portion of the target supply amount determined in the method described in the form (22) is set as the target supply amount in each setting. A plurality of the devices for detecting the height position of the upper surface of the layer of the electronic circuit components may be provided respectively at different positions in the height direction. For example, the height detecting devices are provided respectively at a position for detecting the target supply amount as the suppliable amount and at a position for detecting the set minimum amount described in the form (20) as the suppliable amount.
   As described in the above-described form (18), the function of the loading completion notifier changes depending upon whether the electronic-circuit-component placement machine includes the automatic loading stopper or not.
   It is noted that in a case where the loading of the electronic circuit components from the component loading device held by the placement-machine body into the accommodating portion of the bulk feeder held by the placement-unit body is started in a state in which no electronic circuit components are held in the entire bulk feeder in the electronic-circuit-component placement machine according to the form (18), the target supply amount in the present form (21) is generally equal to the target loading amount in the form (18). In this case, accordingly, the target supply amount is replaced with the target loading amount, and the following forms (22) and (23) can be made dependent on the form (18). This applies to the target loading amount described in the form (19).
   The electronic-circuit-component placement machine in the present form can obtain the effects achieved by supplying the electronic circuit components by means of the bulk feeder, and in addition the setting of the target supply amount allows the bulk feeder to supply the electronic circuit components of an amount corresponding to a purpose.
(22) The electronic-circuit-component placement machine according to the above form (21), wherein the target supply amount setting unit comprises a first target supply amount determining unit configured to determine the target supply amount based on a planned production number which is the number of circuit substrates on which the electronic circuit components are planned to be placed by the electronic-circuit-component placement machine and the number of electronic circuit components to be supplied from the bulk feeder for production of one circuit substrate.
   In the target supply amount setting unit described in the present form, all the electronic circuit components required for the placement onto the planned number of circuit substrates are loaded into and accommodated in the accommodating portion at one time. Accordingly, loading of the electronic circuit components is not required during a series of placements of the electronic circuit components onto the circuit substrates, and the placement is not interrupted, thereby reducing an amount of lowering in efficiency of the placement.
(23) The electronic-circuit-component placement machine according to the above form (21) or (22), wherein the target supply amount setting unit comprises a second target supply amount determining unit configured to determine the target supply amount based on a limit of performance deterioration due to blackening of the electronic circuit components held by the bulk feeder.
   The target supply amount set by the target supply amount setting unit described in the present form may be larger or smaller than the total number of the electronic circuit components to be placed on all the circuit substrates planned to be produced. In the case where the target supply amount is smaller than the total number of the electronic circuit components, the electronic circuit components need to be restocked during placement, but the electronic circuit components whose performance has been lowered due to the blackening are not placed. Accordingly, in a form in which the present form depends on the form (22), the target supply amount is set depending upon whether a higher priority is given to the performance deterioration due to the blackening or the reduced efficiency due to the interruption of the placement.
(24) The electronic-circuit-component placement machine according to the above form (22) or (23), wherein when the target supply amount determined by the target supply amount setting unit is equal to or greater than a maximum suppliable amount of electronic circuit components to be supplied from the accommodating portion and when the suppliable amount detected by the suppliable amount detecting device has reached the maximum suppliable amount, at least one of the loading completion notifier and the automatic loading stopper is operated.
   When the target supply amount is less than the maximum suppliable amount, the maximum suppliable amount of electronic circuit components are not loaded into the accommodating portion, and a predetermined amount of electronic circuit components are loaded into the accommodating portion. In contrast, when the target supply amount is equal to or greater than the maximum suppliable amount, the electronic circuit components are loaded into the accommodating portion to its upper limit.
(25) The electronic-circuit-component placement machine according to any one of the above forms (14) through (24), further comprising a forcible discharger which forcibly discharges the plurality of electronic circuit components accommodated at least in the accommodating portion of the bulk feeder, from the accommodating portion.
   Here, the forcible discharge means discharging all the plurality of electronic circuit components at the same time to place them onto the circuit substrate, not one by one. The forcible discharger is preferably designed to discharge the electronic circuit components not only in the accommodating portion but also in the component transferring portion.
   The forcible discharger may be designed such that the accommodating portion is placeable on and removable from the component transferring portion, for example, because, in a case where the accommodating portion is removable, the operator can discharge the electronic circuit components in a state in which the accommodating portion is removed. In this case, an outflow preventing member or device for preventing an outflow of the electronic circuit components from the removed accommodating portion is preferably provided. For example, an opening/closing member for opening and closing a component-outflow-side opening of the accommodating portion may be provided, or a magnet for attracting the electronic circuit components to each other in the component-outflow-side opening may be provided near an outer circumference of a portion of the accommodating portion which defines the component-outflow-side opening. In a case where an electromagnet is used as the magnet, a state of the magnet can be easily switched between a magnetized state and a demagnetized state, resulting in easy establishment of an outflow allowing state and an outflow inhibiting state. The opening/closing member may be designed to be moved manurally by the operator selectively to one of its open position and its closed position and may be designed to be automatically moved selectively to one of the open position and the closed position by an opening/closing-member moving device including a drive source. It is noted that the entire bulk feeder including the accommodating portion, the supply portion, and the component transferring portion may be designed to be removable from the placement-unit body.
   The forcible discharge is carried out upon completion of the placement of the electronic circuit components onto the circuit substrate, at change of the type of the circuit substrate, and at maintenance, for example. In the case where the forcible discharge is carried our at the change of the type of the circuit substrate, at least the accommodating portion can be used for supply of a plurality of types of the electronic circuit components, leading to reduction in cost of the device.
(26) The electronic-circuit-component placement machine according to the above form (25), further comprising a component returning device which uses power to return the plurality of electronic circuit components discharged by the forcible discharger, to the component loading device.
(27) The electronic-circuit-component placement machine according to any one of the above forms (1) through (26), wherein the accommodating portion of the component supplier held by the placement-unit body is removable from the supply portion and the component transferring portion of the component supplier.
   In the electronic-circuit-component placement machine in the present form, when the accommodating portion is removed from the supply portion and the component transferring portion and when the electronic circuit components are accommodated in the accommodating portion, an outflow preventing member or device for preventing an outflow of the electronic circuit components from the removed accommodating portion is preferably provided as explained in the explanation for the above form (25).
   When the accommodating portion is removed from the supply portion and the component transferring portion, various operations can be performed outside the electronic-circuit-component placement machine. Examples of such operations include: a component forcible-discharge operation in which the electronic circuit components are taken out from the accommodating portion to empty out the accommodating portion; an operation for storing other electronic circuit components into the empty accommodating portion; and a maintenance operation. Also, replacement of the accommodating portion allows a change in the type of electronic circuit components to be supplied by the component supplier.
   In a form in which the present form directly depends on any one of the above forms (19) through (24) and a form in which the present form depends on any one of the above forms (19) through (24) by depending on the above form (25) or (26), the component supplier includes the bulk feeder.
(28) The electronic-circuit-component placement machine according to any one of the above forms (1) through (27), wherein the component supplier held by the placement-unit body is entirely removable from the placement-unit body.
   For example, an operation described in the form (27) can be performed for each component supplier.
   In a form in which the present form directly depends on any one of the above forms (19) through (24) and a form in which the present form depends on any one of the above forms (19) through (24) by depending on any one of the above forms (25) through (27), the component supplier includes the bulk feeder.
(29) The electronic-circuit-component placement machine according to any one of the above forms (1) through (28), wherein the component supplier comprises a tape feeder in which the accommodating portion accommodates a component holding tape holding the electronic circuit components arranged at a predetermined pitch, and the component transferring portion comprises: a guide passage defined to guide the component holding tape from the accommodating portion to the supply portion; and a transfer device configured to transfer the component holding tape along the guide passage.

In the electronic-circuit-component placement machine according to any one of the above forms (19) through (24) and the electronic-circuit-component placement machine according to any one of the above forms (25) through (28) depending on any of one of the forms (19) through (24), the placement-unit body may hold a component supplier other than the bulk feeder, and one example of the component supplier is the tape feeder.

### BRIEF DESCRIPTION OF THE DRAWINGS

Fig. 1 is a perspective view illustrating an electronic-circuit-component placement line including a plurality of placement modules each as an electronic-circuit-component placement machine according to one embodiment of the claimable invention.
Fig. 2 is a perspective view illustrating board conveyor devices and other components of some of the placement modules.
Fig. 3 is a side view illustrating a tape feeder of a component supply device of the placement module (partly in cross section).
Fig. 4 is a perspective view illustrating a placement head and a head moving device of a placement device of the placement module.
Fig. 5 is an exploded perspective view illustrating the head moving device.
Figs. 6(a) and 6(b) are perspective views each illustrating the placement head, wherein Fig. 6(a) is a view illustrating a placement head including one nozzle holder, and Fig. 6(b) is a view illustrating a placement head including twelve nozzle holders.
Fig. 7 is a perspective view illustrating the placement head including the twelve nozzle holders, with a cover being removed.
Fig. 8 is a perspective view illustrating the nozzle holders, pickup nozzles, an elevating and lowering device, a valve switching device, and other components of the placement head including the twelve nozzle holders.
Fig. 9 is a perspective view illustrating the nozzle holders, pickup nozzles, another elevating and lowering device, another valve switching device, and other components of the placement head including the twelve nozzle holders.
Fig. 10 is a perspective view illustrating the placement head including the twelve nozzle holders in a case where the placement head is viewed from a side on which bulk feeders are provided.
Fig. 11 is a view schematically illustrating stop positions of the pickup nozzles rotated by a rotary body in the placement head including the twelve nozzle holders.
Fig. 12 is a side view illustrating the bulk feeder (partly in cross section).
Fig. 13 is a front elevational view illustrating a casing for the bulk feeder (partly in cross section).
Fig. 14 is a plan view illustrating a top portion of the casing.
Figs. 15(a) and 15(b) are side elevational views in cross section illustrating the top portion of the casing, wherein Fig. 15(a) is a view illustrating a guide groove formed in one side face of a groove, and Fig. 15(b) is a view illustrating a guide groove formed in the other side face.
Fig. 16 is a rear view illustrating a discharge promoting pipe driving device of the bulk feeder.
Figs. 17(a) and 17(b) are plan views each illustrating a shutter provided for a lower opening of the casing (partly in cross section), wherein Fig. 17(a) is a view illustrating the shutter located at an open position, and Fig. 17(b) is a view illustrating the shutter located at a closed position.
Fig. 18 is a side view illustrating the shutter.
Fig. 19 is a plan view illustrating a component transferring device of the bulk feeder.
Fig. 20 is a side view illustrating a stopper provided at an end of a guide passage for guiding electronic circuit components transferred by the component transferring device.
Fig. 21 is a perspective view illustrating a component receiver provided at the end of the guide passage.
Fig. 22 is a perspective view illustrating a portion of a feeder body of the bulk feeder on which a component receiver is to be mounted.
Figs. 23(a) and 23(b) are side elevational views in cross section each illustrating the component receiver mounted on the feeder body, wherein Fig. 23(a) is a view illustrating the component receiver located at a stop position, and Fig. 23(b) is a view illustrating the component receiver located at an exposing position.
Fig. 24 is a perspective view illustrating, with the placement head, a component loading device for loading electronic circuit components into the casing for the bulk feeder.
Fig. 25 is a side view illustrating the casing for the component loading device (partly in cross section).
Fig. 26 is a side elevational view in cross section illustrating a front end portion of a component conveyor of the component loading device.
Fig. 27 is a plan view illustrating the front end portion of the component conveyor of the component loading device (partly in cross section).
Fig. 28 is a front elevational view illustrating a guide roller of the component conveyor (partly in cross section).
Fig. 29 is a front elevational view illustrating another guide roller of the component conveyor (partly in cross section).
Fig. 30 is a side elevational view in cross section illustrating a component accommodation recess formed in a component conveyor belt of the component conveyor.
Fig. 31 is a rear view illustrating a front end portion of the component conveyor.
Fig. 32 is a block diagram illustrating configurations of devices including a module control device for controlling the placement modules.
Fig. 33 is a flow chart illustrating an initial loading number setting routine stored in a RAM of a computer as a main device of the module control device.
Fig. 34 is a flow chart illustrating a component loading routine stored in a RAM of a computer as a main device of a component-loading-device control device for controlling the component loading device.
Fig. 35 is a flow chart illustrating a supplementary loading number setting routine stored in the RAM of the computer as the main device of the module control device.
Figs. 36(a) and 36(b) are side views each explaining a loading operation of the component loading device for loading the components into the casing for the bulk feeder (partly in cross section), wherein Fig. 36(a) is a view illustrating a shutter, for opening and closing an opening formed in the top portion of the casing, located at a closed position, and Fig. 36(b) is a view illustrating the shutter located at an open position.
Fig. 37 is a side view explaining a separation of the casing from the feeder body (partly in cross section) and illustrating a situation in which the discharge promoting pipe has been elevated to a discharge hole.
Fig. 38 is a side view explaining a separation of the casing from the feeder body (partly in cross section) and illustrating a situation in which the lower opening of the casing is closed by the shutter.
Fig. 39 is a side view illustrating a situation in which the casing is separated from the feeder body (partly in cross section).
Fig. 40 is a side view illustrating a front end portion of a component conveyor of a component loading device in another embodiment (partly in cross section).
Fig. 41 is a side elevational view illustrating the front end portion of the component conveyor of the component loading device in Fig. 40, with a shutter being illustrated in cross section.
Fig. 42 is a plan view illustrating the front end portion of the component conveyor of the component loading device illustrated in Fig. 40.
Fig. 43 is a rear view in cross section illustrating the front end portion of the component conveyor of the component loading device illustrated in Fig. 40, with the shutter being removed.
Fig. 44 is a plan view illustrating the shutter for the component loading device illustrated in Fig. 40.
Figs. 45(a)-45(c) are side elevational views in cross section each for explaining a loading operation of the component loading device illustrated in Fig. 40 for loading components into a casing for a bulk feeder, wherein Fig. 45(a) is a view illustrating a state in which the shutter for the component loading device is fitted in a groove of a top portion of the casing, Fig. 45(b) is a view illustrating a state in which an opening of the top portion of the casing is open, and Fig. 45(c) is a view illustrating a state in which a component output opening of the component conveyor is open.
Fig. 46 is a side view illustrating a bulk feeder in still another embodiment (partly in cross section).
Fig. 47 is a plan view illustrating electromagnets provided for the bulk feeder illustrated in Fig. 46.
Fig. 48 is a view schematically illustrating an example, in a placement head in still another embodiment, in which bulk feeders are respectively provided at four of twelve stop positions where pickup nozzles rotated by a rotary body are to be stopped.
Fig. 49 is a front view in cross section illustrating a portion of a placement head in still another embodiment.
Fig. 50 is a left side view schematically illustrating the portion of the placement head illustrated in Fig. 49.
Fig. 51 is a view schematically illustrating the portion of the placement head illustrated in Fig. 49 in a case where the placement head is viewed in arrow P in Fig. 49.
Figs. 52(a)-(c) are views illustrating a relative positional relationship between bulk feeders and stop positions of pickup nozzles in the placement head illustrated in Fig. 49, wherein Fig. 52(a) is a view corresponding to Fig. 50 (i.e., a left side view illustrating the placement head illustrated in Fig. 49), Fig. 52(b) is a left side view of Fig. 52(a) (i.e., a rear view illustrating the placement head illustrated in Fig. 49), and Fig. 52(c) is a plan view of Fig. 52(a) (i.e., a plan view illustrating the placement head illustrated in Fig. 49).

### EMBODIMENTS OF THE INVENTION

Hereinafter, there will be described embodiments of the claimable invention by reference to the above-described drawings. It is to be understood that the claimable invention is defined by the appended claims 1-10.

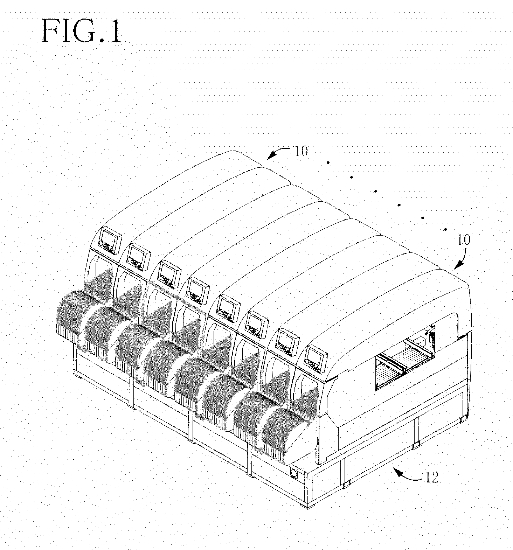

Fig. 1 illustrates an external appearance of an electronic-circuit-component placement line. This placement line is constituted by a plurality of placement modules 10 and a base 12 constituted by a single member, and the placement modules 10 are fixed to an upper face of the base 12 so as to be arranged adjacent to each other in a row. Each of the placement modules 10 is an electronic-circuit-component placement machine according to one embodiment of the claimable invention. The placement modules 10 place electronic circuit components onto circuit boards in parallel, and a plurality of the placement modules 10 are used for the component placement on each circuit board.

The placement modules 10 are described in detail in JP-A-2004-104075, for example, and a brief explanation will be provided for a configuration other than that relating to the present claimable invention.

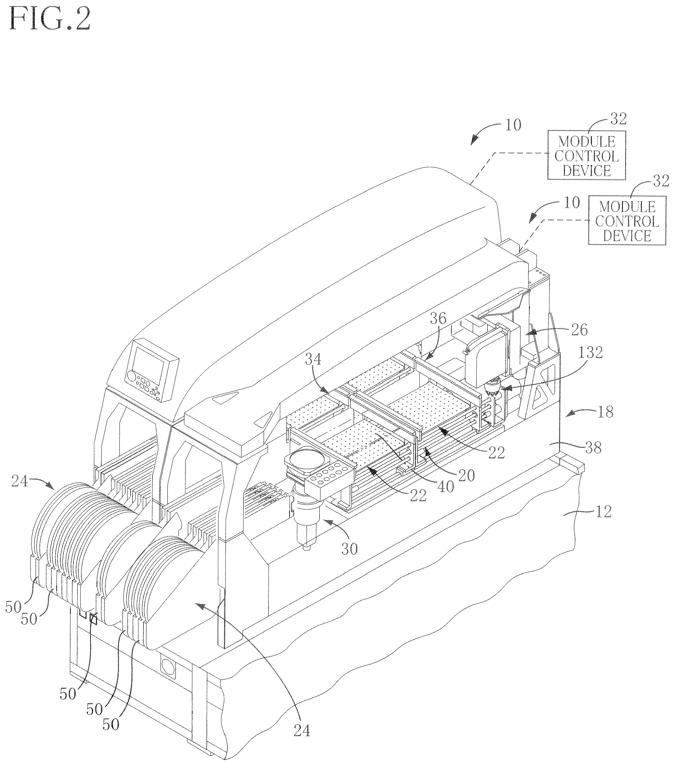

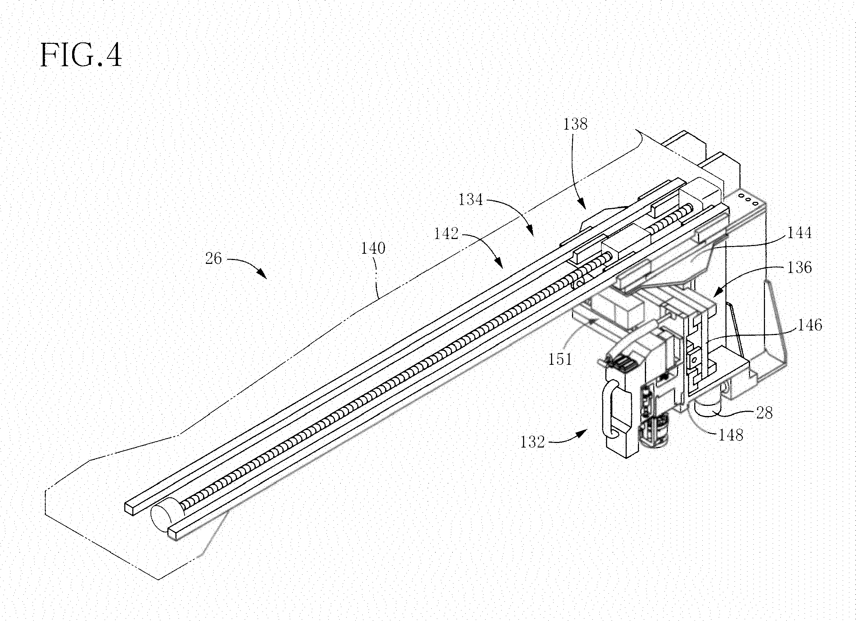

As illustrated in Fig. 2, each of the placement modules 10 includes a module body 18 as a placement-machine body, a board conveyor device 20 as a substrate conveyor device, a board holding device 22, a component supply device 24, a placement device 26, a fiducial-mark taking device 28 (see Fig. 4), a component-image taking device 30, and a module control device 32.

In the present embodiment, as illustrated in Fig. 2, each board conveyor device 20 includes two board conveyors 34, 36 and is provided at a central portion of a base 38 constituting the module body 18 in a front and rear direction of a corresponding one of the placement modules 10. The board conveyor device 20 horizontally conveys a circuit board 40 as one kind of a circuit substrate in a direction parallel to a direction in which the placement modules 10 are arranged. In the present embodiment, the circuit board is a generic name for a printed wiring board and a printed circuit board. The board holding devices 22 are provided on the module body 18 respectively for the two board conveyors 34, 36. Though not illustrated, each of the board holding devices 22 includes: a support member for supporting a lower face of the circuit board 40; and a clamp member for clamping opposite edge portions of the circuit board 40 in a direction parallel to a conveying direction in which the circuit board 40 is conveyed. The board holding device 22 holds the circuit board 40 such that its component-placement surface on which the electronic circuit components are to be placed extends horizontally, that is, the board holding device 22 constitutes a circuit substrate holder. In the present embodiment, the conveying direction in which the circuit board 40 is conveyed by the board conveyor device 20 is defined as an X-axis direction, while a direction perpendicular to the X-axis direction in a horizontal plane extending parallel to the component-placement surface of the circuit board 40 held by the board holding device 22 is defined as a Y-axis direction.

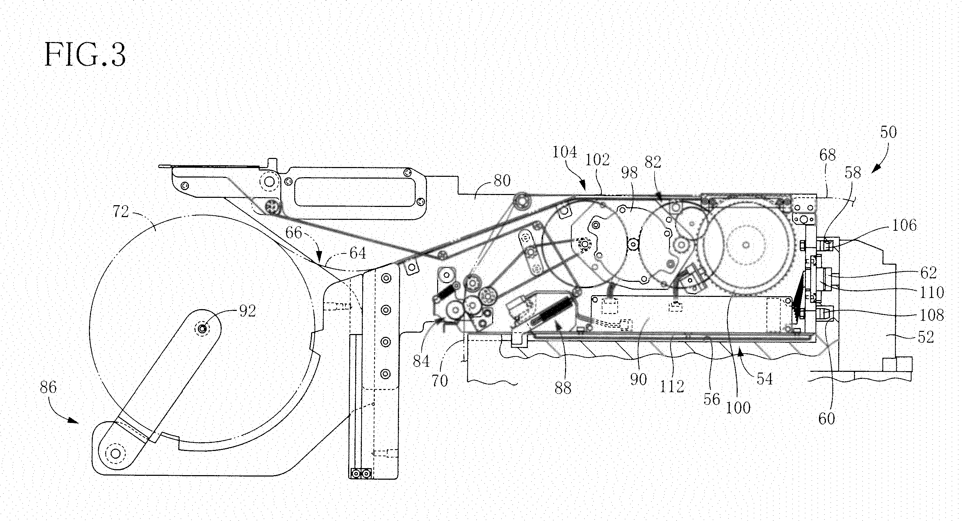

As illustrated in Fig. 2, each component supply device 24 is provided on the base 38 at a position located on one of opposite sides of the board conveyor device 20 in the Y-axis direction, specifically, each component supply device 24 is provided at a front portion of the corresponding placement module 10. As illustrated in Fig. 3, the component supply device 24 includes: a plurality of tape feeders 50 each as one kind of a component feeder as a component supplier; and a feeder holding table 52, as a supplier holder, for removably holding the tape feeders 50. This feeder holding table 52 includes a plurality of feeder holders 54 and removably mounted on the base 38. The feeder holding table 52 is secured to the base 38 when mounted. In the present embodiment, each of the feeder holders 54 includes: a groove 56 extending in a front and rear direction (a right and left direction in Fig. 3); a pair of locating holes 58, 60; and a connector 62. In this feeder holding table 52, the feeder holders 54 are evenly spaced apart from each other at appropriate intervals in a direction parallel to the X-axis direction (in a direction perpendicular to a sheet surface in Fig. 3). The placement module 10 may be configured such that the feeder holders 54 are provided on the base 38, with a portion of the base 38 constituting the feeder holding table.

In each of the tape feeders 50, the electronic circuit components are held by a component holding tape 64 and supplied as taped components 66. In the tape feeder 50, the component holding tape 64 includes a carrier tape 68 and a cover tape 70 and is wound around a reel 72 as a taped component holder. The present tape feeder 50 has the same construction as that of a feeder described in JP-A-2004-47951 and will be briefly explained.

The tape feeders 50 has a main body, namely, a feeder body 80 which is provided with a transfer device 82, a cover-tape peeling device 84, a component accommodating device 86, an engagement device 88, and a tape feeder control device 90. The component accommodating device 86 is provided at one of opposite end portions of the feeder body 80 in its longitudinal direction, specifically, the component accommodating device 86 is provided at a rear end portion of the feeder body 80. The component accommodating device 86 includes a support shaft 92 which supports the reel 72 rotatably. When the transfer device 82 is driven by an electric motor 98, a sprocket 100 is rotated to transfer the taped components 66 drawn from the reel 72, by a predetermined distance at a time, in the present embodiment, by a distance equal to an interval at which the electronic circuit components are held by the component holding tape 64, and position the electronic circuit components one by one to a component taking position at which each component is taken out from the component holding tape 64. The component taking position is set at the other end portion of the feeder body 80 in its longitudinal direction, specifically, the component taking position is set at a front end portion of the feeder body 80 which constitutes a supply portion. The electric motor 98 is constituted by a servomotor with an encoder in the present embodiment. The servomotor is an electric rotary motor which can accurately control a rotation angle, and a step motor may be used instead of the servomotor. This applies to other electric motors described below. The taped components 66 being transferred are guided by a guide portion 104 which is provided on the feeder body 80 so as to extend parallel to the front and rear direction of the feeder body 80. This guide portion 104 has a guide surface 102 facing upward which can be considered to constitute a guide passage defined only by a surface for supporting lower faces of the taped components 66.

The cover-tape peeling device 84 is driven by the electric motor 98 like the transfer device 82 in the present embodiment. When the taped components 66 are transferred, the cover tape 70 is peeled off from the carrier tape 68, and each of the electronic circuit components is positioned to the component taking position in a state in which the electronic circuit components are not covered with the cover tape 70. Also, a front face of the feeder body 80 is provided with a pair of positioning projections 106, 108 and a connector 110.

A bottom face of the feeder body 80 is provided with a rail 112 extending in the longitudinal direction of the feeder body 80. This rail 112 is fitted in the groove 56 formed in the feeder holder 54, and the positioning projections 106, 108 are respectively fitted in the locating holes 58, 60. The engagement device 88 is operated in this state by an operator, so that the tape feeder 50 is engaged with the feeder holding table 52. As a result, the tape feeder 50 is positioned by the feeder holder 54 in a state in which the front and rear direction and a longitudinal direction of the tape feeder 50 is parallel to the Y-axis direction, and a right and left direction and a widthwise direction of the tape feeder 50 is parallel to the X-axis direction. While being held by the feeder holder 54, the tape feeder 50 is prevented from being floating from the feeder holding table 52. The plurality of tape feeders 50 are mounted on the feeder holding table 52 and on the module body 18 in a state in which the supply portions of the respective tape feeders 50 are arranged in a row in the X-axis direction, in the present embodiment, in a state in which the supply portions are located on a straight line extending parallel to the X-axis direction. Each of the tape feeders 50 constitutes a second component supplier, the component accommodating device 86 constitutes an accommodating portion, and the transfer device 82 constitutes a component transferring portion.

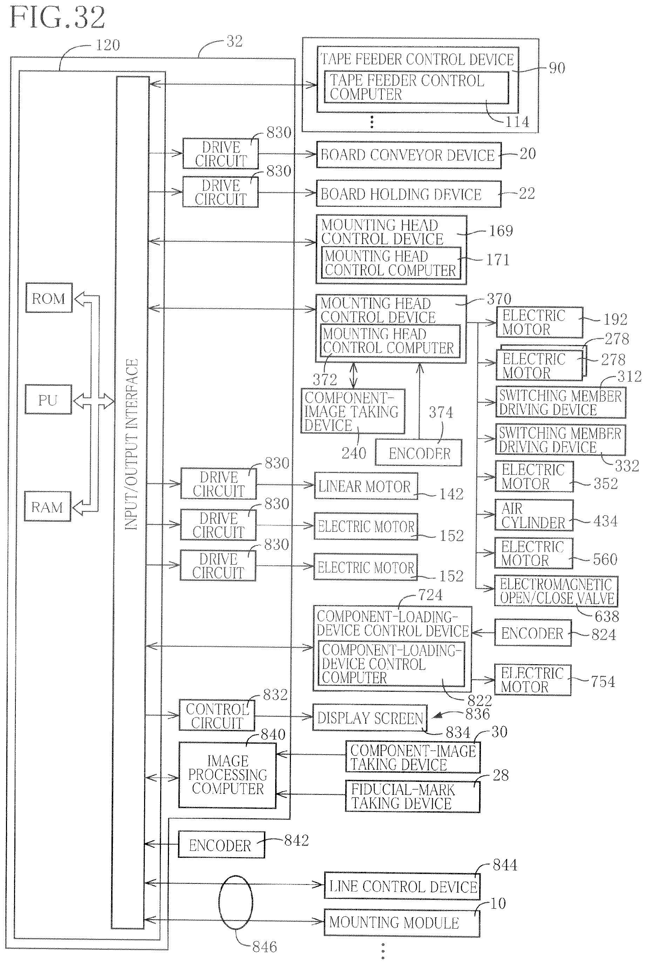

When the connectors 62, 110 are connected, the tape feeder 50 is powered, and a communication is established between a tape feeder control computer 114 as a main device of the tape feeder control device 90 and a module control computer 120 (see Fig. 32) as a main device of the module control device 32. The electric motor 98 is controlled by the tape feeder control device 90. It is noted that a component supply device which is held by the placement-machine body without being held by a placement-unit body as a main body of a placement head which will be described below like the component supply device 24 may include a component feeder and a tray.

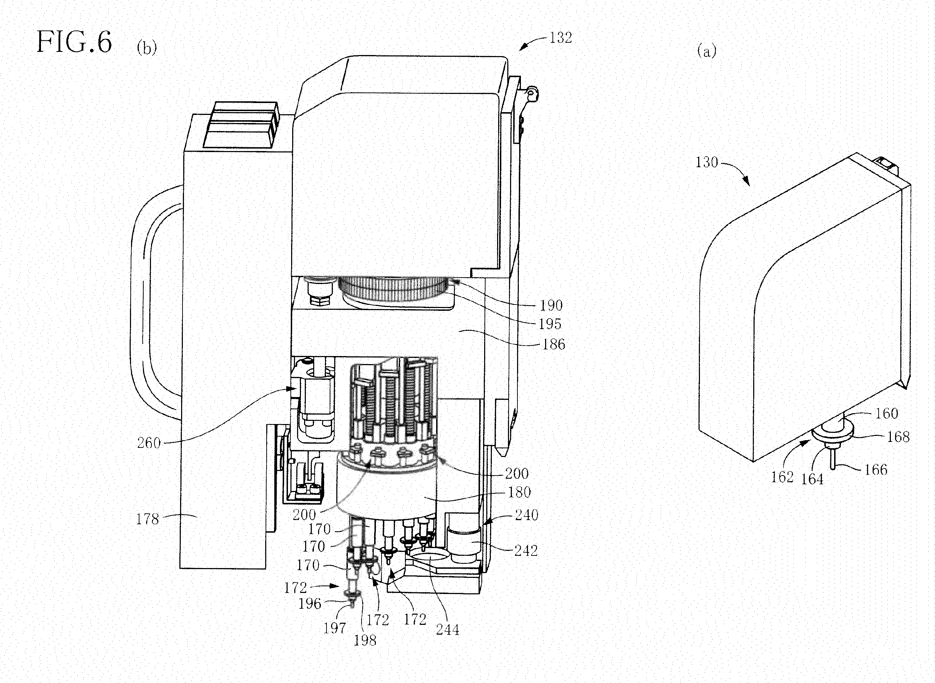

The placement device 26 includes: working heads in the form of placement heads 130, 132 illustrated in Fig. 6; and a head moving device 134 (see Fig. 4) for moving the placement head 130 or 132. The head moving device 134 moves the placement head 130 or 132 in two directions intersecting each other in a horizontal plane that is one plane extending parallel to the component-placement surface of the circuit board 40 held by the board holding device 22. In the present embodiment, the head moving device 134 moves the placement head 130 or 132 in two directions perpendicular to each other, one of which coincides with the X-axis direction, the other of which coincides with the Y-axis direction. As illustrated in Fig. 4, the head moving device 134 includes an X-axis-direction moving device 136 and a Y-axis-direction moving device 138, and thus constitutes what is called an X-Y robot. The Y-axis-direction moving device 138 includes a linear motor 142 provided on a crown 140 constituting the module body 18, and this linear motor 142 extends over the supply portion of the component supply device 24 and the two board holding devices 22. The Y-axis-direction moving device 138 moves a Y-axis slide 144 as a moving member as a movable member to any position in the Y-axis direction.

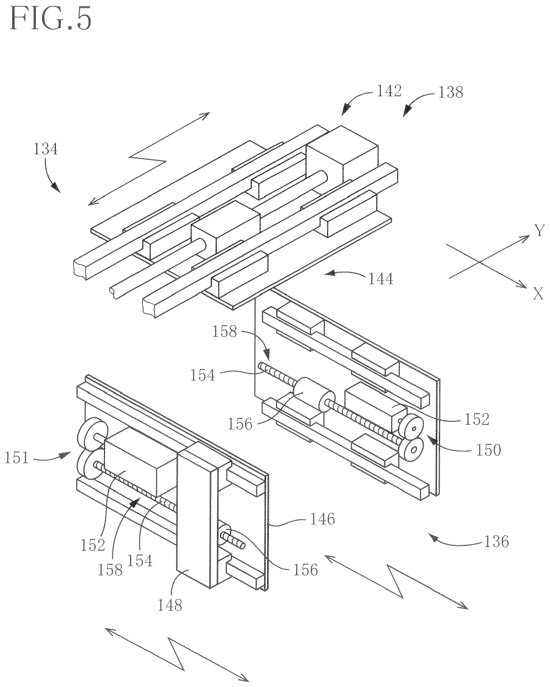

The X-axis-direction moving device 136 is provided on the Y-axis slide 144. As illustrated in Fig. 5, the X-axis-direction moving device 136 is moved with respect to the Y-axis slide 144 in the X-axis direction and includes: first and second X-axis slides 146, 148 which are moved relative to each other in the X-axis direction; and X-axis-slide moving devices 150, 151 for moving the respective slides 146, 148 in the X-axis direction. Each of the X-axis-slide moving devices 150, 151 includes: an electric motor 152 as a drive source; and a transfer screw mechanism 158 including a threaded shaft 154 and a nut 156, for example. Each of the X-axis-slide moving devices 150, 151 moves a corresponding one of the X-axis slides 146, 148 to any position in the X-axis direction. A ball screw mechanism is used as the transfer screw mechanism in the present embodiment. This applies to other transfer screw mechanisms described below. The head moving device may be designed such that the Y-axis-direction moving device is provided on the X-axis slide.

The placement head 130 or 132 is removably mounted on the second X-axis slide 148 and moved horizontally by the head moving device 134 to any position within a placement area which is a moving area extending over the component supply portion of the component supply device 24 and the two board holding devices 22. In the present embodiment, each of the placement heads 130, 132 constitutes a placement unit, and the head moving device 134 constitutes a first relative-movement device. Though not explained, the placement head 130 or 132 is removably mounted on the second X-axis slide 148 by a head placement device which is similar in construction to a head placement device described in JP-A-2004-221518. Each of the placement heads 130, 132 holds the electronic circuit component by means of a pickup nozzle as one kind of a component holder. There are provided various kinds of placement heads, including the placement heads 130, 132, which differ from each other in the number of nozzle holders each as a component-holder holding member for holding the pickup nozzle, and one of these placement heads is selectively mounted on the second X-axis slide 148 according to the type of the circuit board 40 on which the electronic circuit components are to be placed.

As illustrated in Fig. 6(a), the placement head 130 includes one nozzle holder 160 which holds one pickup nozzle 162. The pickup nozzle 162 includes a nozzle body 164, a pickup tube 166 provided on one end portion of the nozzle body 164 in its axial direction, and a background forming member 168 shaped like a plate. The pickup nozzle 162 picks up the electronic circuit component by a negative pressure supplied to the pickup tube 166 through a passage, not shown, formed in the nozzle body 164. The background forming member 168 forms a background of the electronic circuit component when the component-image taking device 30 takes an image of the electronic circuit component held by the pickup nozzle 162. The component holder includes not only the pickup nozzle but also a component grasping member, for example, which includes a plurality of grasping members and grasps and releases the electronic circuit component by symmetrical movement of the grasping members.

The nozzle holder 160 is elevated and lowered in a direction parallel to its axis by an elevating and lowering device, not shown, as a moving device provided on a head body of the placement head 130. The nozzle holder 160 is also rotated about its axis by a rotating device provided on the head body. Control of a negative/positive pressure supply control device, not shown, causes or stops selective supply of one of a negative pressure and a positive pressure to the pickup nozzle. The placement head 130 also includes a placement head control device 169 (see Fig. 32). The placement head control device 169 is constituted mainly by a placement head control computer 171 and is connected to the module control computer 120 when the placement head 130 is mounted on the second X-axis slide 148. As illustrated in Fig. 6(b), the placement head 132 includes a plurality of nozzle holders 170, for example, three or more nozzle holders 170. In the illustrated example, the placement head 132 includes the twelve nozzle holders 170 and can hold up to twelve pickup nozzles 172. The placement head 132 will be explained later in detail.

As illustrated in Fig. 4, the fiducial-mark taking device 28 is mounted on the second X-axis slide 148 and moved with the placement head by the head moving device 134 to take an image of a fiducial mark, not shown, provided on the circuit board 40. The head moving device 134 also serves as a fiducial-mark-taking-device moving device. As illustrated in Fig. 2, the component-image taking device 30 is fixed to the base 38 at a position between the board conveyor device 20 and the component supply device 24 and takes an image of a lower side of the electronic circuit component as an image taking object picked up by the pickup nozzle 162. In the present embodiment, each of the fiducial-mark taking device 28 and the component-image taking device 30 is constituted by a CCD camera but may be constituted by a CMOS camera.

There will be next explained the placement head 132.

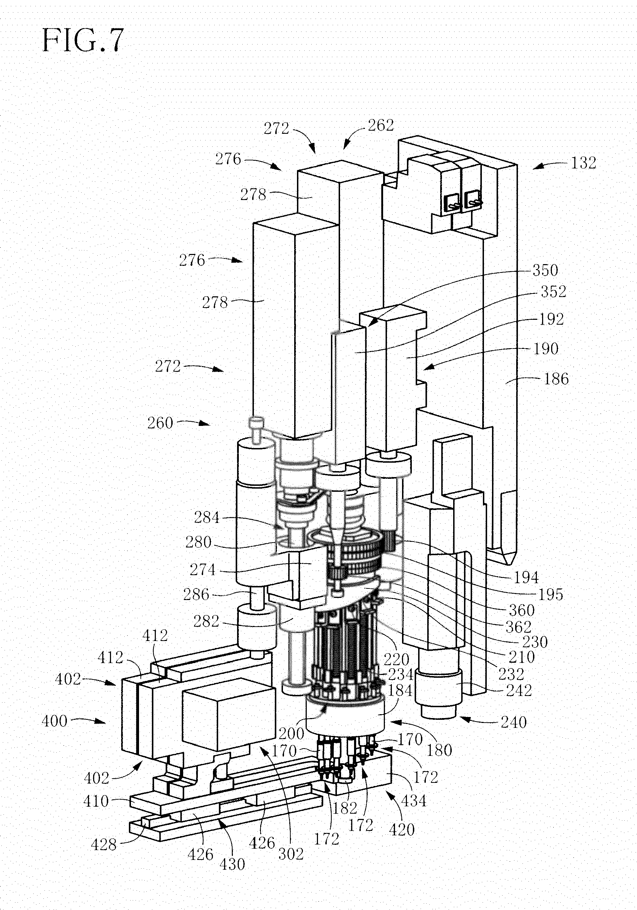

Fig. 6(b) illustrates the placement head 132 covered with a cover 178, and Fig. 7 illustrates the placement head 132 not covered with the cover 178. As illustrated in Fig. 7, the twelve nozzle holders 170 are held by a rotary body 180 as a movable member. The rotary body 180 includes a shaft portion 182 and a holder holding member 184 having the larger diameter than that of the shaft portion 182. The rotary body 180 is supported at the shaft portion 182 by a head body 186 as a main body of the placement head 132, such that the rotary body 180 is rotatable about its axis. The head body 186 constitutes the placement-unit body. The axis of the rotary body 180 extends in the vertical direction in the state in which the placement head 132 is mounted on the second X-axis slide 148.

The rotary body 180 is rotated by a rotary-body driving device 190 as a movable-member driving device. The rotary-body driving device 190 is driven by an electric motor 192 and designed such that a drive gear 194 fixed to an output shaft of the electric motor 192 is meshed with a driven gear 195 provided on an upper portion of the shaft portion 182. When the driven gear 195 is rotated by the electric motor 192, the rotary body 182 is rotated by a desired angle about a vertical axis in forward and backward directions.

The holder holding member 184 has a round shape in transverse cross section (i.e., a round shape in cross section perpendicular to its axis). The twelve nozzle holders 170 are fitted in a peripheral portion of the holder holding member 184 respectively at twelve positions spaced apart from each other along a circumference of a circle centered about the rotation axis of the rotary body 180, in the present embodiment, at the twelve positions equiangularly spaced apart from each other, such that each nozzle holder 170 is moveble relative to the rotary body 180 in the axial direction of the nozzle holder in a state in which the axial direction of the nozzle holder 170 is parallel to the rotation axis of the rotary body 180. Thus, when the rotary body 180 is rotated, the nozzle holder 170 is turned about the rotation axis of the rotary body 180, moving each of pickup nozzles 172 in a direction intersecting the axial direction, in the present embodiment, in a direction perpendicular to the axial direction. In this turning, the pickup nozzles 172 are moved along a circular path. In the present embodiment, the twelve nozzle holders 170, the rotary body 180, and the rotary-body driving device 190 constitute a second relative-movement device.

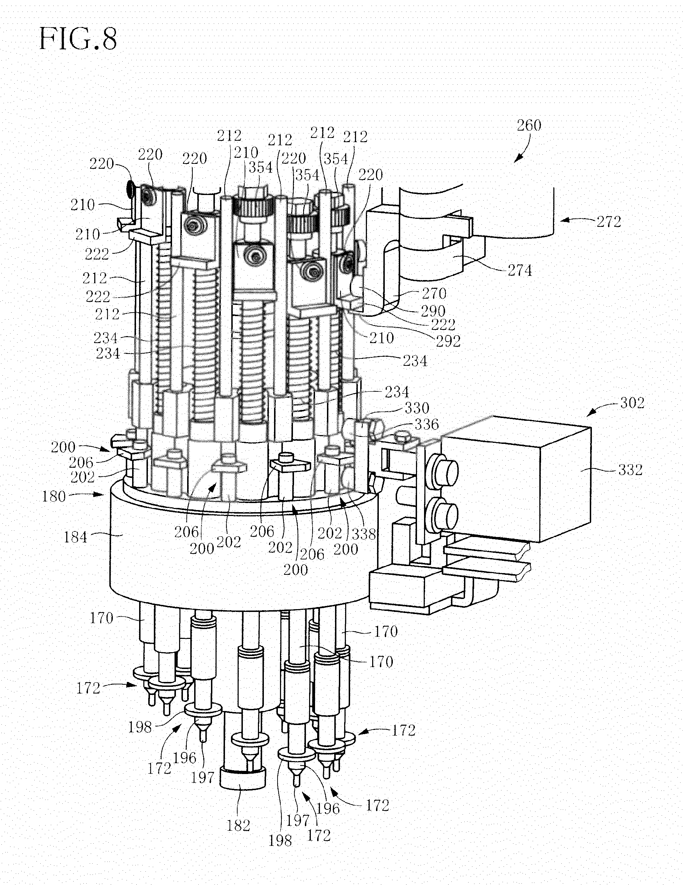

Each pickup nozzle 172 is held by a corresponding one of the nozzle holders 170 at its lower end portion projecting downward from the holder holding member 184. As illustrated in Fig. 6(b), the pickup nozzle 172 includes a nozzle body 196, a pickup tube 197, and a background forming member 198 shaped like a plate. The pickup nozzles 172 held by the respective nozzle holders 170 are arranged concentrically, and the nozzle holders 170 are held by the rotary body 180 so as to be advanceable and retractable in the axial direction of the pickup nozzle 172. Each pickup tube 197 is provided on a lower end portion or a forward end portion of the corresponding pickup nozzle 172 and constitutes a pickup portion. One of a negative pressure and a positive pressure is selectively supplied to the pickup tube 197 through a passage formed in the nozzle body 196, the nozzle holder 170, and the rotary body 180. Each of the twelve nozzle holders 170 is provided with a switching valve device 200 (see Fig. 8) which selectively switches the supply of the pressure between the negative pressure supply and the positive pressure supply.

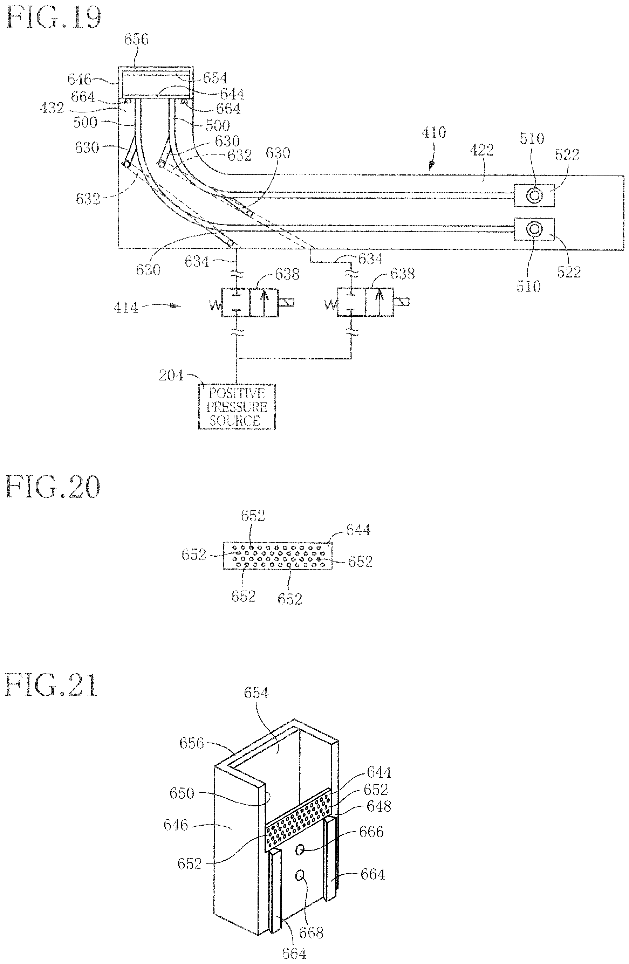

Each switching valve device 200 is constituted by a spool valve in the present embodiment and includes a valve spool 202 as a switching member as illustrated in Fig. 8. The valve spool 202 is fitted in the holder holding member 184 at a position adjacent to the nozzle holder 170 so as to be movable parallel to the axial direction of the nozzle holder 170. The valve spool 202 at its uppermost position establishes a communication between the pickup nozzle 172 and a positive pressure source 204 (see Fig. 19) and at its lowermost position establishes a communication between the pickup nozzle 172 and a negative pressure source, not shown. The uppermost position is a positive pressure supply position, and the lowermost position is a negative pressure supply position.

Though not shown, a plurality of sealings each as a seal member are provided between the valve spool 202 and the holder holding member 184, preventing leakage of the positive pressure and the negative pressure. The frictional force of these sealings keeps the valve spool 202 at one of the positive pressure supply position and the negative pressure supply position. An engagement protruding portion 206 is provided on an upper end portion of the valve spool 202 which projects upward from the holder holding member 184. The engagement protruding portion 206 projects outward from the valve spool 202 in a radial direction of the holder holding member 184. The engagement protruding portion 206 is shaped like a plate and constitutes an engaging portion.

As illustrated in Fig. 8, an engagement member 210 is fitted on an upper portion of the nozzle holder 170 which projects upward from the holder holding member 184, such that the engagement member 210 is rotatable relative to the nozzle holder 170 and not movable relative to the nozzle holder 170 in its axial direction. Twelve guide rods 212 are provided on the holder holding member 184 respectively for the twelve nozzle holders 170 so as to extend parallel to the nozzle holders 170. Each of the guide rods 212 has a round shape in transverse cross section and is disposed between corresponding adjacent two of the nozzle holders 170. Each two of the guide rods 212 are adjacent to a corresponding one of the nozzle holders 170, and outer circumferential portions of the two guide rods 212 respectively have portions each having a central angle less than 180 degrees. Each engagement member 210 is fitted on the respective portions of corresponding two of the guide rods 212 so as to be movable relative to the corresponding nozzle holder 170 in its axial direction. The guide rods 212 guide the engagement member 210 during its elevation and lowering and inhibit a rotation of the engagement member 210 relative to the rotary body 180. Each of the guide rods 212 constitutes a guide member and a relative-movement inhibiting member.

As illustrated in Fig. 8, a roller 220 as a cam follower is mounted on an upper end portion of an outer face of each engagement member 210 (i.e., a face of the engagement member 210 which faces outward in a radial direction of the rotary body 180). The roller 220 is rotatable about an axis perpendicular to the rotation axis of the rotary body 180. A lower end portion of the outer face of the engagement member 210 is provided with an engagement protruding portion 222 shaped like a plate projecting outward in a direction perpendicular to the rotation axis of the rotary body 180, and this engagement protruding portion 222 constitutes an engaging portion.

As illustrated in Fig. 7, the roller 220 is engaged with a cam surface 232 of a cam 230 fixed to the head body 186. The cam 230 having a cylindrical shape is provided coaxially with the rotary body 180 such that a lower surface of the cam 230 faces a path of turning of the roller 220 which is caused by the rotation of the rotary body 180, in the axial direction of the nozzle holder 170. The lower surface of the cam 230 is moved in the axial direction of the nozzle holder 170 with the movement of the rotary body 180 and constitutes the cam surface 232. A height position of the cam surface 232 is changed in a circumferential direction of the cam 230. In the present embodiment, the height position is made gradually higher with a movement of the cam 230 in a forward or reverse direction from a lowermost position of the cam 230. With the movement in each of the forward and reverse directions, the height position of the cam surface 232 is situated at its uppermost position when the cam 230 is spaced apart from the lowermost position by a distance corresponding to 120 degrees.

As illustrated in Fig. 8, the nozzle holders 170 are respectively urged upward by compression coil springs 234 provided between the engagement members 210 and the holder holding member 184, and thereby the rollers 220 are held in contact with the cam surface 232. Thus, when the rotary body 180 is rotated, the rollers 220 are rotated along the cam surface 232 and moved in a direction parallel to the rotation axis of the rotary body 180, whereby the twelve nozzle holders 170 are elevated or lowered while being turned about the rotation axis of the rotary body 180.

In this construction, when each roller 220 is moved from a position where the roller 220 is engaged with the cam surface 232 located at its lowermost position to a position where the roller 220 is engaged with the cam surface located at its uppermost position, a distance between the pickup tube 197 of each pickup nozzle 172 and the board holding device 22 increases with higher position of the roller 220. In the present embodiment, the rollers 220 and the cam 230 constitute a distance increasing unit. It is noted that each of the compression coil springs 234 is a spring as an elastic member as one kind of an urging member. This applies to other compression coil springs and extension coil springs described below.

The twelve pickup nozzles 172 are sequentially stopped at twelve stop positions by intermittent rotation of the rotary body 180 by an angle equal to that corresponding to the pitch at which the nozzle holders 170 are arranged. In the present embodiment, one of the twelve stop positions is a shortest distance stop position which is the nearest to the board holding device 22. The twelve stop positions further include one stop position spaced apart from the shortest distance stop position by 180 degrees and four stop positions, each two of which are adjacent to the one stop position on a corresponding one of forward and reverse sides of the one stop position. These five stop positions are longest distance stop positions each of which is the farthest from the board holding device 22.

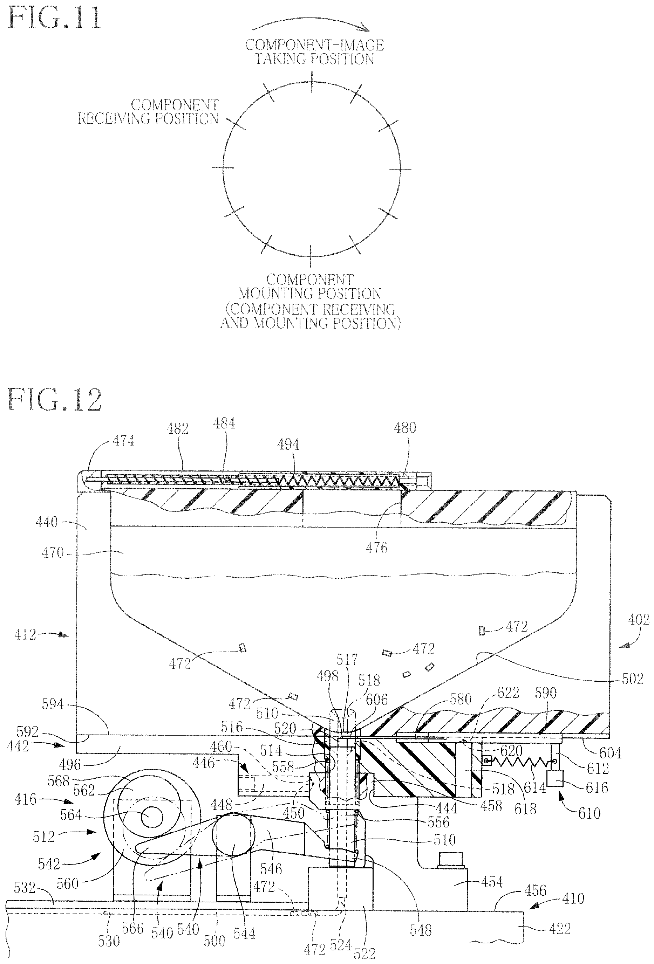

As schematically illustrated in Fig. 11, these positions are defined in the present embodiment in the following manner: the shortest distance stop position is a component placement position at which an electronic circuit component is placed onto the circuit board 40; one of the longest distance stop positions which is the nearest to the component placement position among the longest distance stop positions located downstream of the component placement position in the rotational direction of the rotary body 180 during placement (i.e., a direction indicated by the arrow in Fig. 11) is a component receiving position; and one of the longest distance stop positions which is spaced apart from the component placement position by 180 degrees among the longest distance stop positions located downstream of the component receiving position is a component-image taking position. Each of the component placement position, the component receiving position, and the component-image taking position is a working position at which a certain work is carried out. The rotation of the rotary body 180 moves the pickup nozzle 172 from each of the component placement position, the component receiving position, and the component-image taking position to another working position or a deviated position deviated from the component receiving position in a direction intersecting the axial direction of the pickup nozzle 172. The component receiving position is a position at which the pickup nozzle 172 receives an electronic circuit component from a bulk feeder which will be described later, and the received electronic circuit component is placed onto the circuit board 40 at the component placement position. In contrast, receiving the electronic circuit component from the tape feeder 50 by the pickup nozzle 172 and placing the received electronic circuit component onto the circuit board 40 are carried out at the component placement position, that is, the component placement position also serves as a component receiving and placement position. In the present embodiment, the placement head 132 is designed such that the component-image taking position is located at an area near a portion of the placement head 132 which is mounted on the second X-axis slide 148.

As illustrated in Fig. 7, a component-image taking device 240 is provided on a portion of the head body 186 which corresponds to the component-image taking position. As illustrated in Fig. 6(b), the component-image taking device 240 includes a CCD camera 242 as an image taking device and a light guiding device 244. Facing downward, the CCD camera 242 is provided on a portion of the head body 186 which corresponds to the component-image taking position and to a space defined when the distance between the pickup nozzle 172 and the board holding device 22 is made largest by the cam 230. The light guiding device 244 is provided in the space and includes a plurality of mirrors each constituting a light entering portion. One of the mirrors is positioned just under the pickup nozzle 172 stopped at the component-image taking position so as to face the pickup tube 197. Another of the mirrors is provided under the CCD camera 242 to guide an image forming light (i.e., a light reflected from the electronic circuit component) into the CCD camera 242. As a result, an image of the electronic circuit component picked up by the pickup tube 197 of the pickup nozzle 172 is taken in the axial direction of the pickup nozzle 172. A CMOS camera may be used instead of the CCD camera. The component-image taking device 30 is a component-image taking device fixed to the module body 18 without being mounted on the head body 186, and the component-image taking device 240 is a movable component-image taking device which is moved with respect to the board holding device 22 together with the pickup nozzle 172.

Elevating and lowering devices 260, 262 are provided on the head body 186 respectively at positions corresponding to the component placement position and the component receiving position to advance and retract the nozzle holders 170 with respect to the rotary body 180 in the axial direction.

As illustrated in Figs. 7 and 8, in the present embodiment, an elevating and lowering device 260 includes a drive member 270 and a drive member elevating and lowering device 272. The drive member elevating and lowering device 272 includes an elevating and lowering member 274 and an elevating-and-lowering-member driving device 276, and the elevating-and-lowering-member driving device 276 includes an electric motor 278 as a drive source and a transfer screw mechanism 284 including a threaded shaft 280 and a nut 282. The threaded shaft 280 is provided rotatably about a vertical axis by the head body 186 and immovably in an axial direction of the threaded shaft 280. The elevating and lowering member 274 is fixed to the nut 282 engaged with the threaded shaft 280. When the threaded shaft 280 is rotated by the electric motor 278, the elevating and lowering member 274 is elevated and lowered while being guided by a guide rod 286 as a guide member.

As illustrated in Fig. 8, the drive member 270 is fixed to the elevating and lowering member 274 so as to extend toward the rotary body 180, and a roller 290 is mounted on an end part of the extending portion of the drive member 270. The roller 290 is disposed on a path of turning of the engagement protruding portion 222 of the engagement member 210 fitted on the nozzle holder 170 so as to be rotatable about a horizontal axis extending in a direction perpendicular to a tangent to the turning path and perpendicular to a center line of the turning. The roller 290 constitutes a rotational contact portion as a contact portion of the drive member 270. The uppermost position of the drive member 270 is a position at which the roller 290 is slightly above the engagement protruding portion 222 fitted on the nozzle holder 170 located at the component placement position.

When located at the uppermost position, the drive member 270 allows turning of the nozzle holder 170. When the drive member 270 is moved downward, the roller 290 is engaged with the engagement protruding portion 222, and the nozzle holder 170 is lowered against an urging force of the spring 234 to bring the pickup nozzle 172 closer to the circuit board 40 held by the board holding device 22. When the drive member 270 is moved upward, the nozzle holder 170 is elevated by the urging force of the spring 234 to move the pickup nozzle 172 away from the circuit board 40. The roller 220 is engaged with the cam surface 232 before the drive member 270 reaches the uppermost position, allowing the nozzle holder 170 to be turned by the rotation of the rotary body 180. The drive member 270 thereafter reaches the uppermost position, and the roller 220 is moved off the engagement protruding portion 222.

As illustrated in Fig. 8, the drive member 270 is provided with an engagement projection 292 under the roller 290. The engagement projection 292 is shaped like a plate and provided projecting toward the nozzle holders 170, constituting an engaging portion. When the drive member 270 is located at the uppermost position, the engagement projection 292 is located slightly under the engagement protruding portion 222 fitted on the nozzle holder 170. Thus, the engagement projection 292 does not interfere with the turning of the nozzle holder 170, but if the nozzle holder 170 is not elevated by the urging force of the spring 234 during elevation of the drive member 270 due to some causes, the engagement projection 292 engages with a lower face of the engagement protruding portion 222 fitted on the nozzle holder 170 to forcibly elevate the nozzle holder 170. This elevating and lowering device 260 forcibly lowers the nozzle holder 170 but allows the elevation of the nozzle holder 170. The elevating and lowering device may be designed to forcibly elevate and lower the nozzle holder 170.

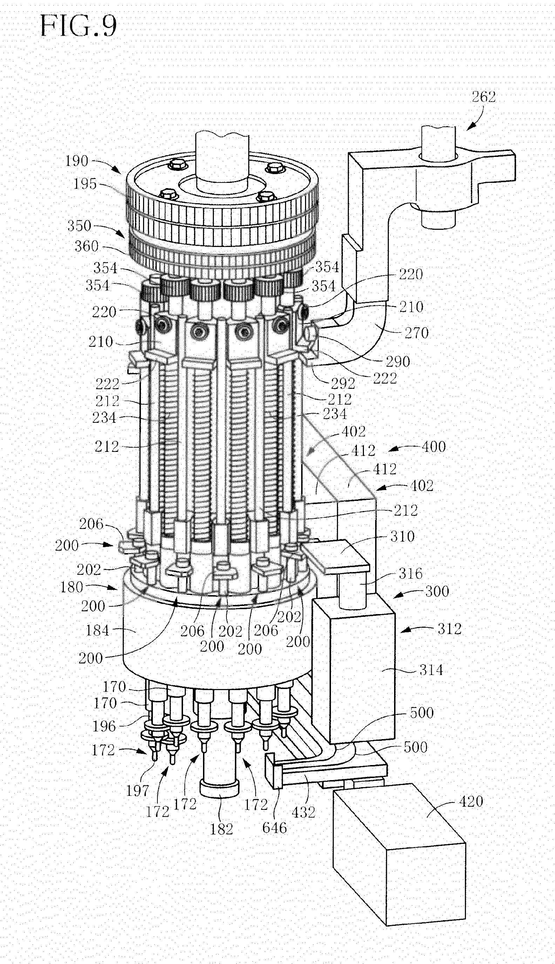

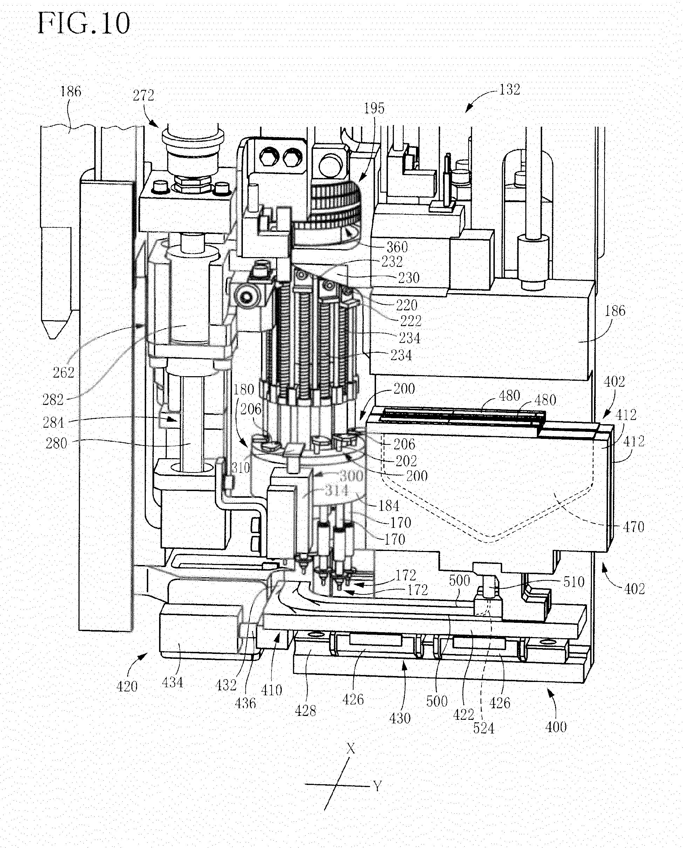

As illustrated in Figs. 9 and 10, an elevating and lowering device 262 provided on the head body 186 at a position corresponding to the component receiving position is similar in construction to the elevating and lowering device 260. Thus, the same reference numerals as used for the elevating and lowering device 260 are used to designate the corresponding elements of this elevating and lowering device 262, and an explanation of which is dispensed with. Figs. 9 and 10 illustrate only some elements of the elevating and lowering device 262 for the purposes of illustration. The elevating and lowering device 262 elevates and lowers the nozzle holder 170 to move the pickup nozzle 172 toward and away from a supply portion of the bulk feeder (described later) which is provided at the component receiving position.

Valve switching devices 300, 302 are provided on the head body 186 respectively at positions corresponding to the component receiving position and the component placement position.

As illustrated in Fig. 9, the valve switching device 300 provided on the portion of the head body 186 which corresponds to the component receiving position includes a switching member 310 and a switching member driving device 312. The switching member driving device 312 is constituted by an air cylinder. The air cylinder is a fluidic cylinder which is one kind of a fluidic actuator as a drive source. The switching member 310 is shaped like a plate and provided on a distal end portion of a piston rod 316 projecting upward from a cylinder housing 314, such that the switching member 310 projects from the piston rod 316 toward the valve spool 202. The switching member 310 is elevated and lowered by expansion and contraction of the piston rod 316.

In normal situation, the expansion of the piston rod 316 keeps the switching member 310 at a non-switching position as an uppermost position or a non-working position located on an upper side of the engagement protruding portion 206 provided on the valve spool 202 of the switching valve device 200 corresponding to the nozzle holder 170 located at the component receiving position. When the nozzle holder 170 reaches the component receiving position, the valve spool 202 provided on the switching valve device 200 is located at the positive pressure supply position. After the nozzle holder 170 has reached the component receiving position, the switching member 310 is lowered and engaged on an upper surface of the engagement protruding portion 206, moving the valve spool 202 downward from the positive pressure supply position to the negative pressure supply position. The position of the valve spool 202 at this time is a working position or a switching position. After the switching, the switching member 310 is elevated to the non-switching position, allowing the switching valve device 200 to be turned and waits for the next switching.

As illustrated in Fig. 8, the valve switching device 302 provided on the portion of the head body 186 which corresponds to the component placement position includes a switching member 330 and a switching member driving device 332. The switching member driving device 332 is constituted by an electric motor and causes pivotal movement of the switching member 330 in forward and reverse directions about the axis perpendicular to the rotation axis of the rotary body 180. Rollers 336, 338 are mounted respectively on opposite extended end portions of the switching member 330 in a direction perpendicular to an axis of the pivotal movement of the switching member 330. Each of the rollers 336, 338 is rotatable about an axis parallel to the axis of the pivotal movement of the switching member 330 and constitutes an engagement protruding portion as a rotatable engaging portion as one kind of an engaging portion.

In normal situation, the switching member 330 is located at a non-switching position as a non-working position, and in this state the rollers 336, 338 are positioned respectively on upper and lower sides of a path of turning of the engagement protruding portion 206 provided on the valve spool 202, allowing the turning of the valve spool 202. The valve spool 202 of the switching valve device 200 corresponding to the pickup nozzle 172 holding the electric circuit component to be placed on the circuit board 40 is positioned at the negative pressure supply position. For the pickup nozzle 172 having reached the component placement position, the switching member 330 is pivoted in such a direction that the lower roller 338 is to be brought into contact with a lower surface of the engagement protruding portion 206 provided on the valve spool 202, whereby the roller 338 moves the valve spool 202 upward from the negative pressure supply position to the positive pressure supply position. As a result, a positive pressure is supplied to the pickup nozzle 172 to release the electric circuit component. After the switching, the switching member 330 is moved back to the non-switching position to allow the turning of the valve spool 202 and waits for the next switching.

In a case where the component placement position is set as the component receiving and placement position, and the pickup nozzle 172 receives the electronic circuit component fed by the tape feeder 50, the switching member 330 is pivoted such a direction that the upper roller 336 is to be brought into contact with the upper surface of the engagement protruding portion 206 provided on the valve spool 202 of the switching valve device 200 provided for the pickup nozzle 172 having reached the component receiving and placement position, whereby the roller 336 moves the valve spool 202 from the positive pressure supply position to the negative pressure supply portion. As a result, a negative pressure is supplied to the pickup nozzle 172 which thereby picks up the electronic circuit board. Upon placement of the electronic circuit component, the switching member 330 is pivoted in such a direction that the valve spool 202 is to be moved upward as described above.

Each nozzle holder 170 is rotated about its axis by a nozzle holder rotating device 350. As illustrated in Fig. 7, the nozzle holder rotating device 350 is driven by an electric motor 352 to rotate all the twelve nozzle holders at the same time. Accordingly, as illustrated in Fig. 9, each of the twelve nozzle holders 170 is provided with a gear 354 at its upper end portion located above the portion of the nozzle holder 170 on which the engagement member 210 is fitted. The head body 186 keeps this gear 354 meshed with a gear (not shown), as a common drive member, which is held rotatably about the vertical axis.

Though not shown, the head body 186 is provided with a rotation shaft rotatable coaxially with the rotary body 180, and the common gear is fixed to the rotation shaft. As illustrated in Fig. 7, a driven gear 360 is mounted on this rotation shaft so as to be meshed with a drive gear 362 which is mounted on an output shaft of the electric motor 352. Thus, when the common gear is rotated by the gears 360, 362 driven by the electric motor 352, the gears 354 respectively mounted on the twelve nozzle holders 170 are rotated, thereby rotating the twelve nozzle holders 170 about their respective axes by the same amount of angle in the same direction at the same time. It is noted that each tooth of the common gear has a relatively long length in the up and down direction (i.e., the axial direction) such that the common gear is not disengaged from the gear 354 even when the nozzle holder 170 is elevated or lowered by any of the cam 230 and the elevating and lowering devices 260, 262.

The head body 186 is provided with a placement head control device 370 (see Fig. 32). The placement head control device 370 is constituted mainly by a placement head control computer 372 and connected to the module control computer 120 to control elements such as the electric motor 192 of the rotary-body driving device 190. Encoders 374 for the components such as the electric motor 192 are connected to the placement head control computer 372 though only one of the encoders 374 is illustrated by way of example.

As illustrated in Fig. 10, a component supply device 400 is provided on the head body 186 at the position corresponding to the component receiving position. The component supply device 400 is moved by the head moving device 134 with respect to the circuit board 40 together with the pickup nozzles 172 and so on. The present component supply device 400 is designed to supply electronic circuit components by means of at least one bulk feeder 402, for example, a plurality of bulk feeders 402. In the present embodiment, the component supply device 400 can supply the electronic circuit components by means of two bulk feeders 402. Each of the bulk feeders 402 is a first component supplier held by the head body 186 constituting the placement-unit body, and the tape feeder 50 of the component supply device 24 is the second component supplier held by the module body 18 as the placement-machine body without being mounted by the head body 186.

The two bulk feeders 402 have the same construction. In the present embodiment, as illustrated in Figs. 10 and 12, each of the bulk feeders 402 includes a feeder body 410, a casing 412, a component transferring device 414 (see Fig. 19), and a component discharge promoting device 416. The bulk feeder 402 is provided on the head body 186 so as to extend from the component receiving position toward the component placement position in the Y-axis direction. The two bulk feeders 402 are moved by a feeder moving device 420 as a component-supplier moving device in a direction parallel to a straight line touching a circle corresponding to a path of turning of the nozzle holders 170, in the present embodiment, in a direction parallel to the Y-axis direction.

In the present embodiment, accordingly, the feeder bodies 410 of the respective two bulk feeders 402 are provided integrally with each other. Each of the feeder bodies 410 has an L-shape in plan view, and a lower face of an arm portion 422 that is one of arm portions of the L-shape is provided with a plurality of guide blocks 426 each as a guided member. The guide blocks 426 are movably fitted in a guide rail as a guide member provided on the head body 186 in a direction parallel to the Y-axis direction. The guide blocks 426 and the guide rail 428 constitute a guiding device 430. An arm portion 432 that is the other of the arm portions of the L-shape extends, in the X-axis direction, from a front portion of the arm portion 422 (which corresponds to the component receiving position) provided parallel to the Y-axis direction. An end part of the extended portion is located under the pickup nozzle 172 stopped at the component receiving position.

In the present embodiment, the feeder moving device 420 is driven by an air cylinder 434 and is provided on the head body 186. A piston rod 436 of the air cylinder 434 is fixed to the feeder body 410. When the piston rod 436 is expanded or contracted, the feeder body 410 is moved in the Y-axis direction while being guided by the guiding device 430. The feeder moving device 420 can be considered as a device for moving the component supply device 400 and can also be considered to constitute the component supply device 400 with the bulk feeders 402. Also, the feeder body 410 can be considered to be provided integrally with a moving member as a movable member of the feeder moving device 420 and can also be considered to serve as the moving member as the movable member. The guiding device can be considered to constitute the feeder moving device.

There will be next explained one of the two bulk feeders 402 by way of example.

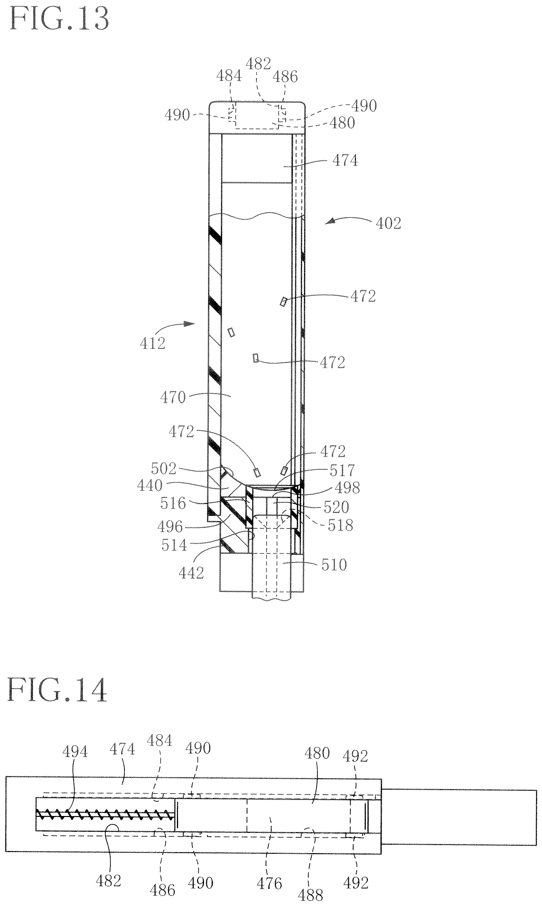

The casing 412 is formed of synthetic resin mixed with anti-static agent, for example, to prevent electrostatic buildup. As illustrated in Figs. 12 and 13, the casing 412 is constituted by a plurality of elements including first and second members 440, 442 assembled to each other for convenience of manufacturing. After the assembling, the plurality of elements function as the casing 412. The casing 412 has a flat shape having a short width and a long length. The casing 412 is removably mounted on a rear portion of the arm portion 422 and constitutes an accommodating portion.

As illustrated in Fig. 12, a recessed portion 444 is formed in a lower portion of the casing 412, specifically, in a central portion of the second member 442 in its longitudinal direction. This recessed portion 444 is open in a bottom face of the casing 412 so as to extend through the bottom face in its widthwise direction, and this recessed portion 444 constitutes a mounted portion. A ball plunger 446 as an engagement unit is provided on a portion of the second member 442 which defines a side face of a front part of the recessed portion 444. The ball plunger 446 is designed such that a ball 450 as an engagement member is movably fitted in a casing 448, and the ball 450 is urged by a spring, not shown, in a direction in which the ball 450 is projected from the casing 448. The ball plunger 446 is provided parallel to a longitudinal direction of the casing 412.

As illustrated in Fig. 12 a mount portion 454 is provided on the rear portion of the arm portion 422 of the feeder body 410. The mount portion 454 extends upward from an upper surface 456 of the feeder body 410 and is bent so as to extend frontward parallel to the upper surface 456. A mating portion 458 is provided on an end part of the bent portion so as to project therefrom. An front end face of the mating portion 458 has a conical recessed portion 460 to constitute an engaged portion.

When the recessed portion 444 is fitted on the mating portion 458, the casing 412 is positioned in the front and rear direction and placed supported by an upper face of the mating portion 458. The ball 450 of the ball plunger 446 is fitted in the recessed portion 460 to press the casing 412 against the mating portion 458 and position the casing 412 in its widthwise direction. As a result, the casing 412 is removably secured to the feeder body 410 in a state in which the widthwise direction of the casing 412 is parallel to the X-axis direction, and the longitudinal direction and the front and rear direction of the casing 412 are parallel to the Y-axis direction.

As illustrated in Fig. 12, a plurality of chip components 472 each as a leadless electronic circuit component not having lead wires are stored in a space 470 formed in the casing 412 in an unjoined or separate state. Examples of the chip components 472 include capacitors and resistors. Each of the chip components 472 may be hereinafterer referred simply as a component 472 or referred to as a bulk component 472. Formed in a top portion 474 of the casing 412 is an opening 476 extending through the top portion 474 in the up and down direction to establish a communication between the space 470 and an outside space, and this opening 476 constitutes a component receiving opening. The components 472 are loaded into the space 470 through the opening 476.

The opening 476 is opened and closed by a shutter 480 provided on the top portion 474. As illustrated in Figs. 13 and 14, a projecting portion of the top portion 474 which projects upward from the space 470 has a groove 482 which has a width equal to that of the opening 476. The groove 482 is open in an upper face and a lower face of the projecting portion and extends in the front and rear direction. The shutter 480 is fitted in the groove 482 so as to be slidable in the longitudinal direction of the casing 412 to open and close the opening 476.

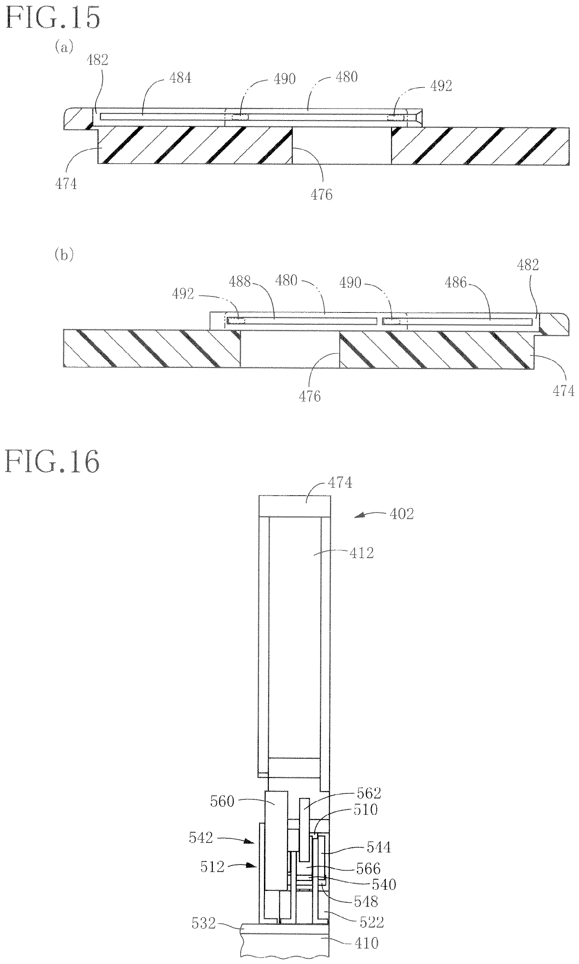

The shutter 480 is provided with guide projections 490, 492 projecting respectively from opposite side faces of the shutter 480 which are spaced apart from each other in the longitudinal direction of the shutter 480. Portions of the guide projections 490, 492 which project from one of opposite side faces of the shutter 480 in its widthwise direction are movably fitted in a guide groove 484 (see Fig. 15(a)) formed in one of opposite side faces for defining the groove 482, and other portions of the guide projections 490, 492 which project from the other of the opposite side faces of the shutter 480 in its widthwise direction are movably fitted respectively in guide grooves 486, 488 (see Fig. 15(b)) formed linearly in the other of the opposite side faces for defining the groove 482, whereby the movement of the shutter 480 is guided. The guide groove 484 is open at its rear portion (i.e., a potion of the guide groove 484 which is located near a side to which the shutter 480 is moved when closing the opening 476).

As illustrated in Fig. 12, the shutter 480 is urged by a compression coil spring 494 in a direction in which the shutter 480 closes the opening 476, and the compression coil spring 494 is provided between the shutter 480 and an end face of the groove 482. As illustrated in Fig. 15(b), the movement of the shutter 480 by the spring 494 is limited by contact of the guide projection 490 with an end face of the guide groove 486 (i.e., a partition between the guide grooves 486, 488). The position of the shutter 480 in this state is a closed position, and as illustrated in Fig. 12, the opening 476 is closed by the shutter 480.

The components 472 stored in the casing 412 are discharged from a discharge hole 498 formed in a bottom portion 496 of the casing 412, to a guide passage 500 formed in the feeder body 410. Thus, a bottom surface 502 defining the space 470 is an inclining surface, specifically, a partly-cylindrical surface which is designed such that as illustrated in Fig. 12 the bottom surface 502 inclines downward from opposite end portions of the casing 412 in its longitudinal direction to a central portion of the casing 412 and inclines symmetrically with respect to a plane perpendicular to the longitudinal direction of the casing 412 and such that as illustrated in Fig. 13 one of opposite ends of the bottom surface 502 which is farther from the discharge hole 498 than the other end in the widthwise direction of the casing 412 is located at a higher height level than the discharge hole 498, and the bottom surface 502 curves from the one end to the discharge hole 498 so as to have a downward convex shape.

The discharge of the components from the casing 412 is promoted by the component discharge promoting device 416. As illustrated in Fig. 12, the component discharge promoting device 416 includes a discharge promoting pipe 510 as a discharge promoting member and a discharge promoting pipe driving device 512 as a discharge-promoting-member driving device. The discharge promoting pipe 510 is fitted in the mating portion 458 of the feeder body 410 so as to be slidable in the up and down direction, and an upper portion of the discharge promoting pipe 510 is fitted in a mating hole 514 formed in the bottom portion 496 via a bushing 516 so as to be slidable in the up and down direction. The bushing 516 is formed of material having high wear resistance. As illustrated in Fig. 13, the mating hole 514 is formed through the bottom surface 502 in the up and down direction at a position deviating from the central portion of the bottom portion 496 in the widthwise direction, specifically, the mating hole 514 is formed through a side portion of the bottom surface 502 which is lower in height than the other side portion thereof in the widthwise direction. An upper end surface of the bushing 516 constitutes a portion of the bottom surface 502. An opening formed in the upper end surface of the bushing 516 is a component-outflow-side opening of the casing 412 and a lower opening 517 of the space 470.

The discharge promoting pipe 510 is shaped like a pipe, for example, the discharge promoting pipe 510 has a round shape in transverse cross section and has a through hole having a round shape in cross section. An upper surface of the discharge promoting pipe 510 is provided with a guide surface 518 (see Fig. 13) shaped like a beheaded circular conical surface which inclines toward a center of the guide surface 518 in the downward direction. An upper portion of the discharge promoting pipe 510 is shaped like a funnel. A pipe 520 as a guide member having a round shape in transverse cross section is fitted in the discharge promoting pipe 510 so as to be movable relative to the discharge promoting pipe 510.

As illustrated in Fig. 12, the pipe 520 is provided on a support member 522 shaped like a block which is provided under the mating portion 458 of the feeder body. The pipe 520 extends in the up and down direction and is not movable in the up and down direction. An upper end portion of the pipe 522 is located in the bushing 516 and near the lower opening 517 of the space 470, and a lower end portion of the pipe 522 is located near the upper surface 456 of the feeder body 410. An opening of the pipe 520 near the space 470 constitutes the discharge hole 498 from which the components 472 stored in the casing 412 are discharged. Formed in the support member 522 is a guide passage 524 which establishes a communication between a lower end portion of the pipe 520 and the guide passage 500. It is noted that the discharge promoting member may be constituted by a pipe formed with a through hole having a quadrilateral shape in cross section, and the pipe 520 may have a quadrilateral shape in cross section. The components 472 enter one by one from the casing 412 into the pipe 520 through the discharge hole 498 and are supplied one by one to the guide passage 500 in which the components 472 are arranged in a row and transferred.

In a case where each electronic circuit component has a rectangular shape in transverse cross section (i.e., in cross section perpendicular to a longitudinal direction of the component) and where the pipe for guiding the electronic circuit component has a round shape in transverse cross section, the pipe is designed to adjust a rotational phase of the electronic circuit component (i.e., an orientation thereof about a central axis in its longitudinal direction) to a rotational phase of the electronic circuit component to be transferred by the component transferring device after the electronic circuit component enters into the pipe in a certain rotational phase. In a case where the component transferring device transfers each electronic circuit component in an orientation to be established when the electronic circuit component is to be picked up by the pickup nozzle, the rotational phase of the electronic circuit component is adjusted such that the electronic circuit component is passed from the pipe to the component transferring device in that orientation. In a case where the pipe has a rectangular shape in transverse cross section like the electronic circuit component, the pipe only needs to be provided such that the electronic circuit component enters into the pipe in the rotational phase to be established when the electronic circuit component is transferred from the pipe to the component transferring device. An orientation changing member may be provided in the transferring path to adjust the rotational phase of the electronic circuit component passed from the pipe to the component transferring device in a certain rotational phase or a predetermined rotational phase, to the rotational phase to be established when the electronic circuit component is supplied.

The guide passage 500 is defined by: a groove 530 formed in the upper surface 456 of the feeder body 410; and a planar closing member 532 fixed to the upper surface 456 to close the groove 530. The closing member 532 constitutes a portion of the feeder body 410 in the state in which the closing member 532 is fixed to the upper surface 456. It is noted that Fig. 10 does not illustrate the closing member 532.

As illustrated in Fig. 12, the discharge promoting pipe driving device 512 includes a drive lever 540 as a drive member and a drive lever swinging device 542 as a drive-member driving device. The drive lever 540 is mounted on the closing member 532 by means of a shaft 544 so as to be pivotable about an axis parallel to a widthwise direction of the bulk feeder 402. An engaging portion 548 shaped like a yoke is provided at an end part of an arm portion 546 which is one of arm portions extending from the shaft 544, and this engaging portion 548 is engaged with the discharge promoting pipe 510.

The drive lever 540 is urged by a compression coil spring 556 in such a direction that the engaging portion 548 is moved downward. The compression coil spring 556 is provided between the drive lever 540 and the feeder body 410, with the discharge promoting pipe 510 and the casing 412 being disposed between the compression spring 556 and the feeder body 410. The discharge promoting pipe 510 is urged by a compression coil spring 558 provided between the discharge promoting pipe 510 and the casing 412, in such a direction that the discharge promoting pipe 510 is moved downward, i.e., in such a direction that the discharge promoting pipe 510 is engaged with the drive lever 540.

The drive lever swinging device 542 includes an electric motor 560 as a drive source and an eccentric cam 562 rotated by the electric motor 560. The eccentric cam 562 is shaped like a round plate and fixed eccentrically to an output shaft 564 of the electric motor 560. The eccentric cam 562 is located on an upper side of an arm portion 566 which is the other arm portion of the drive lever 540. As illustrated in Fig. 16, the discharge promoting pipe driving device 512 is provided on the feeder body 410 at a position overlying the casing 412 in the widthwise direction of the bulk feeder 402 such that the discharge promoting pipe driving device 512 does not lie off a region corresponding to one bulk feeder 402 in a widthwise direction of the feeder body 410. Accordingly, the provision of the discharge promoting pipe driving device 512 never widens the bulk feeder 402, resulting in smaller space required for the two bulk feeders 402.

The arm portion 566 is held in contact with an outer circumferential surface of the eccentric cam 562 by an urging force of the spring 556. Accordingly, when the eccentric cam 562 is rotated by the electric motor 560 to increase a distance between the rotation axis of the eccentric cam 562 and a position at which a cam surface 568 constituted by an outer circumferential surface of the eccentric cam 562 is held in contact with the drive lever 540, the drive lever 540 is pivoted against the urging force of the spring 556 to move the discharge promoting pipe 510 upward against an urging force of the spring 558. As a result, the discharge promoting pipe 510 is moved to its uppermost position indicated by two-dot chain lines in Fig. 12 through the discharge hole 498 and the opening 517 so as to project into the space 470, so that the guide surface 518 is located over the discharge hole 498 by a distance corresponding to a plurality of components, for example, two components.

When the eccentric cam 562 is rotated to shorten the distance between the rotation axis of the eccentric cam 562 and the position at which the cam surface 568 is held in contact with the drive lever 540, the drive lever 540 is pivoted by the urging force of the spring 556, and the discharge promoting pipe 510 is moved downward by the urging force of the spring 558 with the pivotal movement of the drive lever 540, so that, the guide surface 518 is moved to its lowermost position located below an upper surface of the pipe 520 as indicated by solid lines in Fig. 12. The springs 556, 558 constitute the discharge promoting pipe driving device 512 with the drive lever 540 and the drive lever swinging device 542. The electric motor 560 is controlled by the placement head control device 370 to move the discharge promoting pipe 510 in the up and down direction to any position between the uppermost position and the lowermost position.

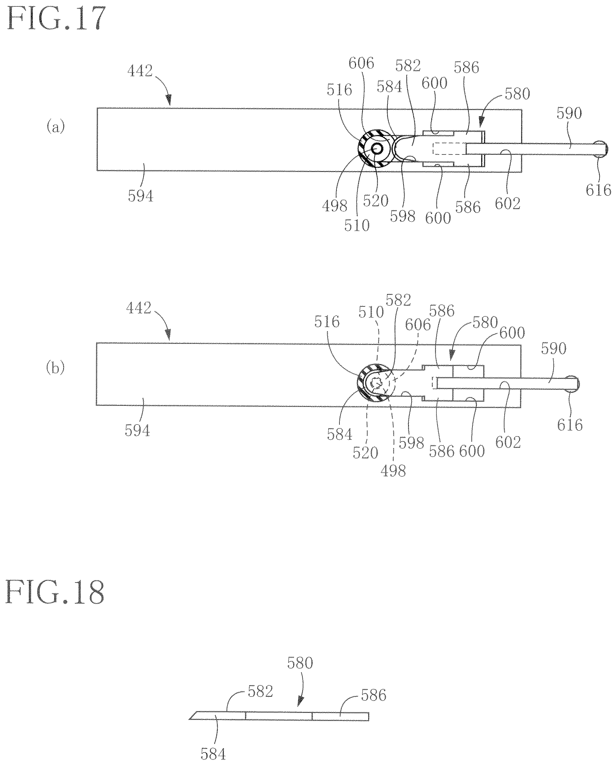

As illustrated in Fig. 12, the bottom portion 496 of the casing 412 is provided with a shutter 580 as an opening/closing member for opening and closing the lower opening 517 of the space 470. The shutter 580 is an elongated plate having a thickness smaller than the dimension of each component 472 and formed of metal such as spring steel. As illustrated in Fig. 17, one end portion of the shutter 580 in its longitudinal direction is constituted by a closing portion 582 having a semicircular shape. The diameter of a circle defining the closing portion 582 is equal to the inside diameter of the bushing 516. As illustrated in Fig. 18 in enlarged scale, the nearer to an outer circumferential edge of the closing portion 582, the smaller the thickness of an outer circumferential portion of the closing portion 582 is. The closing portion 582 has a scooping portion 584 at a position near its outer circumferential edge.

As illustrated in Fig. 17, the other end portion of the shutter 580 in its longitudinal direction has opposite end portions extending parallel to the longitudinal direction, and these opposite end portions project outward in the widthwise direction of the shutter 580. Guided portions 586 extending in the longitudinal direction are provided respectively on these opposite end portions. Also, the other end portion of the shutter 580 is fixedly fitted on one end portion of an operating rod 590 as an operating member. The operating rod 590 has a circular cylindrical shape, and the shutter 580 is fixed such that its longitudinal direction is parallel to a longitudinal direction of the operating rod 590.

As illustrated in Fig. 12, the first member 440 constitutes a portion of the casing 412 which corresponds to the space 470 and the components located above the discharge hole 498 of the mating hole 514 by a distance corresponding to the thickness of the shutter 580, and the second member 442 constitutes a portion of the casing 412 which corresponds to the components located below the space 470 and the shutter 580. The first and second members 440, 442 are secured to each other in a state in which a mating surface 592 as a lower surface of the first member 440 and a mating surface 594 as an upper surface of the second member 442 are mated to each other. The shutter 580 is sandwiched between the first and second members 440, 442 so as to be movable in a state in which the longitudinal direction of the shutter 580 coincides with the longitudinal direction of the casing 412.

In the present embodiment, as illustrated in Fig. 17, a groove 598 in which the shutter 580 is to be fitted is open in the mating surface 594 of the second member 442. The groove 598 has a width equal to the inside diameter of the bushing 516 and is formed so as to be perpendicular to a portion of the second member 442 which constitutes the mating hole 514. The groove 598 has such a length that allows the shutter 580 to be slid thereon, and a rear portion of the groove 598 has a pair of guide groove portions 600 in which the pair of guided portions 586 are to be fitted respectively. The second member 442 has another groove 602 continued from the groove 598, and the operating rod 590 is to be fitted in the groove 602 so as to be slidable in its axial direction. This groove 602 has a semicircular shape in transverse cross section, and a front portion of the groove 602 overlaps with the groove 598 while a rear portion of the groove 602 is open in a rear end face of the second member 442.

As illustrated in Fig. 12, a groove 604 having a semicircular shape in transverse cross section is formed in the mating surface 592 of the first member 440 so as to extend in the longitudinal direction of the casing 412 and be open in a rear end face of the first member 440. As illustrated in Fig. 17(a), the bushing 516 has a slit 606 extending in a direction perpendicular to a center line of the bushing 516 so as to allow the shutter 580 to be fitted in the slit 606. The slit 606 has a width equal to the inside diameter of the bushing 516.

In manufacturing the casing 412, the shutter 580 is fitted into the groove 598, the pair of guided portions 586 respectively into the pair of guide groove portions 600, and the operating rod 590 into the groove 602. The first member 440 and the second member 442 are mated and secured to each other in this state. The groove 598 is thereby closed, and as illustrated in Fig. 12, the shutter 580 is sandwiched between the first and second members 440, 442 so as to be movable in the longitudinal direction of the casing 412. A combination of the groove 604 and the groove 602 constitutes a mating hole having a round shape in transverse cross section, and the operating rod 590 is fitted in the mating hole so as to be slidable in its axial direction.

As illustrated in Fig. 12, a rear end portion of the operating rod 590 projects rearward from the second member 442, and a shaft portion 612 of an operation portion 610 is provided so as to project from the rear end portion. An extension coil spring 614 is provided between the shaft portion 612 and the second member 442 to urge the operating rod 590 in its forward direction. An urging force of the extension coil spring 614 moves the shutter 580 forward to move the closing portion 582 into the bushing 516 through the slit 606. As illustrated in Fig. 17(a), the forward movement of the shutter 580 by the spring 614 is limited by contact of the closing portion 582 with an inner circumferential surface of the bushing 516. At the forwardmost position, the shutter 580 is located on an upper end surface of the pipe 520, that is, the shutter 580 is located at its closed position for closing the opening 517.

The shutter 580 is moved backward when the operator uses a handle 616 of the operation portion 610 to move the operating rod 590 backward against the urging force of the spring 614. The handle 616 has a circular cylinderical shape which is larger in diameter than the shaft portion 612, for example. As illustrated in Fig. 12, the retracted position of the shutter 580 is a position thereof at a point in time when a ball 620 of a ball plunger 618 provided on the second member 442 is fitted in a recessed portion 622 formed and opened in an outer circumferential surface of the operating rod 590. At the retracted position of the shutter 580, as illustrated in Fig. 17(a), the closing portion 582 is moved off an inner space of the bushing 516, and the shutter 580 is kept at its open position for opening the opening 517. Like the bushing 516, the second member 442 is formed of high-quality material having high wear resistance to ensure smooth movement of the shutter 580.

It is noted that the casing 412 may be formed separately in the up and down direction such that a groove in which the shutter is to be fitted is formed in the first member as an upper member.

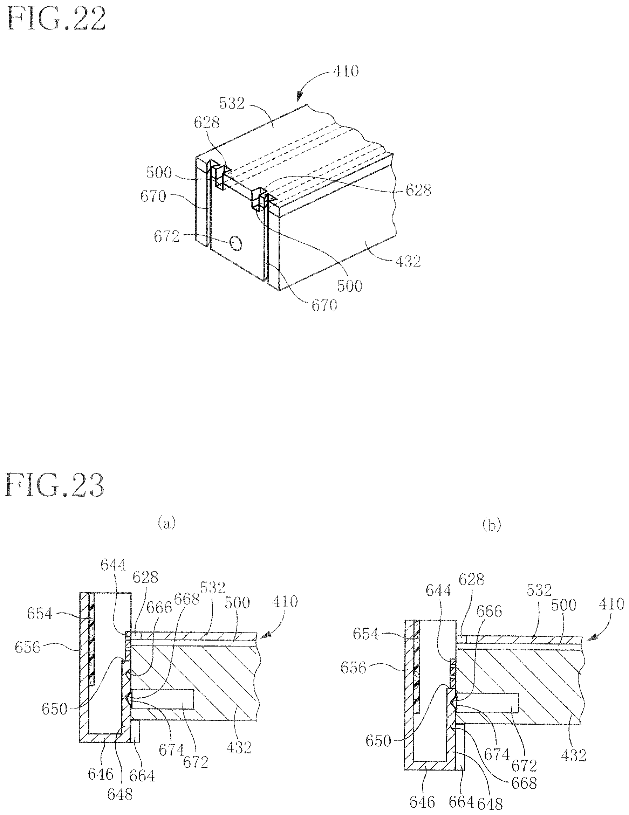

As illustrated in Figs. 10 and 19, each guide passage 500 formed in the feeder body 410 extends frontward from the guide passage 524 in a direction parallel to the Y-axis direction, and curves such that a front portion as an extended portion of the guide passage 500 extends parallel to the X-axis direction. The front end portions of the guide passages 500 formed respectively for the two bulk feeders 402 are arranged next to each other in the direction parallel to the Y-axis direction and located in a vertical plane extending parallel to the Y-axis direction which contains the axis of the pickup nozzle 172 positioned at the component receiving position. As illustrated in Fig. 23, a portion of the closing member 532 which corresponds to the front end portion of the guide passage 500 has a component taking opening 628 formed through the portion of the closing member 532 in its thickness direction. The component taking opening 628 has such a size that only one component 472 can be taken out through the component taking opening 628 at one time, and a portion of the feeder body 410 which has the component taking opening 628 therein constitutes a supply portion.

When the feeder body 410 is moved by the feeder moving device 420, and the two bulk feeders 402 are moved together in the Y-axis direction, the supply portions of the respective bulk feeders 402 are selectively positioned one by one at a component supply position opposite a portion of the path of the turning of the pickup nozzle 172 which corresponds to the component receiving position, and the supply portions selectively supply the components 472. In the present embodiment, the range of the movement of the feeder body 410 is defined by two ends of stroke of a piston of an air cylinder constituting the feeder moving device 420, and the supply portions of the respective bulk feeders 402 are selectively positioned at the component supply position. In the present embodiment, the feeder moving device 420 constitutes a third relative-movement device.

In each of the bulk feeders 402, as illustrated in Fig. 10, the arm portion 422 and the casing 412 of the feeder body 410 are provided parallel to the Y-axis direction. The arm portions 422 and the casings 412 of the respective two bulk feeders 402 are arranged next to each other in the X-axis direction, and each guide passage 500 curves to the component receiving position, enabling the supply of the components 472. Each of the two bulk feeders 402 has a small dimension in a direction parallel to the board transferring direction and is provided on the head body 186 such that each bulk feeder 402 does not interfere with the rotary body 180 and the pickup nozzles 172 and such that the supply portion of each bulk feeder 402 is located under the pickup nozzle 172 located at the component receiving position. Accordingly, the placement head 132 less frequently deviates from the circuit board 40 to one side thereof in the board transferring direction during placement, in the present embodiment, an upstream side in the board transferring direction, ensuring a larger area for the placement head 132 to place the electronic circuit components. In addition, when the placement head 132 receives the electronic circuit component from the tape feeder 50, it is possible to ensure a larger area for the receipt. In particular, one of the longest distance stop positions which is located farthest from the board holding device 22 is set at the component receiving position, and thereby a space for the bulk feeders 402 is provided between the pickup tube 197 and the board holding device 22. Accordingly, the bulk feeders 402 can be provided without making the height of the rotary body 180 higher to obtain the space of the bulk feeders 402, resulting in effective reduction of the deviation of the placement head 132 from the circuit board 40.

In the present embodiment, the component transferring device 414 is designed to use air flow to transfer the components 472 from a position near the casing 412 to the supply portion. As illustrated in Fig. 19, the interior of the feeder body 410 has a plurality of air blowing passages 630, e.g., two air blowing passages for one guide passage 500. Each of these air blowing passages 630 inclines with respect to the guide passage 500. One end portion of each air blowing passage 630 is open in the guide passage 500 and located downstream of the other end portion thereof in a component transferring direction. The other end portion is connected to the positive pressure source 204 through a common passage 632 formed in the feeder body 410 and a communication passage 634 formed outside the feeder body 410.

Each communication passage 634 is provided with an electromagnetic open/close valve 638 as one kind of an electromagnetic control valve. The electromagnetic open/close valve 638 is a normally closed valve which is open when the components are transferred, and compression air is blown from the air blowing passages 630 to the guide passage 500. This blowing of the compression air forms an airflow directed from a position near the casing 412 to the component taking opening 628, so that the components 472 arranged in a row in the guide passage 500 are transferred to the supply portion. In the present embodiment, the component transferring device 414 and the guide passage 500 constitute a component transferring portion.

The transfer of each component 472 is stopped by a stopper 644, and the component 472 is positioned at the component taking position in the component taking opening 628 and then positioned at the supply portion. In the present embodiment, as illustrated in Fig. 19, the stopper 644 is provided on a component receiver 646. As illustrated in Fig. 21, the component receiver 646 is shaped like a container opening upward, and one of four side walls of the component receiver 646 is a side wall 648 which has a cutout 650 at its upper portion. The stopper 644 is fixed to the component receiver 646 in the cutout 650.

As illustrated in Fig. 20, the stopper 644 is a thin plate having a multiplicity of holes 652 which are formed through the stopper 644 in its thickness direction so as to be arranged in a staggered configuration. Each of the holes 652 has a diameter allowing air to pass therethrough but inhibiting the component 472 from passing therethrough. As illustrated in Figs. 19 and 21, the stopper 644 is fixed to the component receiver 646 in a lower portion of the cutout 650 such that an outer face of the stopper 644 is flush with that of the side wall 648. The four side walls of the component receiver 646 include a side wall 662 opposing the side wall 648, and a cushioning material 654 is affixed to an upper portion of an inner face of the side wall 662. The cushioning material 654 is formed of foam rubber, for example, and disposed opposing the cutout 650 and the stopper 644.

As illustrated in Fig. 21, an outer surface of the side wall 648 is provided with a pair of rails 664 arranged parallel to each other so as to extend in the up and down direction, and this pair of rails 664 constitute a guided portion and an engaging portion. Each of these rails 664 has a trapezoid shape in transverse cross section, that is, each rail 664 is formed so as to be fitted in a dovetail groove. The side wall 648 has recessed portions 666, 668 between the pair of rails 664, and these recessed portions 666, 668 are spaced apart from each other in the up and down direction and constitute an engaged portion. As illustrated in Fig. 22, two dovetail grooves 670 are formed through a distal end portion of the arm portion 432 of the feeder body 410 in the up and down direction and constitute a guide portion and an engaging portion. A ball plunger 672 is provided between the dovetail grooves 670.

As illustrated in Fig. 23, when the pair of rails 664 are fitted in the respective dovetail grooves 670, and a ball 674 of the ball plunger 672 is fitted selectively in one of the recessed portions 666, 668, the component receiver 646 is secured to the feeder body 410 without any space between the component receiver 646 and the feeder body 410. The ball plunger 672 and the recessed portions 666, 668 position the stopper 644 selectively to one of: a working position or a stop position illustrated in Fig. 23(a) at which the stopper 644 closes the guide passage 500 to stop the transfer of the components 472; and a non-working position or an exposing position illustrated in Fig. 23(b) at which the stopper 644 is located below the guide passage 500 to expose its opening. The component receiver 646 is positioned selectively at one of a non-accommodating position illustrated in Fig. 23(a) and an accommodating position illustrated in Fig. 23(b). The component receiver 646 is provided such that the cushioning material 654 opposes the guide passage 500 and is located on opposite sides of the guide passage 500 in the up and down direction when the component receiver 646 is located at any of the non-accommodating position and the accommodating position. It is noted that the air cylinder 434 of the feeder moving device 420 of the bulk feeder 402 and the electromagnetic open/close valve 638 of the component transferring device 414 are controlled by the placement head control device 370.

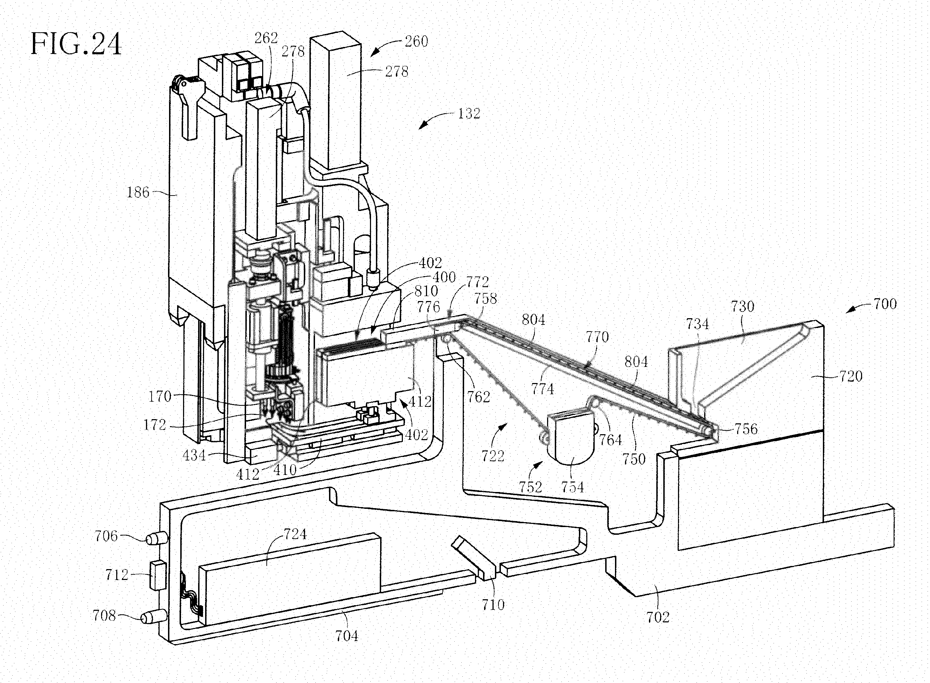

As illustrated in Fig. 24, the placement modules 10 respectively include component loading devices 700. The above-described two bulk feeders 402 respectively supply different kinds of the chip components 472. Accordingly, two component loading devices 700 are provided (Fig. 24 illustrates one component loading device 700 by way of example) and each holds a corresponding one of different kinds of the chip components 472 to load the components 472 into a corresponding one of the bulk feeders 402 which is to supply the corresponding kind of the components 472.

In the present embodiment, the component loading device 700 is held by the feeder holding table 52 and by the module body 18. That is, the component loading device 700 is held by the module body 18 without being held by the head body 186 of the placement head 132. Accordingly, a device body 702 of the component loading device 700 is similar in construction to the feeder body 80 of the tape feeder 50, and a rail 704 provided on a bottom surface of the device body 702 is fitted in the groove 56 of the feeder holding table 52. Also, a pair of positioning projections 706, 708 provided on a front face of a front end portion as one end portion of the device body 702 in its longitudinal direction are positioned by being fitted in the respective locating holes 58, 60, and the device body 702 is secured to the feeder holding table 52 by an engagement device 710. Furthermore, a connector 712 is connected to the connector 62.

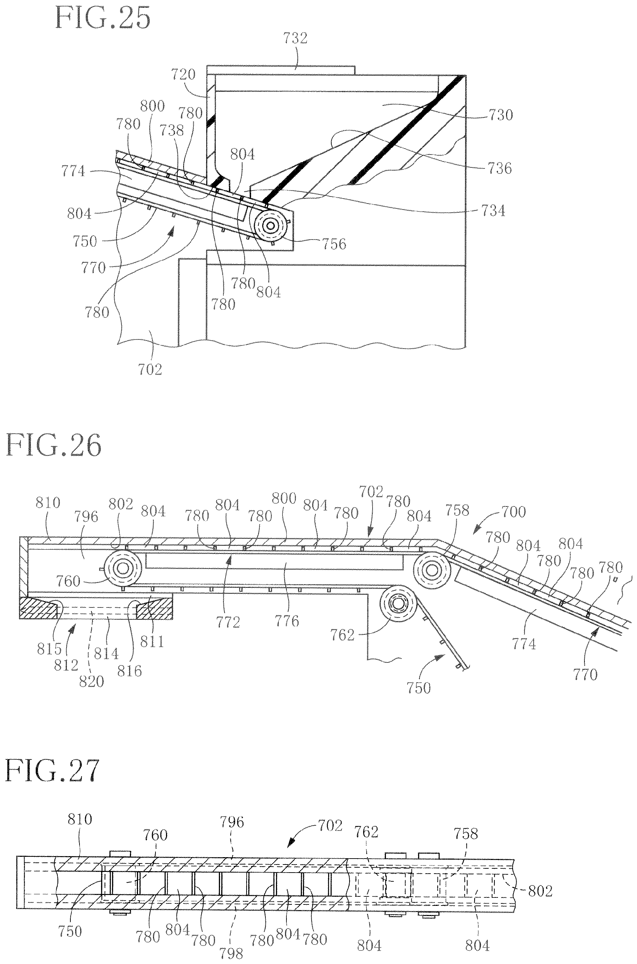

The component loading device 700 includes: a casing 720 as a component container provided on the device body 702; a component conveyor 722; and a component-loading-device control device 724. The casing 720 is a flat member having a short width and a long length. The casing 720 is provided at a rear end portion as the other end portion of the device body 702 in its longitudinal direction and constitutes an accommodating portion. As illustrated in Fig. 25, the components 472 are loaded into a space 730 formed in the casing 720 from an opening formed in a top portion 732, not shown, and discharged from an output opening 734 formed in a portion of the casing 720 which constitutes a bottom portion of the space 730. A shutter, not shown, having a construction similar to that of the shutter 480 provided on the casing 412 is provided on the top portion 732, and the operator operates this shutter to open or close the opening. It is noted that Fig. 24 illustrates the components of the device body 702, with a side plate being removed.

As illustrated in Fig. 25, the output opening 734 is formed in front of a center of the space 730 in its longitudinal direction. A bottom surface 736 of the space 730 has a front portion and a rear portion located on opposite sides of the output opening 734. The front portion is shorter than the rear portion and inclines downward toward a rear end of the front portion, and the rear portion inclines downward toward a front end thereof. That is, each of the front portion and the rear portion inclines toward the output opening 734. A lower face of the casing 720 in which the output opening 734 is formed is an inclined surface 738 inclining upward in a front direction. The output opening 734 is open in the inclined surface 738 on the other side of the opening 734 from the space 730.

In the present embodiment, as illustrated in Fig. 24, the component conveyor 722 includes an endless component conveyor belt 750 as a conveyor member and a belt rotating device 752 as a conveyor-member driving device and constitutes a component conveying portion and a component transferring portion. As illustrated in Figs. 24 and 26, the belt rotating device 752 includes: an electric motor 754 as a drive source; guide rollers 756, 758, 760, 762, 764 each as a rotation guide member as one kind of a guide member; and a drive roller, not shown, rotated by the electric motor 754.

Each of the guide rollers 756-764 is mounted on the device body 702 so as to be rotatable about an axis extending parallel to the widthwise direction, and the guide rollers 756-764 are respectively located at positions that differ from each other in at least one of the front and rear direction and the vertical direction. Thus, the component conveyor belt 750 includes: an inclined portion 770 extending under the output opening 734 as illustrated in Fig. 25 and inclining upward from the rear side toward the front side as illustrated in Fig. 24; and a horizontal portion 772 horizontally extending frontward from a front end of the inclined portion 770. Lower sides of the inclined portion 770 and the horizontal portion 772 are supported respectively by guide rails 774, 776, and movement of the component conveyor belt 750 is guided by the guide rails 774, 776. The horizontal portion 772 is defined by the two guide rollers 758, 760, and the guide roller 760 is located in front of the guide roller 758. The component conveyor belt 750 is wrapped on the guide roller 760 from an upper side thereof, then turned so as to horizontally extend rearward, and guided by the guide roller 762 to the drive roller.

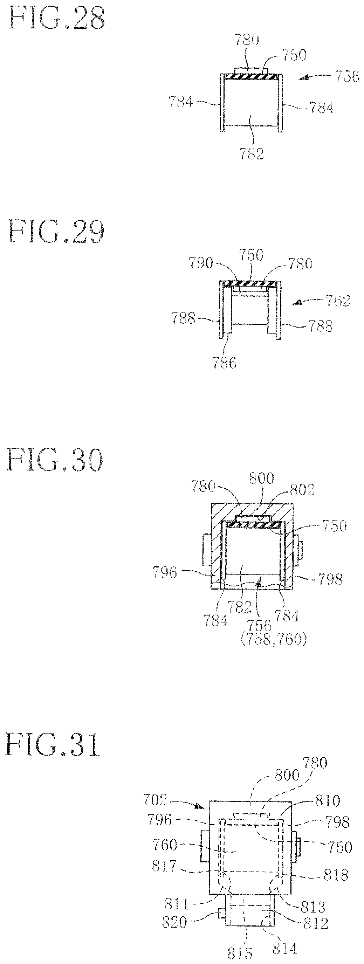

As illustrated in Fig. 26, a plurality of protruding portions 780 are provided on an outer surface of the component conveyor belt 750 so as to be evenly spaced apart from each other in a longitudinal direction of the component conveyor belt 750. As illustrated in Fig. 28, each of the protruding portions 780 is a projection whose width is shorter than that of a portion of the component conveyor belt 750 which is wrapped on the guide roller 756 and so on and whose length is shorter than a width of the opening 476 of the casing 412. Though only the guide roller 756 is illustrated in Fig. 28 by way of example, each of the guide rollers 756, 758, 760 on which an inner circumferential surface of the component conveyor belt 750 is wound is provided with flange portions 784 for limiting movement of the component conveyor belt 750 in its widthwise direction. Each roller has a wrapped portion 782 having a round shape in transverse cross section, and these flange portions 784 are located on opposite end portions of the wrapped portion 782 in its axial direction. Also, though only the guide roller 762 is illustrated in Fig. 29 by way of example, each of the guide rollers 762, 764 on which an outer circumferential surface of the component conveyor belt 750 is wound includes: wrapped portions 786 on which no protruding portion 780 is provided and on which opposite edge portions of the belt 750 are respectively wrapped; a pair of flange portions 788; and an annular recessed portion 790 capable of accommodating the protruding portions 780.

The device body 702 is constituted by a plurality of elements assembled together with each other and includes, as illustrated in Fig. 30, side wall portions 796, 798 and a top portion 800 for covering the component conveyor belt 750 from opposite sides thereof in the widthwise direction and from an upper side thereof. The top portion 800 has a recessed portion 802 opening in its inner face and having such a width and a depth that the recessed portion 802 perfectly fits the protruding portions 780. The recessed portion 802 extends parallel to the longitudinal direction of the component conveyor belt 750. As a result, as illustrated in Fig. 27, a plurality of component accommodation recesses 804 each having a rectangular shape in plan view are formed so as to be evenly spaced apart from each other in the longitudinal direction of the component conveyor belt 750. Each of the component accommodation recesses 804 is defined by: corresponding adjacent two of the protruding portions 780 provided on the component conveyor belt 750; a bottom face of the recessed portion 802; and a pair of side faces of the recessed portion 802 which extend parallel to a direction in which the belt is rotated.

As illustrated in Fig. 26, a portion of the device body 702 which covers the horizontal portion 772 of the component conveyor belt 750 horizontally extends frontward to a position in front of the guide roller 760 so as to form an extending portion 810. As illustrated in Fig. 31, portions of the side wall portions 796, 798 of the device body 702 which constitute the extending portion 810 respectively have lower end portions 811, 813 extending in such directions that the lower end portions 811, 813 are gradually made closer to each other. As illustrated in Figs. 26 and 31, a drive member 812 is provided under the lower end portions 811, 813.

The drive member 812 has a rectangular shape in plan view and has the same width as the groove 482 formed in the top portion 474 of the casing 412 of the bulk feeder 402, and a longitudinal direction of the drive member 812 is parallel to that of the extending portion 810. The drive member 812 extends from a front end of the extending portion 810 to a position at a rear of the guide roller 760 and has a component output opening 814 of the component loading device 700 which extends through the drive member 812 in the up and down direction. The component output opening 814 is shorter in length than the opening 476 formed in the top portion 474 of the casing 412 and shorter in width than the opening 476. As illustrated in Fig. 26, the component output opening 814 are partly defined by two portions of the drive member 812 which are spaced apart from each other in the longitudinal direction of the drive member 812, and upper surfaces of the respective two portions of the drive member 812 are inclined surfaces 815, 816 inclining downward toward a center of the component output opening 814. As illustrated in Fig. 31, a distance between the lower end portions 811, 813 of the respective side wall portions 796, 798 is shorter than the width of the component output opening 814, and inner side surfaces of the respective lower end portions 811, 813 are inclined surfaces 817, 818 inclining downward toward the center of the component output opening 814. That is, there are no surfaces inclining upward for receiving the chip components 472, allowing the chip components 472 to reliably entering into the casing 412 through the component output opening 814 and the opening 476. Also, a rail 820 is horizontally provided on one of opposite outer faces of the drive member 812 which are parallel to the longitudinal direction of the drive member 812. This rail 820 can be fitted in the groove 484 formed in the top portion 474 of the casing 412 and constitutes a guided portion.

It is noted that shafts for rotatably supporting the respective rollers such as the guide roller 756 are mounted on the side wall portions 796, 798, and the extending portion 810 is smaller in width than the casing 412 of the bulk feeder 402 including these shafts.

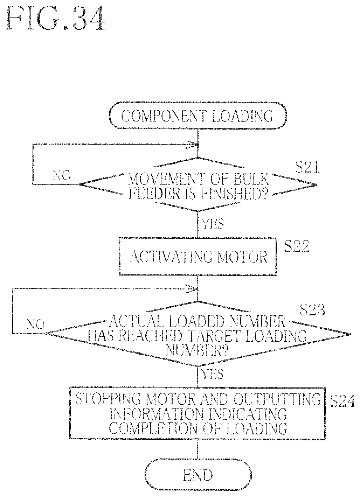

The component-loading-device control device 724 is constituted mainly by a component-loading-device control computer 822 (see Fig. 32). An encoder 824 of the electric motor 754 is connected to the component-loading-device control device 724, and the component-loading-device control device 724 controls the electric motor 754. When the connectors 712, 110 are connected to each other, the component-loading-device control computer 822 is connected to the module control computer 120. A RAM of the component-loading-device control computer 822 stores a component loading routine illustrated in Fig. 34.

As illustrated in Fig. 32, the module control device 32 uses a drive circuit 830 to control drive sources and so on for various devices constituting the placement module 10 such as the linear motor 142 and uses a control circuit 832 to control a display screen 834. The control circuit 832 and the display screen 834 constitute a display device 836, as a notification device, for displaying various types of information in the form of characters, figures, and so on. Examples of the notification device include devices which notify the operator of information in various methods such as illumination and blink of a lamp, a sound of a buzzer, a voice announce, and a communication with a mobile terminal owned by the operator.

Devices connected to an input/output interface of the module control computer 120 include: an image processing computer 840 configured to process data representative of images taken by the fiducial-mark taking device 28 and the component-image taking device 30; encoders 842 (one of which is illustrated in Fig. 32 by way of example) provided for devices such as an electric motor for the X-axis-slide moving device 150; the tape feeder control computer 114; the placement head control computers 171, 372; and the component-loading-device control computer 822. It is noted that the data representative of the images taken by the component-image taking device 240 of the placement head 132 is transmitted from the placement head control device 370 to the image processing computer 840 via the module control computer 120, and the image processing computer 840 processes the data. Data required is transmitted from the module control computer 120 to the placement head control computer 372.

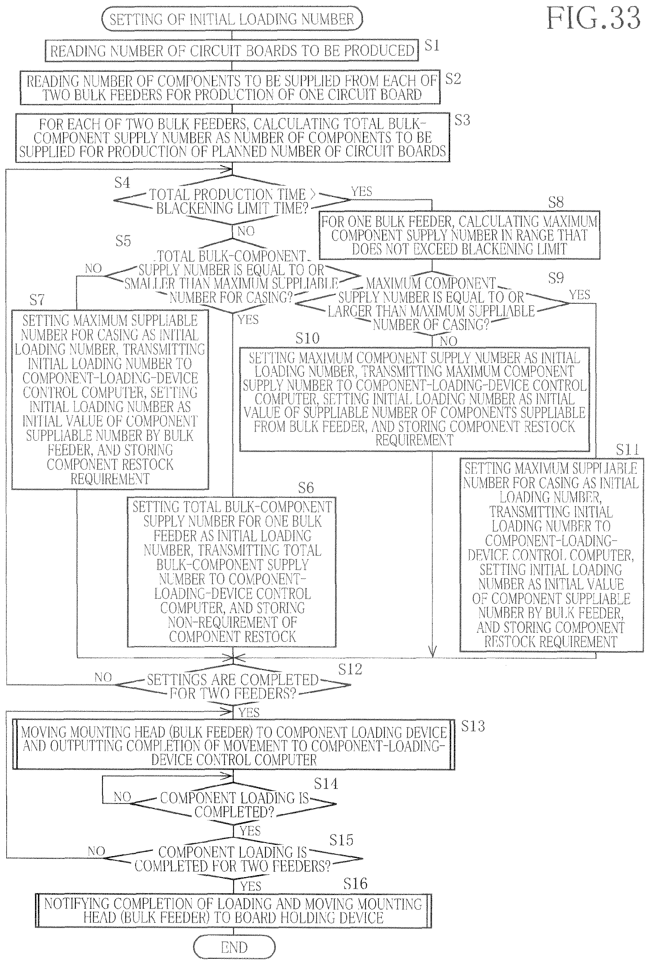

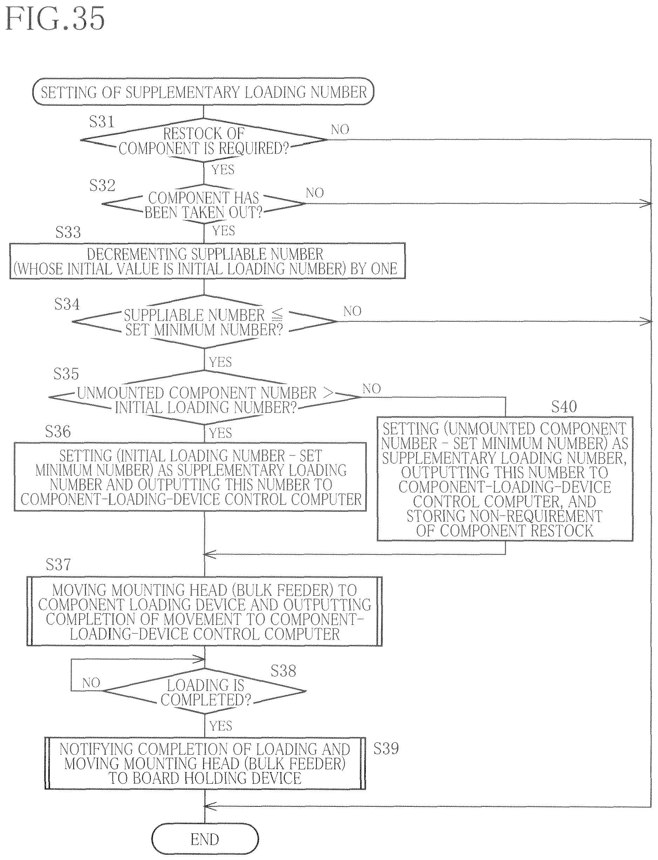

The respective module control devices 32 of the other placement modules 10 and a line control device 844 for controlling the entire placement line are also connected to the input/output interface via a communication cable 846. A RAM of the module control computer 120 includes various programs, data, and other similar information for placement of the electronic circuit components onto the circuit board 40 such as routines illustrated in the flow charts in Figs. 33 and 35.

These programs include a production program which contains information such as types and the number of the circuit boards 40 on which the electronic circuit components are to be placed and types and the number of the electronic circuit components to be placed. The programs further include a placement program which contains: coordinates defining a plurality of component placement positions set on the component-placement surface of the circuit board 40; types of electronic circuit components to be placed on the respective component placement positions; a type of the component feeder used to supply the electronic circuit components (the bulk feeder or the tape feeder); component-supply-device designating data; component-feeder designating data; and data in which orientations of the electronic circuit components upon placement and similar information are associated with the order in which the electronic circuit components are to be placed.

The component-supply-device designating data indicates whether the electronic circuit components are to be supplied from the component supply device 400 of the placement head 132 or the component supply device 24 provided on the base 38. In a case where the electronic circuit components are to be supplied by the component supply device 400, head-body component-supply-device designating data is created. In a case where the electronic circuit components are to be supplied by the component supply device 24, module-body component-supply-device designating data is created. The head-body component-supply-device designating data is first-component-supplier-use designating data for designating a supply of electronic circuit components by means of the first component supplier held by the placement-unit body. The module-body component-supply-device designating data is second-component-supplier-use designating data for designating a supply of electronic circuit components by means of the second component supplier held by the placement-machine body without being held by the placement-unit body.

The component-feeder designating data indicates a component feeder used to supply electronic circuit components among a plurality of component feeders provided for the same component supply device. For example, the component feeder of the component supply device held by the placement-unit body is designated according to its position on the placement-unit body, and the component feeder of the component supply device held by the placement-machine body is designated according to its position on the placement-machine body. Bulk-feeder designating data is created for the component supply device 400 for supplying the electronic circuit components using the two bulk feeders 402. One of the two bulk feeders 402 which is to be used to supply the bulk components 472 is designated according to its position on the head body 186 in the X-axis direction. The mount portion 454 to which the casings 412 of the respective bulk feeders 402 are to be mounted are provided on the feeder body 410 of the two bulk feeders 402 so as to be arranged in the X-axis direction, and the bulk feeder 402 to be used to supply the electronic circuit components is designated according to positions of the two placement units 454 in the X-axis direction. Tape-feeder designating data is created for the component supply device 24 for supplying the electronic circuit components using the tape feeders 50. One of the tape feeders 50 which is to be used to supply the electronic circuit components is designated according to its position on the feeder holding table 52.

There will be explained placement of the electronic circuit components onto the circuit board 40 by the placement head 132.

In each of at least one of the placement modules 10 constituting the electronic-circuit-component placement line, the placement head 132 is mounted on the second X-axis slide 148 and used to place the electronic circuit components. It is assumed in this example that the placement head 132 is designed such that the twelve nozzle holders 170 respectively hold the pickup nozzles 172 of the same type and such that the placement head 132 takes out the electronic circuit components from the bulk feeders 402 and the tape feeders 50 to place the components onto the circuit board 40. The number of types of the electronic circuit components to be placed on the circuit board 40 is larger than the number of the bulk feeders 402, and electronic circuit components of the types unabled to be supplied by the bulk feeders 402 are to be supplied by the tape feeders 50. Twenty-four electronic circuit components are to be placed on the circuit board 40, twenty-one of which are the bulk components 472, three of which are electronic circuit components to be supplied from the tape feeder 50 (each hereinafter may be referred to as "tape-feeder supply component" as needed). The rotary body 180 are rotated two times to cause the placement head 132 to complete placement for one circuit board 40 (hereinafter, placement during one rotation of the rotary body 180 will be referred to as "one cycle"). Twelve bulk components 472 are placed in the first cycle, and nine bulk components 472 and three tape-feeder supply components are placed in the second cycle.

The circuit board 40 is loaded into the placement module 10 by the board conveyor device 20 and held by the board holding device 22. When the board holding device 22 holds or releases the circuit board 40, its support member and clamp member are moved. After the circuit board 40 is held, however, the support member and clamp member are not moved and keep their stationary state during placement of the electronic circuit components. The fiducial mark of the circuit board 40 held by the board holding device 22 is taken by the fiducial-mark taking device 28, and positional errors between the component placement positions are calculated. Each positional error contains: positional errors of the component placement position in the X-axis direction and the Y-axis direction; and a rotational positional error which is a positional error of the component placement position about an axis perpendicular to the component-placement surface of the circuit board 40.

The twelve pickup nozzles 172 of the placement head 132 are initially turned by the rotation of the rotary body 180 so as to be positioned one by one at the component receiving position where each pickup nozzle 172 takes the component 472 out of the bulk feeder 402. During placement of the electronic circuit components, the following data sets are read from the placement program for each component in the order of placement: the type of the electronic circuit component; the component-supply-device designating data; the data for designating the component feeder to be used to supply the electronic circuit component; and data representative of, e.g., the component placement position. The data read from the placement program is transmitted from the module control computer 120 to the placement head control computer 372. The feeder moving device 420 is controlled based on the head-body component-supply-device designating data and the bulk-feeder designating data contained in the data, and the designated bulk feeder 402 is positioned at the component supply position to supply the bulk components 472 of the set type. Also, the elevating and lowering device 262 and the valve switching device 300 are operated based on the head-body component-supply-device designating data to cause the pickup nozzles 172 to receive the bulk components 472 at the component receiving position.

The nozzle holder 170 is moved downward at the component receiving position by the elevating and lowering device 262, and the valve spool 202 of the switching valve device 200 corresponding to the nozzle holder 170 is moved downward by pressing contact of the valve switching device 300 from the positive pressure supply position to the negative pressure supply position, so that the negative pressure is supplied to the pickup nozzle 172 which thereby picks up the bulk component 472. The drive member 270 of the elevating and lowering device 262 is lowered in a state in which a downstream end portion of the engagement protruding portion 222 of the engagement member 210 fitted on the nozzle holder 170 in its turning direction is located under the roller 290 of the drive member 270, whereby the drive member 270 moves the nozzle holder 170 downward. The turning and lowering of the nozzle holder 170 are performed simultaneously, and this simultaneous movement is allowed by the rotation of the roller 290.

In the bulk feeder 402, the stopper 644 is positioned at the stop position, and the leading component 472 in the guide passage 500 is brought into contact with the stopper 644, so that the component is located at the component taking position under the component taking opening 628. The pickup nozzle 172 is lowered to pick up the component 472 and elevated to take the component 472 out of the guide passage 500 through the component taking opening 628. After the component is taken out, the compression air is blown from the air blowing passage 630 to the guide passage 500, moving the component 472 to the supply portion. The stopper 644 has the holes 652 through which the air passes through the stopper 644 to provide airflow. The leading component 472 is stopped by contacting the stopper 644 and waits for being taken out.

The component discharge promoting device 416 is operated each time when a predetermined number of the components 472 are supplied. In operation, the discharge promoting pipe 510 is elevated from its lowermost position to its uppermost position concurrently with the downward movement of the pickup nozzle 172 so as to enter into the casing 412 containing the bulk components 472. As a result, a bridge between the bulk components 472 is removed, and the guide surface 518 is positioned above the discharge hole 498 to guide the enter of the bulk components 472 into the pipe 520. The discharge promoting pipe 510 is moved downward to its lowermost position concurrently with transfer of the components 472.

The pickup nozzle 172 having received the bulk component 472 at the component receiving position is moved by the rotation of the rotary body 180 to the component-image taking position where an image of the bulk component 472 is taken by the component-image taking device 240. Data representative of the image is processed to calculate a holding position error which is an error in a holding position at which the pickup nozzle 172 holds the bulk component 472. The holding position error includes: a positional error of the holding position in the X-axis direction and the Y-axis direction; and a rotational positional error which is a positional error of the holding position about the axis. After the image is taken, the pickup nozzle 172 positioned at the component placement position by the rotation of the rotary body 180 is lowered by the elevating and lowering device 260 to place the bulk components 472 onto the component placement position on the circuit board 40. The bulk feeder 402 is mounted on the head body 186, and accordingly concurrently with the receipt of the bulk component by the pickup nozzle 172 from the bulk feeder 402 and the image taking of the bulk component 472 held by the pickup nozzle 172, the placement head 132 can be moved by the head moving device 134 with respect to the board holding device 22 to position the pickup nozzle 172 at the component placement position and place the bulk component 472 onto the circuit board 40.

Correction of the position to which the placement head 132 is to be moved corrects a positional error between the bulk component 472 held by each pickup nozzle 172 and the corresponding component placement position on the circuit board 40 in the X-axis direction and the Y-axis direction. In addition, the nozzle holders 170 are rotated about their respective axes by the nozzle holder rotating device 350 to correct a rotational positional error between the bulk component 472 held by each pickup nozzle 172 and the corresponding component placement position. At the same time, a holding angle at which each electronic circuit component is held is also changed. Since the nozzle holder rotating device 350 rotates the twelve nozzle holders 170 at the same time, each nozzle holder 170 is rotated, taking rotation angles of the other nozzle holders 170 into consideration. This applies to a case where a rotational position error of the bulk component 472 is obtained by taking its image. Control for rotating all the nozzle holders 170 at the same time is disclosed in JP-A-10-163677, for example, and an explanation of which is dispensed with.

The turning and lowering of the nozzle holder 170 are performed simultaneously also during placement of the bulk component 472. Also, the valve spool 202 located at the negative pressure supply position is elevated to the positive pressure supply position by the valve switching device 302, so that the supply of the negative pressure to the pickup nozzle 172 is interrupted, and the positive pressure is supplied to the pickup nozzle 172.

The bulk feeders 402 and the component-image taking device 240 are provided on the head body 186 with the pickup nozzles 172 and moved together with respect to the board holding device 22, and the twelve pickup nozzles 172 are moved with respect to the bulk feeders 402 and the component-image taking device 240 by the rotation of the rotary body 180. Thus, the pickup nozzle 172 positioned at the component receiving position can receive the bulk component 472 from the bulk feeder 402 regardless of the position of the placement head 132, and an image of the electronic circuit component held by the pickup nozzle 172 which has reached the component-image taking device can be taken by the component-image taking device 240. Furthermore, the following operations can be carried out concurrently with each other: taking out the bulk component 472 from the bulk feeder 402 by one of the pickup nozzles 172; taking an image of the bulk component 472 held by another pickup nozzle 172 by means of the component-image taking device 240; and placing the bulk component 472 held by still another pickup nozzle 172 onto the circuit board 40.

These concurrent operations are performed to place the twelve bulk components 472 onto the circuit board 40 in the first cycle. Following the placement of the twelve bulk components 482 in the first cycle, the nine bulk components 472 are placed onto the circuit board 40 in the second cycle. Specifically, the placement of the bulk components 472 in the first cycle and receiving the bulk component 472 from the bulk feeder 402 and taking an image of the bulk component 472 in the second cycle are performed concurrently with each other. Nine pickup nozzles 172 of the plurality of pickup nozzles 172 receive the respective bulk components 472 and place them onto the circuit board 40.

The three tape-feeder supply components are to be placed on the circuit board 40 in the second cycle. Thus, after completion of the placement of the nine bulk components 472 in the second cycle, the placement head 132 is moved to the component supply device 24 in a state in which any of the twelve pickup nozzles 172 does not hold the electronic circuit component. The head moving device 134 is operated based on the module-body component-supply-device designating data and the tape-feeder designating data contained in the data read from the placement program. As a result, the placement head 132 is moved to the designated tape feeder 50, and the electronic circuit components are received from the tape feeder 50 by the pickup nozzle 172 being located at the component receiving and placement position and two pickup nozzles 172 next to the pickup nozzle 172 on an upstream side of the pickup nozzle 172 in the rotational direction of the rotary body 180. In this operation, the elevating and lowering device 260 and the valve switching device 302 are operated based on the module-body component-supply-device designating data to cause the pickup nozzles 172 to receive the respective tape-feeder supply components at the component receiving and placement position. The component-supply-device designating data also serves as component-receipt stop-position designating data for designating one of the twelve stop positions which is used for the pickup nozzle 172 to receive the electronic circuit component and as data for designating one of the elevating and lowering devices 260, 262 and one of the valve switching devices 300, 302 which are to be operated.

After the components are received, the rotary body 180 is rotated by 120 degrees, so that the leading pickup nozzle 172 holding the tape-feeder supply component, i.e., the pickup nozzle 172 located on the most downstream side in the rotational direction of the rotary body 180 is moved to the component-image taking position where an image of the tape-feeder supply component is taken. The rotary body 180 is intermittently rotated thereafter, and images of the tape-feeder supply components held by the other two pickup nozzles 172 are taken. Then, the rotary body 180 is rotated by 120 degrees, so that the leading pickup nozzle 172 is moved to the component receiving and placement position to place the tape-feeder supply component onto the circuit board 40. The rotary body 180 is intermittently rotated thereafter, so that the other two pickup nozzles 172 are moved to the component receiving and placement position to place the tape-feeder supply components onto the circuit board 40.

Upon each completion of the placement of the electronic circuit components onto one circuit board 40, a state in which all the pickup nozzles 172 hold no electronic circuit components or an empty state of the placement head 132 is established, and the electronic circuit components are placed onto the next circuit board 40 that is loaded in the empty state. When the circuit board 40 is loaded into the placement module 10 and when an image of the fiducial mark is taken by the fiducial-mark taking device 28, for example, the placement head 132 causes the pickup nozzles 172 to receive the bulk components 472 from the bulk feeders 402 and causes the component-image taking device 240 to take an image of the bulk component 472 to prepare for placement onto the circuit board 40. Concurrently with the placement of the tape-feeder supply components onto the circuit board 40 by the placement head 132 in the second cycle, the pickup nozzles 172 can receive the bulk components 472 to be placed onto the next circuit board 40 in the first cycle.

In the present placement module 10, the placement head 132 is mounted on the second X-axis slide 148 in its empty state in which no bulk components 472 are accommodated in the casing 412, no bulk components 472 are present in the pipe 520 and the guide passage 500, and no bulk components 472 are held by the entire bulk feeder 402. The component loading device 700 loads the bulk components 472 into the casing 412 in advance of a start of placement of the bulk components 472 onto the circuit board 40. The component loading device 700 loads the bulk components 472 into the casing 412 also during placement of the bulk components 472 onto the circuit board 40 as needed.

The module control computer 120 initially executes an initial loading number setting routine illustrated in Fig. 33 to set an initial loading number for each of the two bulk feeders 402, and this initial loading number indicates the number of the bulk components 472 to be loaded into the empty casing 412. The initial loading number is also a target loading number as a target loading amount.

At step 1 (hereinafter abbreviated as "S1", the other steps being similarly abbreviated), a planned production number of the circuit boards 40 is read from the production program. The planned production number is the number of the circuit boards 40 onto which electronic circuit components are to be placed by the placement modules 10. At S2, the number of the bulk components 472 to be supplied from each of the two bulk feeders 402 for production of one circuit board 40 is read from the production program. At S3, the planned production number of the circuit boards 40 and the number of components to be supplied by one bulk feeder 402 read at S1, S2 are multiplied by each other, and the number obtained by adding the number of the circuit boards 40 required for recovery of, e.g., failures in pickup and placement of the bulk components 472 by the pickup nozzles 172, to the number obtained by the multiplication is set at the total number of the bulk components 472 to be supplied from the one bulk feeder 402 for production of the planned number of the circuit boards 40 (hereinafter referred to as "total bulk-component supply number").

At S4, it is determined for one of the two bulk feeders 402 whether or not a total production time is longer than a blackening limit time for the bulk components 472 to be supplied from the bulk feeder 402. The total production time is the total time required for the placement head 132 to place the twenty-one bulk components 472 and the three tape-feeder supply components onto each of the planned production number of the circuit boards 40 in the above-described two cycles. To calculate the total production time, a production time for one circuit board 40 is calculated based on, e.g., a distance and a speed of movement of the placement head 132 for taking images of fiducial marks, receiving components, and placing components, for example, and this production time is multiplied by the planned production number. While this explanation ignores blackening of the bulk components 472 due to a discharge promoting operation for discharging the bulk components 472 from the casing 412 to the pipe 520 by the component discharge promoting device 416 for the sake of simplification, the total production time may be calculated in consideration of this blackening.

The blackening is caused in a case where the bulk components 472 rub against each other in the casing 414 when the placement head 132 is moved. The blackening progresses with increase in time of the movement of the placement head 132, making the electronic circuit components unusable ultimately. The blackening limit time is the longest time in such a range that ensures the blackening does not progress to a degree in which the bulk components 472 become unusable. The blackening limit time is obtained by experiments in advance for each type of the bulk components 472 and stored into a blackening time memory provided in the RAM of the module control computer 120 in association with the type of the bulk component 472. The blackening time memory constitutes a storage device. This applies to other memories.

When the total production time is longer than the blackening limit time, this flow goes to S8 at which the maximum component supply number in such a range that does not exceed the blackening limit is set as the initial loading number, and this number is transmitted to the control computer 822 of the component loading device 700 for loading the bulk components 472 to the one bulk feeder 402. The bulk feeders 402 and the component loading devices 700 are associated with each other by the type of the bulk components 472 to be supplied by the bulk feeders 402. The maximum component supply number in such a range that does not exceed the blackening limit is calculated, for example, by calculating the number of the circuit boards 40 producible within the blackening limit time and multiplying the calculated number by the number of the bulk components 472 to be supplied by the one bulk feeder 402 for placement on the one circuit board 40. In this example, the maximum component supply number is a target supply number as a target supply amount.

At S9, it is determined whether or not the maximum component supply number calculated at S8 is equal to or larger than the maximum suppliable number as the maximum suppliable amount for the casing 412. The maximum suppliable number is the maximum number of the bulk components 472 accommodatable in the casing 412 appropriately (e.g., in a state in which an appropriate space remains in an upper portion of the casing 412). This maximum suppliable number is set in advance for each type of the bulk components 472 and stored in a maximum suppliable number the memory provided in the RAM of the module control computer 120 in association with the types of the bulk components 472.

When the maximum component supply number is smaller than the maximum suppliable number, a negative decision (NO) is made at S9, and this flow goes to S10 at which the maximum component supply number is set as the initial loading number and transmitted to the component-loading-device control computer 822 for loading the bulk components 472 into the one bulk feeder 402. Also, at S10, the maximum component supply number as the initial loading number is set as an initial value of a suppliable number which is an amount of the bulk components 472 suppliable from the bulk feeder 402, and this maximum component supply number is stored into a suppliable-number initial value memory provided in the RAM of the module control computer 120 in association with bulk feeder identification data. The initial loading number is the number of the bulk components 472 accommodated first in the casing 412 and is the start number which is used for determination of a timing of supplementary loading and which is decremented in each supply of one bulk components 472. In the case where a positive decision (YES) is made at S4, and the initial loading number is set, the initial loading number is smaller than the total bulk-component supply number because the blackening limit time is shorter than the total production time, and the number of the bulk components 472 to be supplied within a length of time equal to or shorter than the blackening limit time is smaller than the total bulk-component supply number. Accordingly, restock or supplementary loading of the bulk components 472 for the bulk feeders 402 are required during the placement of the bulk components 472 onto the planned number of the circuit board 40, and this requirement is stored in a restock requirement memory provided in the RAM of the module control computer 120 in association with the bulk feeder identification data.

When the maximum component supply number is equal to or larger than the maximum suppliable number for the casing 412, a positive decision (YES) is made at S9, and this flow goes to S11 at which the maximum suppliable number for the casing 412 is set as the initial loading number. Also, the initial loading number is transmitted to the component-loading-device control computer 822, a component restock requirement is stored, and the maximum suppliable number as the initial loading number is set as an initial value of the component suppliable number. In this case, the target supply number is equal to or larger than the maximum suppliable number, and the maximum suppliable number can be considered to be the target supply number.

When the total production time is equal to or shorter than the blackening limit time, on the other hand, this flow goes to S5 at which it is determined whether or not the total bulk-component supply number is equal to or smaller than the maximum suppliable number for the casing 412. When the total bulk-component supply number is equal to or smaller than the maximum suppliable number for the casing 412, this flow goes to S6 at which the total bulk-component supply number calculated at S3 for the one bulk feeder 402 is set as the initial loading number and transmitted to the component-loading-device control computer 822. In this case, restock of the bulk components 472 is not required, and this non-requirement is stored into the restock requirement memory in association with the bulk feeder identification data. The initial value of the suppliable number is not set. In this case, the total bulk-component supply number is the target supply number.

When the total production time is equal to or shorter than the blackening limit time, but the total bulk-component supply number is larger than the maximum suppliable number for the casing 412, a negative decision (NO) is made at S5, a processing at S7 is executed as at S11. Even in the case where the total production time is short, some numbers of the bulk components 472 to be placed onto one circuit board may result in the total bulk-component supply number larger than the maximum suppliable number for the casing 412.

Upon completion of the processing at S6, S7, S10, or S11, this flow goes to S12 at which it is determined whether the initial loading number is set for all the bulk feeders 402 or not. Here, since the initial loading number has been set for only one of the two bulk feeders 402, a negative decision (NO) is made at S12, and the processings at S4-S11 are executed for the other bulk feeder 402.

When the initial loading number is set for each of the two bulk feeders 402, this flow goes to S13 at which the placement head 132 is moved to move a predetermined one of the two bulk feeders 402 to the component loading device 700 which is to load the bulk components 402 into the casing 412 of the bulk feeder 402. The placement head 132 is moved to a position at which the bulk feeder 402 overlaps the component loading device 700 in the X-axis direction and then moved in the Y-axis direction toward the component loading device 700.

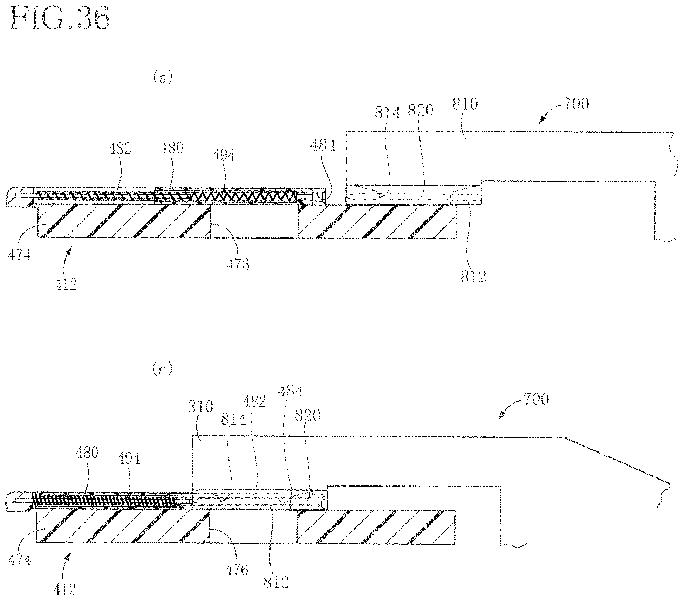

With this movement, as illustrated in Fig. 36(a), the shutter 480 provided on the casing 412 is moved closer to the drive member 812 of the component loading device 700, and as illustrated in Fig. 36(b) the drive member 812 covers the groove 482. Also, the rail 820 is fitted in the guide groove 484 to guide the casing 412 with respect to the drive member 812. After contacting the drive member 812, the shutter 480 is moved backward against the urging force of the spring 494 to open the opening 476. The placement head 132 is moved to a position predetermined for the component loading device 700. Specifically, as illustrated in Fig. 36(b), the placement head 132 is moved to a position at which the shutter 480 is moved to the open position to open the entire opening 476, and this entire opening 476 opposes and communicates with the component output opening 814 of the drive member 812 to establish a component loading state. This position is a component loading position, and when the placement head 132 is located at this component loading position, the component output opening 814 is located within the opening 476 in plan view. After the movement, a signal representative of completion of the movement is output from the module control computer 120 to the component-loading-device control computer 822.

In the component loading device 700, the component loading routine illustrated in Fig. 34 is executed to load the bulk components 472 into the casing 412. Initially at S21, it is determined whether the bulk feeder 402 has been moved or not, that is, it is determined whether the placement head 132 has been moved to the predetermined component loading position to open the opening 476 of the casing 412 or not. When a signal representative of completion of the movement is output from the module control device 32, a positive decision (YES) is made at S21, and the electric motor 754 is driven at S22 to rotate the component conveyor belt 750.

As a result, the leading component accommodation recess 804 storing the bulk components 472 and having reached the distal end of the horizontal portion 772 faces downward, so that the bulk component 472 falls in an unjoined or separate state into the casing 412 through the component output opening 814 and the opening 476 between the lower end portions 811, 813 of the respective side wall portions 796, 798. The bulk components 472 coming out of the component accommodation recesses 804 enter into the component output opening 814 while being guided by the inclined surfaces 815, 816, 817, 818. Also, as illustrated in Fig. 25, the movement of the component conveyor belt 750 moves the empty component accommodation recesses 804 sequentially to a position opposing the output opening 734 of the casing 720, so that the bulk components 472 in the casing 720 enter into the component accommodation recesses 804 through the output opening 734.

It is determined at S23 whether or not an actual loaded number as an amount of the bulk components 472 actually loaded into the casing 412 has reached the target loading number, in this case, the initial loading number. The determination at S23 is made by determining whether a rotation angle of the electric motor 754 for rotating the component conveyor belt 750 has become equal to or greater than a set rotation angle. The average number of the bulk components 472 accommodated in one component accommodation recess 804 is obtained in advance, and the number of the component accommodation recesses 804 for loading the components into the casing 412 is obtained based on the average number and the target loading number. Then, an amount of transfer of the component conveyor belt 750 required for loading the bulk components 472 into this set number of the component accommodation recesses 804 is set, and a rotation angle of the electric motor 754 is set and used for the determination at S23. The set rotation angle is set by the component-loading-device control computer 822. The determination at S23 may be made in the following manner: the number of the component accommodation recesses 804 used to load the bulk components 472 is obtained based on the rotation angle of the electric motor 754, and this number is multiplied by the number of components accommodated in each of the component accommodation recesses 804 to obtain the actual loaded number, and this actual loaded number is compared with the target loading number.

The processing at S23 is repeated until the rotation angle of the electric motor 754 becomes equal to or greater than the set rotation angle, and thereby the actual loaded number reaches the target loading number. When the actual loaded number has reached the target loading number, this flow goes to S24 at which the electric motor 754 is stopped. After this stop, the electric motor 754 is rotated in its reverse direction to move back the component conveyor belt 750 by a set distance. The set distance is such a distance that ensures that the leading component accommodation recess 804 accommodating the bulk components 472 becomes horizontal and face upward. For example, the component conveyor belt 750 is moved back by a distance corresponding to two component accommodation recesses 804. The leading component accommodation recess 804 may not accommodate all the bulk components 472 of the planned number, and some of the bulk components 472 may be dropped and supplied.

Since the component conveyor belt 750 is moved back, even if the component conveyor belt 750 is stopped at the completion of loading in a state in which the leading component accommodation recess 804 accommodating the bulk components 472 inclines, and the bulk components 472 remain in the component accommodation recess 804, the component accommodation recess 804 becomes horizontal and faces upward, reliably preventing the bulk components 472 from falling out of the component accommodation recess 804. At the start of component loading, accordingly, the component conveyor belt 750 is initially moved forward by a distance equal to the above-described distance by which the component conveyor belt 750 is moved backward, and the component conveyor belt 750 is then rotated until the rotation angle of the electric motor 754 becomes equal to or greater than the set rotation angle. Excess bulk components 472 remaining in this component accommodation recess 804 are loaded into the casing 412, but the amount of these excess bulk components 472 is small when compared with the total amount of the components 472 loaded into the casing 412, causing no problems accordingly. After the component conveyor belt 750 is moved backward, a signal indicating the completion of the loading of the bulk components 472 is output to the module control computer 120.

During loading of the components, the initial loading number setting routine is repeated at S14. When the component-loading completion signal is output from the component-loading-device control computer 822, a positive decision (YES) is made at S14, and this flow goes to S15 at which it is determined whether the component loading is completed for the two bulk feeders 402 or not. Here, the component loading has not been completed for the two bulk feeders 402, a negative decision (NO) is made at S15, and the processings at S13 and S14 are executed for the other bulk feeder 402. The placement head 132 is initially moved in the Y-axis direction, specifically, in a direction in which the one bulk feeder 402 is moved away from the component loading device 700. As a result, the placement head 132 is moved to the spaced position at which the drive member 812 is not fitted in the groove 482, and the opening 476 is spaced apart from the component output opening 814, and the shutter 480 is moved by the urging force of the spring 494 and closes the opening 476, establishing an interrupting state in which the communication between the opening 476 and the component output opening 814 is interrupted. After the placement head 132 is moved in the Y-axis direction until the entire casing 412 is moved off the extending portion 810 of the component loading device 700, the other bulk feeder 402 is moved to the component loading device 700 for loading the bulk components 472 into the casing 412 of the bulk feeder 402.

Positioning of the other bulk feeder 402 with respect to the component loading device 700, opening and closing of the shutter 480, and loading of the components in the other bulk feeder 402 are performed as in the one bulk feeder 402. Upon completion of the component loading, the component-loading completion signal is transmitted from the component-loading-device control computer 822 to the module control computer 120. As a result, a positive decision (YES) is made at S14, and a positive decision (YES) is also made at S15. This flow then goes to S16 at which information indicating the completion of loading is displayed on the display screen 834 and notified. In a case where the maximum suppliable number of the bulk components 472 is loaded into the casing 412, when the suppliable number has reached the upper limit, the notification is made. Also, the placement head 132 is moved to the board holding device 22 to start placing the bulk components 472 onto the circuit board 40. The completion of loading may be notified each time when the component loading is completed in any of the bulk feeders 402.

Upon placement of the bulk components 472 onto the circuit board 40, a supplementary loading number setting routine illustrated in Fig. 35 is executed in the module control computer 120. This routine is executed for each of the two bulk feeders 402 independently. There will be explained setting of a supplementary loading number for one bulk feeder 402.

This flow begins with S31 at which it is determined whether the components need to be restocked or not. This determination is made when the initial loading number of the bulk components 472 is set for the bulk feeder 402. When the initial loading number is set at the total bulk-component supply number, the bulk components 472 required to be placed onto the planned number of the circuit boards 40 are being held by the bulk feeder 402, and the restock is not required. Thus, a negative decision (NO) is made at S31, and this routine ends.

When the initial loading number is smaller than the total bulk-component supply number, and the restock of components is required, this flow goes to S32 at which it is determined whether the bulk component 472 has been taken out of the bulk feeder 402 by the pickup nozzle 172 or not. When the bulk component 472 is taken out in the bulk feeder 402 for which the supplementary loading number setting routine is being executed, this flow goes to S33 at which the suppliable number that is the number of the bulk components 472 suppliable by the bulk feeder 402 is decremented by one. The initial value of the suppliable number is set to the initial loading number at any of S7, S10, and S11.

At S34, it is determined whether or not the suppliable number is equal to or smaller than a set minimum number. The set minimum number is set at a number in which the bulk components 472 remain in the bulk feeder 402, but continuation of the supply may result in, e.g., a lack of the bulk components 472 during receipt of the bulk components 472 by the plurality of pickup nozzles 172 of the placement head 132 or a shortage of the bulk components 472 if the recovery of the failure in pickup or placement is carried out. When the suppliable number is larger than the set minimum number, a negative decision (NO) is made at S34, and this routine ends.

When the suppliable number becomes equal to or smaller than the set minimum number, this flow goes to S35 at which it is determined whether an unplaced component number is larger than the initial loading number or not. The unplaced component number is the number of the builk components 472 not having been placed yet on the ciurcuit board 40 among the bulk components 472 to be supplied from the bulk feeder 402 for the planned production number of the circuit boards 40. This unplaced component number can be obtained by subtracting the number of the placed bulk components 472 from the total bulk-component supply number. The placed component number is obtained based on the number of the circuit boards 40 for which the placement is completed, the number of the bulk components 472 placed on each circuit board 40, and, where placement is being performed for one circuit board 40, the number of the bulk components 472 placed on the circuit board 40.

When the unplaced component number is larger than the initial loading number, this flow goes to S36 at which the number obtained by subtracting the set minimum number from the initial loading number is set as the number of the components to be supplementarily loaded by the component loading device 700 into the bulk feeder 402, and this number is transmitted to the component-loading-device control computer 822. At S37, the placement head 132 is moved to the component loading device 700, the component loading device 700 loads the bulk components 472. The component loading routine is executed in the component loading device 700, and the bulk components 472 are loaded in the same manner as performed in the initial loading, with the supplementary loading number being used as the target loading number. However, the set rotation angle of the electric motor 754 is set based on the supplementary loading number. Upon completion of the loading of the components, a positive decision (YES) is made at S38 based on the output of the component-loading completion signal, and this flow goes to S39. At S39, the completion of loading is notified, and the placement head 132 is moved to the board holding device 22 to restart placing the bulk components 472 onto the circuit board 40.

When the unplaced component number becomes equal to or smaller than the initial loading number, this flow goes to S40. At S40, the number obtained by subtracting the set minimum number from the unplaced component number is set as the supplementary loading number and output to the component-loading-device control computer 822, and the component loading device 700 is allowed to supplemetarily load the bulk components 472. In this case, since additional loading of the bulk components 472 is not required, non-requirement of component restock is stored into the restock requirement memory instead of the component restock requirement. Thus, when the processing at S31 is executed for the next time, a negative decision (NO) is made, and S32-S40 are skipped.

There will be next explained forcible discharge of the components from the bulk feeder 402.

In the present embodiment, the forcible discharge is carried out for the casing 412 and the guide passage 500 to empty out the entire bulk feeder 402. The forcible discharge is performed when a type of the components to be supplied by the bulk feeder 402 is changed and when the placement head 132 finishes placing the electronic circuit components onto the circuit boards in the placement module 10, for example. In this forcible discharge, the placement head 132 is initially moved and stopped at a component-discharge working position which is determined in advance within the moving area of the placement head 132. For example, this component-discharge working position is a position located at the front most side of the placement module 10 in the front and rear direction and a central position of the placement module 10 in the right and left direction.

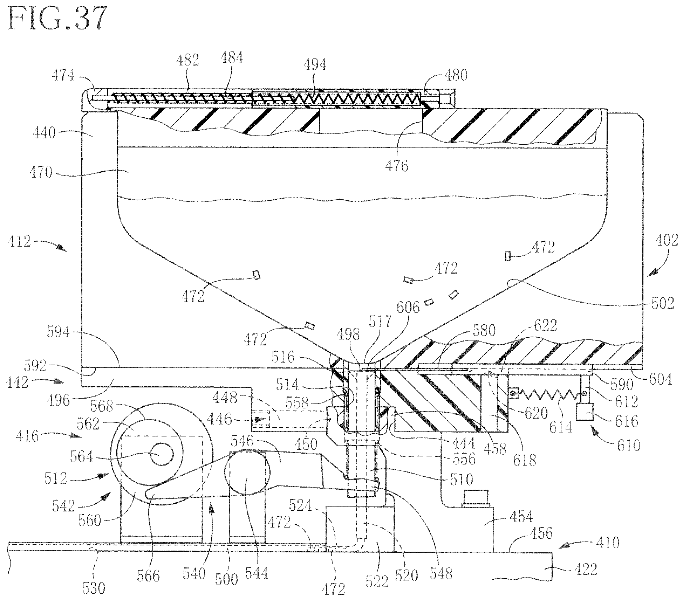

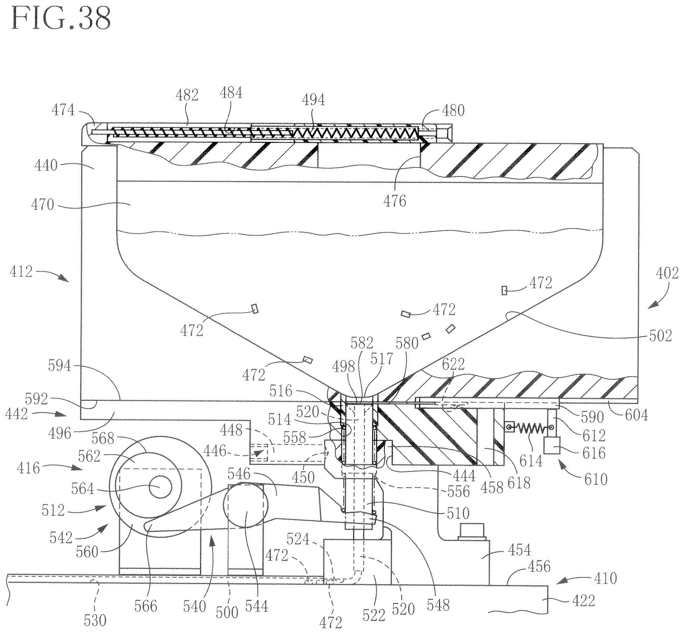

At this position, the operator removes the casing 412 from the feeder body 410. In this operation, as illustrated in Fig. 37, the discharge promoting pipe 510 is initially elevated by the discharge promoting pipe driving device 512 to a casing removing position at which an upper end face of the discharge prompting pipe 510 is located in the same plane in which the upper end face of the pipe 520 and the discharge hole 498 are located. The operator holds the operation portion 610 in this state and applies a forward force to the operating rod 590 to move the ball 620 of the ball plunger 618 out of the recessed portion 622 such that the ball 620 is disengaged from the operating rod 590. As a result, the operating rod 590 is moved forward by the urging force of the spring 614, so that the shutter 580 is moved to the closed position at which as illustrated in Fig. 38, the shutter 580 closes the lower opening 517 of the space 470. In this movement of the shutter 580, the closing portion 582 is moved into a position between the upper end surfaces of the discharge promoting pipe 510 and the pipe 520 and the bulk components 472 located on the upper end faces and further moved forward while scooping up these components.

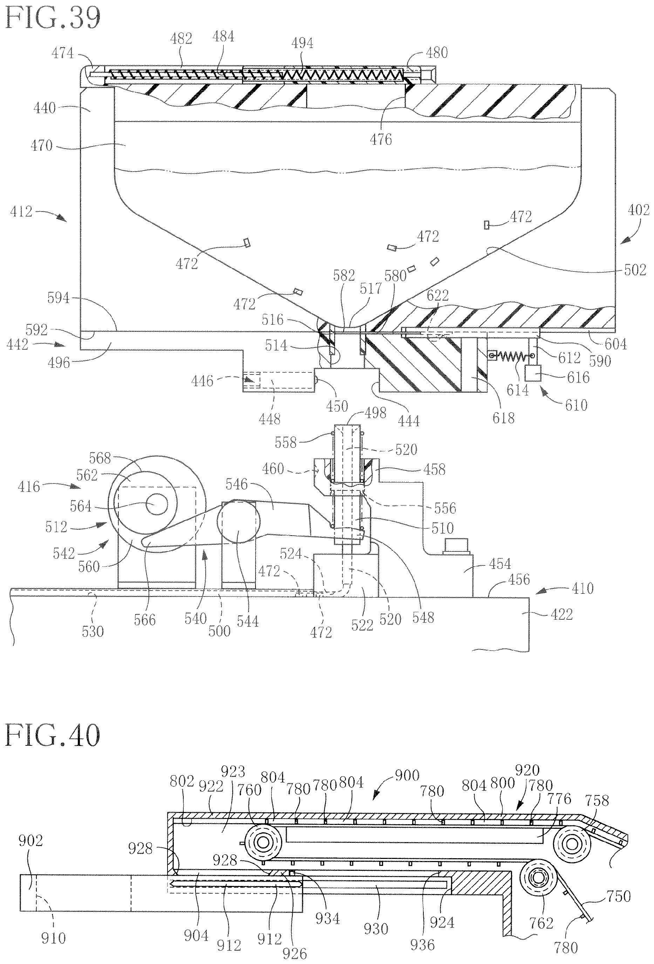

After the opening 517 is closed by the shutter 580, the operator raises the casing 412 and as illustrated in Fig. 39 moves the ball 450 of the ball plunger 446 out of the recessed portion 460 to remove the casing 412 from the feeder body 410. The operator brings the removed casing 412 to a component container, not shown, provided outside the placement module 10, then inverts the casing 412, then opens the shutter 480, and transfers the bulk components 472 into the component container to empty out the casing 412. The operator fits the recessed portion 444 of the empty casing 412 onto the mount portion 454 and mounts the empty casing 412 onto the feeder body 410. The operator then moves the shutter 580 to the open position to open the opening 517. The empty casing 412 is loaded with the electronic circuit components by the component loading device 700.

The bulk components 472 remaining in the pipe 520 and the guide passage 500 are transferred frontward by the component transferring device 414 and received by the component receiver 646. In this operation, the stopper 644 is moved to the exposing position to expose the guide passage 500, and the component receiver 646 is positioned to the accommodating position. Thus, when air is blown from the air blowing passages 630 to move the bulk components 472 frontward through the guide passage 500, the bulk components 472 are dropped out of the guide passage 500 into the component receiver 646. In this receipt of the bulk components 472, the bulk components 472 are brought into contact with the cushioning material 654 for reduced impact of the contact with the component receiver 646. That is, the bulk components 472 are dropped without damages and accommodated in the component receiver 646.

After the discharge of all the bulk components 472, the operator removes the component receiver 646 from the feeder body 410 and collects the accommodated bulk components 472. The operator moves the component receiver 646 upward or downward along the dovetail grooves 670 to remove the component receiver 646 from the feeder body 410 and transfers the accommodated bulk components 472 into the component container. After the collection of the bulk components 472, the operator fits the rails 664 into the respective dovetail grooves 670 to mount the component receiver 646 onto the feeder body 410 in the state in which the component receiver 646 is located at the non-accommodating position, and the stopper 644 is positioned to the stop position.

In the case where the forcible discharge of the bulk components 472 is carried out with the completion of use of the placement head 132, the forcible discharge may be carried out in a state in which the placement head 132 is removed from the second X-axis slide 148. The forcible discharge may also be carried out in the following manner: the forcible discharge of the bulk components 472 out of the guide passage 500 and the pipe 520 are carried out, with the placement head 132 being mounted on the second X-axis slide 148; and the forcible discharge of the bulk components 472 out of the casing 412 is carried out, with the placement head 132 being removed from the second X-axis slide 148. Furthermore, both of the forcible discharge out of the guide passage 500 and the pipe 520 and the forcible discharge out of the casing 412 may be carried out, with the placement head 132 being mounted on the second X-axis slide 148.

It is understood from the foregoing explanation that, in the present embodiment, the elevating and lowering device 262 constitutes a nozzle-holder advancing and retracting device as a first move-toward/away device, and the elevating and lowering device 260 constitutes a second move-toward/away device and a third move-toward/away device which serves as the second move-toward/away device. Also, the shutter 480 and the head moving device 134 constitute the communicating and interrupting device. The head moving device 134 is also a relative-movement device or a shutter driving device which moves the bulk feeder 402 and the component loading device 700 relative to each other to position the shutter 480 selectively to one of the open position and the closed position. Also, a portion of the module control device 32 which controls the head moving device 134 to move the placement head 132 selectively to one of the component loading position and the spaced position constitutes a component loading controller. Also, the construction in which the casing 412 is mountable on and removable from the feeder body 410, the component receiver 646 removably mounted on the feeder body 410, and a portion of the module control device 32 which controls the component transferring device 414 to transfer the bulk components 472 from the pipe 520 and the guide passage 500 into the component receiver 646 constitute a forcible discharger.

Also, a portion of the module control computer 120 which executes the processings at S1-S3 and S6 constitutes a first target supply amount determining unit, a portion of the module control computer 120 which executes the processings at S4, S8, and S10 constitutes a second target supply amount determining unit, and these units constitute a target supply amount setting unit. A portion of the module control computer 120 which executes the processings at S6, S7, S10, and S11 constitutes an initial loading amount determining unit and an initial holding amount determining unit, a portion of the module control computer 120 which executes the processings at S36 and S40 constitutes a supplementary loading amount determining unit, and these units constitute a target-loading-amount setting unit. A portion of the module control computer 120 which executes the processings at S7 and S11 constitutes an accommodating-portion maximum-suppliable-amount dependent initial loading amount determining unit and an accommodating-portion maximum-suppliable-amount dependent initial holding amount determining unit and can also be considered to constitute an accommodating-portion maximum-suppliable-amount dependent target supply amount setting unit.

Also, a portion of the component-loading-device control computer 822 which executes the processing at S23 constitutes an actual-loading-amount detecting device, and a portion of the component-loading-device control computer 822 which executes the processing at S24 constitutes an automatic loading stopper. A portion of the module control computer 120 which executes the processings at S16 and S39 constitutes the loading completion notifier, a portion of the module control computer 120 which executes the processing at S33 constitutes a suppliable amount detecting device, and a portion of the module control computer 120 which executes the processing at S37 constitutes a loading start controller.

It is noted that a configuration in which the processing at S6 is executed with S4 and S5 being omitted is one example of the first target supply amount determining unit configured to determine the target supply amount independently of a limit of performance deterioration due to the blackening.

While a simple case has been explained in the above-described embodiment for the receipt and placement of the bulk components 472 and the tape-feeder supply components by means of the placement head 132, operations and control for, e.g., receiving the electronic circuit components are not limited to those in the above-described embodiment. For example, at least one of the bulk components 472 and the same number of the tape-feeder supply components may be alternately received and placed onto the circuit board 40 by the twelve pickup nozzles 172. Also, both of the bulk components and the tape-feeder supply components may be received and placed in each of the plurality of cycles. Alternatively, only the tape-feeder supply components may be received and placed in one cycle.

This electronic-circuit-component placement machine may be configured such that only the bulk components may be placed onto one circuit board, and the placement head 132 receives the electronic circuit components from only the bulk feeder 402 moved with the pickup nozzles 172 to place the electronic circuit components onto the circuit board. In some cases, the placement head 132 may be used for placing only the tape-feeder supply components.

The forcible discharge of the components remaining in the guide passage 500 and the pipe 520 of the bulk feeders 402 may be carried out such that the bulk component 472 is received at the component receiving position by the pickup nozzle 172 and released at a component accommodating position as one of the stop positions which is located downstream of the component receiving position in the rotational direction of the rotary body 180, and thereby the bulk component 472 is accommodated into the component container disposed at the component accommodating position. The component container may be provided on the head body 186 and may be provided on the module body 18. In either case, the component container is mounted removably and removed by the operator who collects the bulk components 472 from the component container.

An actual loading amount of electronic circuit components loaded into the accommodating portion of the bulk feeder may be detected using a measurement of a loading time and may be detected using count of the number of electronic circuit components which pass through at least one of the component output opening and the component receiving opening. Examples of a method of obtaining the loading time includes: a measurement of a time of movement of the component conveyor belt; and a measurement of a time of passage of the electronic circuit components through the at least one of the component output opening and the component receiving opening.

A shutter may be provided on the component loading device to open and close the component output opening. One example of this structure will be explained with reference to Figs. 40-45.

As partially illustrated in Fig. 40, a component loading device 900 in the present embodiment is similar in construction to the component loading device 700 in the above-described embodiment except for a shutter 902 provided to open and close a component output opening 904. Thus, the same reference numerals as used for the elements of the component loading device 700 are used to designate the corresponding elements of the component loading device 900, and an explanation of which is dispensed with.

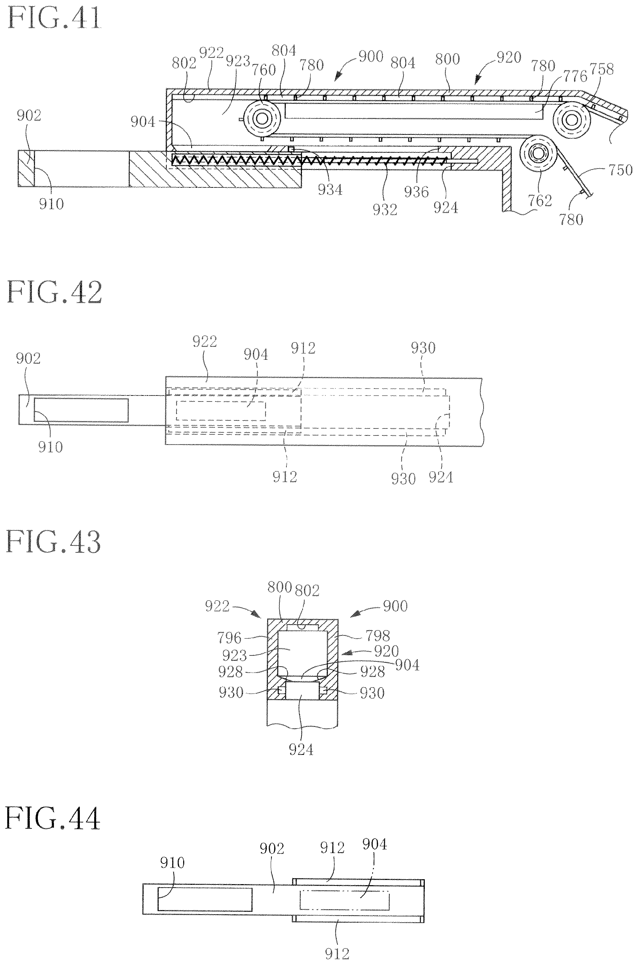

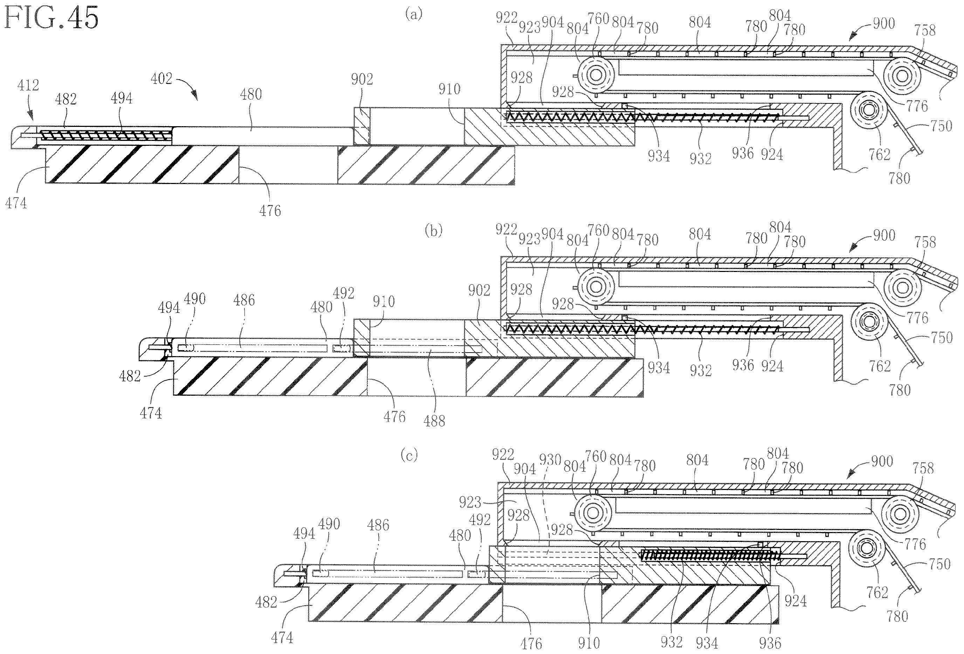

As illustrated in Figs. 40 and 44, the shutter 902 has a rectangular parallelepiped shape having such a width that the shutter 902 can be fitted in the groove 482 formed in the top portion 474 of the casing 412 of the bulk feeder 402. One of side portions of the shutter 902 in its longitudinal direction, namely, a front portion of the shutter 902 has an opening 910 which is formed through the shutter 902 in its thickness direction. As illustrated in Fig. 42, the opening 910 is rectangular in transverse cross section, and each of the width and length thereof is shorter than that of the opening 476 formed in the top portion 474 (see Fig. 45(b)). Rails 912 each as a guided portion extending parallel to the longitudinal direction of the shutter 902 are respectively provided on opposite side faces of the shutter 902 in the other end portion thereof in the longitudinal direction.

As illustrated in Figs. 40 and 43, an extending portion 922 provided on a front end portion of a device body 920 of the component loading device 900 has a groove 924 formed under an accommodation space 923 for accommodating the component conveyor belt 750, the guide roller 760, and so on. This groove 924 extends in a longitudinal direction of the extending portion 922 so as to open in a front end face and a lower face of the device body 920. A bottom wall of the groove 924 is a partition wall 926 serving as a partition between the groove 924 and the accommodation space 923, and an opening is formed through this partition wall 926 in its thickness direction or the up and down direction and constitutes the component output opening 904. The component output opening 904 has a rectangular shape in transverse cross section. Four side faces 928 of the component output opening 904 incline so as to be closer to each other in a direction directed from the accommodation space 923 toward the groove 924. A portion of the component output opening 904 at the groove 924 is smaller in size than a portion of the component output opening 904 at the opening 910 of the shutter 902.

As illustrated in Figs. 40 and 43, opposite side wall portions of the groove 924 which extend parallel to a longitudinal direction of the groove 924 have guide grooves 930 each opening to the groove 924 and extending in the longitudinal direction of the groove 924. Each of these guide grooves 930 constitutes a guide portion. The pair of rails 912 provided on the shutter 902 are respectively fitted in the guide grooves 930 so as to be slidable in the longitudinal direction of the shutter 902. A compression coil spring 932 (see Fig. 41) is provided between the shutter 902 and a rear end face of the groove 924 to urge the shutter 902 in a direction in which the shutter 902 projects frontward from the device body 920.

As illustrated in Fig. 41, forward movement of the shutter 902 due to an urging force of this spring 932 is limited when an engagement projection 934 projecting from an upper surface of the shutter 902 is engaged with a front end face of an elongate hole 936 as an engaging recessed portion formed in the partition wall 926. In this state, the shutter 902 is located at a closing position at which the opening 910 is located in front of the device body 920, and the other portion of the shutter 902 in its longitudinal direction, i.e., a rear portion of the shutter 902 closes the component output opening 904. The urging force of the spring 932 is larger than that of the spring 494 for urging the shutter 480 provided on the casing 412 to the closing position. In this component loading device 900, when the components 472 are not loaded into the casing 412, the shutter 902 is positioned at the closing position to prevent the components 472 from falling down out of the accommodation space 923.

When loading the components, the movement of the placement head 132 moves the casing 412 toward the component loading device 900 in the Y-axis direction in a state in which the casing 412 is positioned with respect to the component loading device 900 in the X-axis direction. As illustrated in Fig. 45(a), the shutter 902 is fitted into the groove 482 and brought into contact with the shutter 480. The casing 412 is further moved from this state, but the urging force of the spring 932 for urging the shutter 902 toward the closing position is larger than the urging force of the spring 494 for urging the shutter 480 toward the closing position as described above. Thus, the shutter 902 cannot be moved with respect to the device body 920, and as illustrated in Fig. 45(b) the shutter 480 is moved to the open position against the urging force of the spring 494 while the casing 412 is moved toward the component loading device 900.

In the present embodiment, the movement of the shutter 480 with respect to the casing 412 is limited when the guide projection 490 is brought into contact with an end face of the guide groove 486 which is farther than the other end face thereof from the guide groove 488. In this state, as illustrated in Fig. 45(b), the shutter 480 is positioned at the open position at which the opening 476 is opened, and the opening 910 of the shutter 902 overlies the opening 476.

The placement head 132 is moved toward the component loading device 900 from this state, but since the movement of the shutter 902 with respect to the casing 412 is inhibited, the casing 412 moves the shutter 902 with respect to the device body 920 against the urging force of the spring 932. The movement of the shutter 902 is guided by the rails 912 and the guide grooves 930. As illustrated in Fig. 45(c), the placement head 132 is moved and stopped at a position at which the shutter 902 is located at its opening position, and the component output opening 904 overlies the openings 910, 476 so as to be opened. The component conveyor belt 750 is thereafter moved, so that the components 472 are loaded into the space 470 of the casing 412 through the component output opening 904 and the openings 910, 476.

Upon completion of the loading of the components, the placement head 132 is moved away from the component loading device 900. In this movement, the shutter 902 is initially moved following the casing 412 with respect to the device body 920 by the spring 932 and moved to the closing position in the state in which the shutter 480 is kept at the open position, and finally the shutter 902 closes the component output opening 904 as illustrated in Fig. 45(b). After the engagement projection 934 is brought into contact with an front end face of the elongate hole 936, and the movement of the shutter 902 with respect to the device body 920 is stopped, as illustrated in Fig. 45(a), the casing 412 is moved with respect to the shutter 902 and the device body 920, so that the shutter 480 is moved forward by the urging force of the spring 494 to close the opening 476.

In the component loading device 900 in the present embodiment as described above, the component output opening 904 is opened and closed by the shutter 902. Accordingly, closing the shutter 902 upon completion of the loading of the components can prevent the components from falling down out of the device body 920, eliminating a need to move back the component conveyor belt 750 to prevent the components from falling down out of the leading component accommodation recess 804 accommodating the components. Even if the components fall down after the loading out of the component accommodation recess 804 in the state in which the component output opening 904 is closed by the shutter 902, the components 472 are received by the shutter 902. Movement of these components 472 with respect to the device body 920 is stopped by the side face 928, and the components 472 are moved with respect to the shutter 902 when opening the component output opening 904 for the next loading of components into the casing 412. When the component output opening 904 is opened, the components 472 are loaded into the casing 412 through the component output opening 904 and the openings 910, 476. Also, the component output opening 904 of the component loading device 900 is opened later and closed earlier than the opening 476 of the casing 412, avoiding a situation in which the components 472 falling down out of the component accommodation recess 804 in the accommodation space 923 fall down into a space other than the space formed in the casing 412.

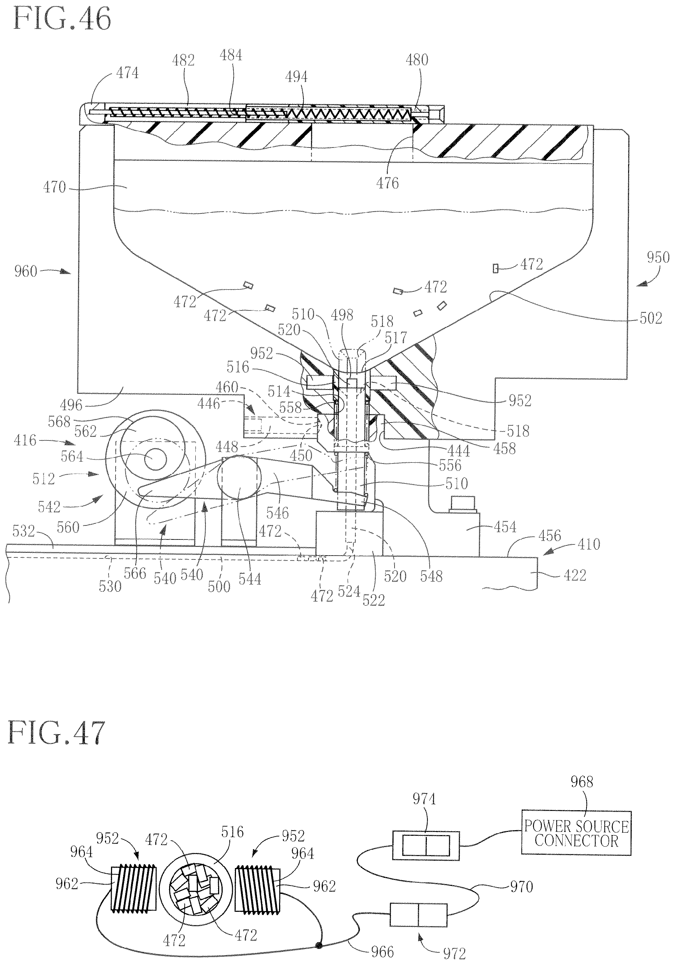

In a case where the accommodating portion of the bulk feeder is removable from the feeder body, magnets may be provided near an outer circumference of a portion of the accommodating portion which forms a component-outflow-side opening, to prevent an outflow of the components from the accommodating portion. One example of this configuration will be explained with reference to Figs. 46 and 47.

A bulk feeder 950 in the present embodiment is similar in construction to the bulk feeder 402 except for electromagnets 952 provided instead of the shutter 580. Thus, the same reference numerals as used for the elements of the bulk feeder 402 are used to designate the corresponding elements of the bulk feeder 950, and an explanation of which is dispensed with.

A casing 960 of this bulk feeder 950 is constructed such that portions thereof for defining the space 470 and the mating hole 514 are integral with each other. The electromagnets 952 are buried in a portion of the casing 960 in which the bushing 516 of the mating hole 514 is to be fitted and which is located on an upper side of the discharge promoting pipe 510 located at its lowermost position. The electromagnets 952 are provided as a pair so as to be spaced apart from each other in a diameter direction of the mating hole 514.

As illustrated in Fig. 47, each of the electromagnets 952 is constituted by an iron core 962 and a coil 964 wound around the iron core 962. The electromagnet 952 is provided in an attitude in which the electromagnet 952 extends perpendicular to a center line of the mating hole 514, and the coils 964 are wound respectively in directions reverse to each other. The respective coils 964 of the pair of electromagnets 952 are connected to a code 966. The code 966 is connected by a plug 972 to a code 970 which is connected to a power source connector 968 of the placement head 132. A switch 974 is provided on the code 970. This switch 974 is a manual switch whose open/closed state is switched by a manual operation of the operator. When the state is switched, a current is supplied to the two coils 964, or this current supply is interrupted.

In a state in which the casing 960 is mounted on the feeder body 410, the code 966 is connected to the code 970, but the switch 974 is open at its open position. Thus, the current is not supplied to the electromagnets 952, so that the electromagnets 952 are in a demagnetized state, establishing an outflow allowing state in which the outflow of the components 472 from the opening 517 is allowed.

When the casing 960 is removed from the feeder body 410, the operator switches the switch 974 to its closed position, so that the current is supplied to the respective coils 964 of the pair of electromagnets 952, establishing a magnetized state. Different magnetic poles are generated respectively in end portions of the iron core 962 of the respective electromagnets 952 which oppose to each other, and a magnetic field generated therebetween magnetizes electrodes of a plurality of the components 472 located in the bushing 516 and on an upper side of the discharge promoting pipe 510 located at its lowermost position. As a result, the components 472 are attracted and joined to each other and pressed on the inner circumferential surface of the bushing 516, preventing the components 472 from falling down from the opening 517.

Accordingly, the operator removes the casing 960 from the feeder body 410 in the state in which the current is supplied to the electromagnets 952, and after turning the casing 960 upside down to prevent the components 472 from falling down from the casing 960, the operator switches the switch 974 to the open position and disconnects the code 966 from the code 970. The operator thereafter brings the casing 960 to the component container provided outside the placement modules 10 and opens the shutter 480 to discharge the components 472 from the opening 476 and stores them into the component container.

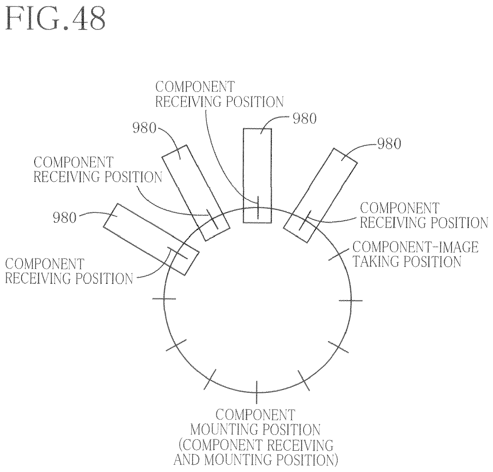

A plurality of the component suppliers may be provided such that their supply portions are arranged along an arc opposing the path of turning of the pickup nozzles which is caused by the rotation of the rotary body. One example of this configuration will be explained with reference to Fig. 48.

Though not shown, the placement head in the present embodiment is similar in construction to the placement head 132. Some of the five longest distance stop positions are set as the component receiving positions, for example, four longest distance stop positions, i.e., one longest distance stop position located on the most upstream side in the rotational direction of the rotary body in the placement of the components and three longest distance stop positions next to the one longest distance stop position are set as the component receiving positions, and the longest distance stop position located on the most downstream side is set as the component-image taking position.

One component supplier, e.g., one bulk feeder 980 is provided on each of positions respectively corresponding to the four component receiving positions of the head body. The bulk feeders 980 are similar in construction to the bulk feeders 402, and as schematically illustrated in Fig. 48, each of the bulk feeder 980 is provided such that its supply portion is located just under the pickup nozzle stopped at the component receiving position. Casings of the bulk feeders 980 located at the respective four component receiving positions respectively contain different types of components. Also, an elevating and lowering device and a valve switching device which are respectively similar in construction to the elevating and lowering device 262 and the valve switching device 300 are provided on each of portions of the head body which respectively correspond to the four component receiving positions.

In the present embodiment, each of the twelve pickup nozzles 172 receives the electronic circuit component from the bulk feeder 980 at any of the four component receiving positions and does not receive the electronic circuit component at the other three component receiving positions. Furthermore, an image of the electronic circuit component is taken at the component-image taking position, and the pickup nozzle 172 places the electronic circuit component onto the circuit board at the component placement position. The twelve pickup nozzles 172 place the electronic circuit components onto the circuit board 40 in the order set by the placement program. Thus, the type of the electronic circuit component received by each of the twelve pickup nozzles 172 is determined by the placement program, whereby the component receiving position for receiving the electronic circuit component is determined. In a case where a plurality of pickup nozzles are simultaneously positioned to their respective component receiving positions for receiving the electronic circuit components, the pickup nozzles receive the respective electronic circuit components simultaneously.

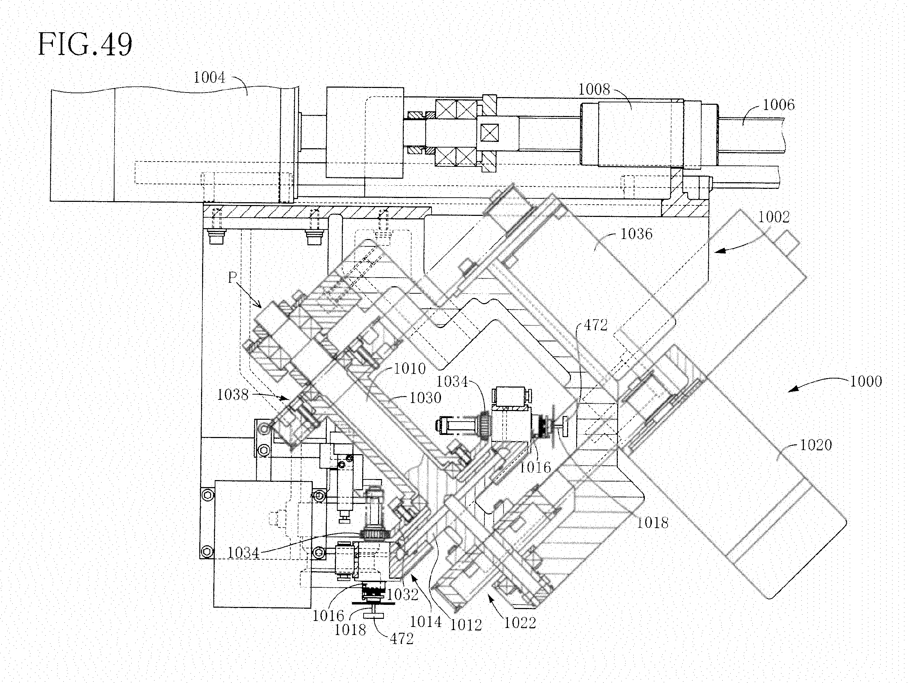

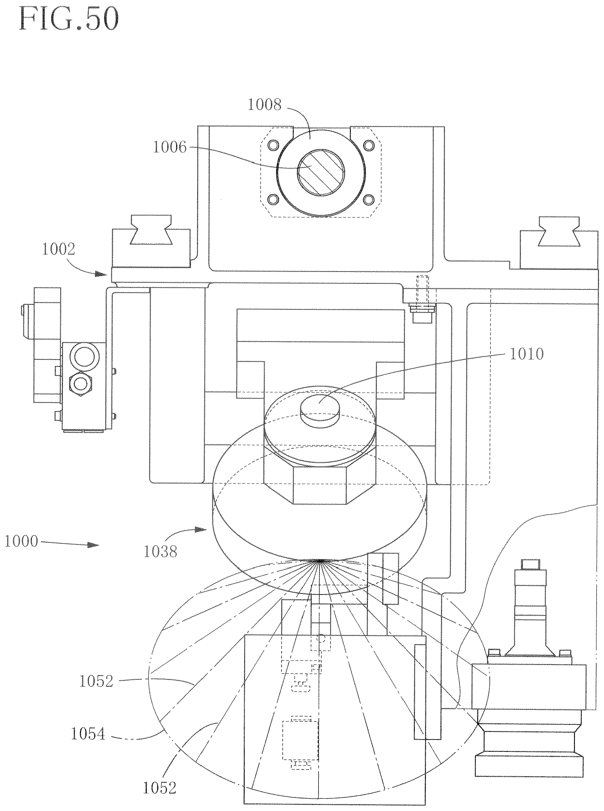

Unlike the placement head 132, the placement head may be designed such that the rotation axis of the rotary body is inclined with respect to a direction perpendicular to the component-placement surface of the circuit substrate held by the circuit substrate holder and such that the nozzle holder is held so as to be advanceable and retractable along a generatrix of a surface of a circular cone whose center line coincides with the rotation axis and whose diameter decreases with increase in distance from the circuit substrate holder, and this construction constitutes a distance increasing unit. One example of this configuration will be explained with reference to Figs. 49-52.

A placement head 1000 illustrated in Figs. 49-51 is constituted by adding a plurality of bulk feeders (four bulk feeders in the illustrated example) to a placement head described in JP-A-10-163677. Since a portion of the placement head 1000 other than a portion relating to the bulk feeders is substantially similar in construction to the placement head described in JP-A-10-163677 and will be simply explained. In Fig. 49, the placement head 1000 includes a head body 1002 constituted by a plurality of elements secured to each other. While the illustrated head body 1002 is constructed integrally with an X-axis slide which is moved in the X-axis direction by an X-axis servomotor 1004, a threaded shaft 1006, and a nut 1008, the head body 1002 may be separate from the X-axis slide like the placement head 132 and may be mountable on and removable from the X-axis slide without using any tools.

The head body 1002 includes a rotary body 1014 constituted by a rotation shaft 1010 and a rotary table 1012. The rotation shaft 1010 is held rotatably about a rotation axis inclined 45 degrees with respect to the vertical direction in a vertical plane perpendicular to the Y axis. The rotary table 1012 is fixed to a lower end of the rotation shaft 1010 so as to extend perpendicular to the above-described rotation axis. A peripheral portion of the rotary table 1012 holds a plurality of nozzle holders 1016 such that each nozzle holder 1016 is rotatable about its rotation axis. Each of the nozzle holders 1016 removably holds a pickup nozzle 1018. A center line of each of the rotation axes of the nozzle holders 1016 and the pickup nozzles 1018 coincides with the rotation axis of the rotation shaft 1010 and also coincides with a generatrix of a surface of a circular cone whose vertex angle is 90 degrees. Accordingly, when the rotary body 1014 is rotated by a turning servomotor 1020 and a rotation transmitting device 1022, the pickup nozzles 1018 are turned along the circular conical surface.

A hollow shaft 103 is provided on an outer side of the rotation shaft 1010 conaxially with the rotation shaft 1010 so as to be rotatable relative to the rotation shaft 1010. A drive gear 1032 fixed to a lower end of the hollow shaft 1030 is meshed with driven gears 1034 fixed to the respective nozzle holders 1016. Thus, when the hollow shaft 1030 is rotated by a nozzle-holder-rotating servomotor 1036 and a rotation transmitting device 1038, the pickup nozzles 1018 are rotated at the same time to change a rotational position of the component (the chip component) 472 held by each of the pickup nozzles 1018 about the rotation axis of the pickup nozzle 1018, i.e., an angle of the component 472 held by the pickup nozzle 1018.

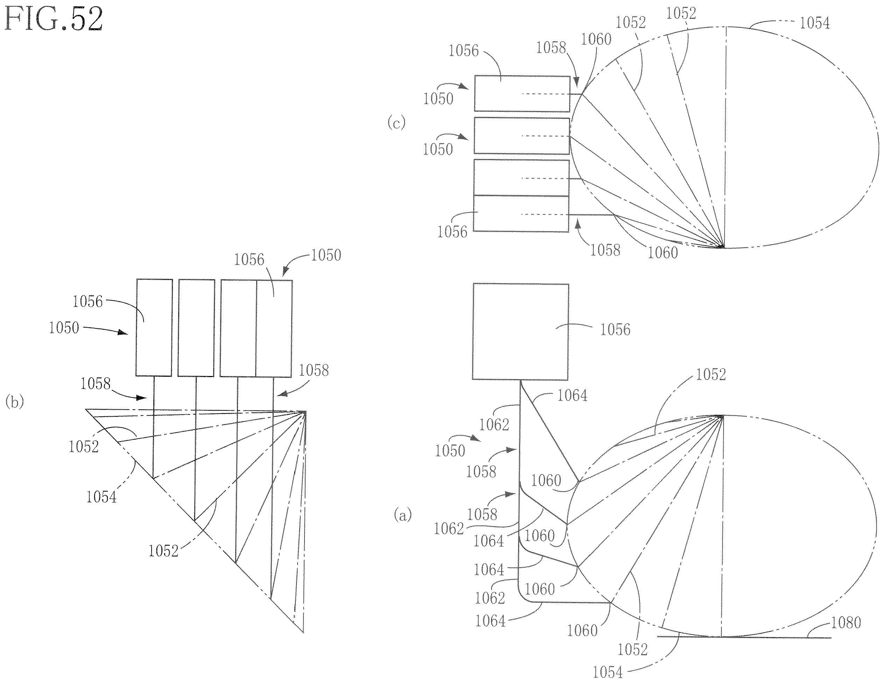

The head body 1002 holds bulk feeders 1050 as illustrated in Figs. 52(a)-(c). Fig. 52 omits specific illustrations of the placement head 1000 for simplicity and schematically illustrates only a relative positional relationship between the pickup nozzles 1018 and the bulk feeders 1050. In Fig. 52, one-dot chain lines indicate stop positions of rotation axes 1052 of the plurality of the pickup nozzles 1018 (the sixteen pickup nozzles 1018 in the illustrated example) when the rotary body 1014 is intermittently rotated, two-dot chain lines indicate a turning path 1054 of distal ends of the respective pickup nozzles 1018, and solid lines indicate casings (accommodating portions) 1056 of the bulk feeders 1050 and guide passages 1058.

Each of the guide passages 1058 is indicated simply by one solid line but in reality formed like the guide passage 500. Each guide passage 1058 includes a supply portion 1060 at a position opposing the turning path 1054, and the supply portion 1060 supplies the component 472 in a state in which the component 472 is supported by a groove bottom surface (inclining with respect to both of the horizontal plane and the vertical plane) perpendicular to the rotation axis of the pickup nozzles 1018. As is evident from Figs. 52(b) and 52(c), the guide passages 1058 extend along the vertical plane perpendicular to the X-axis direction. As illustrated in Fig. 52(a), each of the guide passages 1058 includes a vertical portion 1062 and an inclined portion 1064 inclining with respect to the horizontal plane. As exceptions, however, the guide passage 1058 illustrated in the uppermost position in Fig. 52(a) does not include the vertical portion 1062 (that is, the vertical portion 1062 has no length), and the inclined portion 1064 of the guide passage 1058 illustrated in the lowermost position has no angle of inclination.

Each of the casings 1056 is removable from the head body 1002, and a discharge promoting device like the discharge promoting pipe 510 illustrated in Fig. 12 and an outflow preventing member like the shutter 580 (or the electromagnets 952 illustrated in Fig. 46) are provided between the casings 1056 and the guide passage 1058. Also, each of the guide passages 1058 includes the vertical portion 1062 and the inclined portion 1064, and the components 472 are transferred to the supply portion 1060 due to gravity in these portions, but a means for moving the components 472 along the guide passage 1058 in a positive manner may be provided as needed as in the above-described embodiment. Also, though not explained specifically, the supply portion 1060 is provided with a means for, when stopping one component 472 moved through the guide passages 1058 or taking one component 472 out of the supply portion 1060, preventing the next component 472 from being pressed onto the one component 472 and interfering with taking out the one component 472.

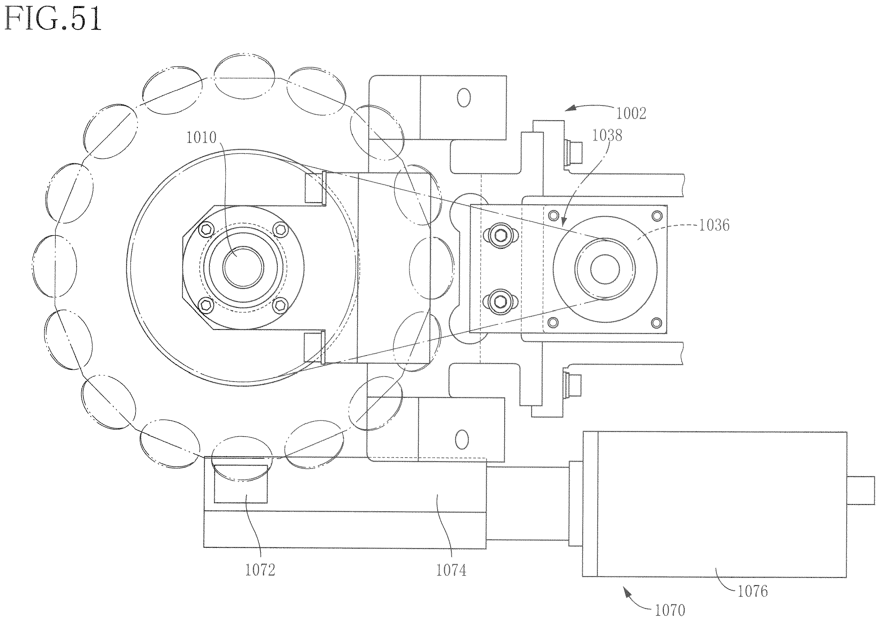

As illustrated in Fig. 51, the head body 1002 holds an image taking device 1070 provided on an opposite side of the placement head 1000 from the bulk feeder 1050. At one of the stop positions of the pickup nozzle 1018, the image taking device 1070 includes: a light guiding device 1074 having a light entering portion 1072 opposing an end face of the pickup nozzle 1018 in a direction parallel to the rotation axis of the pickup nozzle 1018; and a camera 1076 for taking an image of an electronic circuit component such as the component 472 based on light guided by the light guiding device 1074. While a position of the placement head 1000 at which the rotation axis of the pickup nozzle 1018 extends vertically is set as the placement position for placing the electronic circuit component, this position on the other hand is set at the component receiving position for receiving the component supplied from a stationary component supply device. At this position, a plurality of tape feeders are arranged along a straight line 1080 illustrated in Fig. 52(a).

Each of the plurality of pickup nozzles 1018 receives the electronic circuit component with the intermittent rotation of the rotary body 1014 in a state in which the pickup nozzle 1018 opposes a corresponding one of the supply portions 1060 of the plurality of bulk feeders 1050 or a corresponding one of the supply portions of the tape feeders. The pickup nozzle 1018 is thereafter stopped at an image taking position opposing the light entering portion 1072 of the image taking device 1070, and an image of the electronic circuit component is taken at the image taking position. The placement head 1000 is then moved to an upper side of the circuit board held by the circuit-board holding device to place the electronic circuit components onto the circuit board. While an error in a holding position at which the pickup nozzle 1018 holds the electronic circuit component is corrected in this operation, the holding angle at which the electronic circuit component is held is changed at the same time. Since the plurality of pickup nozzles 1018 are rotated together by the common nozzle-holder-rotating servomotor 1036 as described above, and an orientation of each electronic circuit component needs to be set to a predetermined orientation before placement of the electronic circuit component, the orientation of the electronic circuit component at the image taking of the image taking device 1070 may not coincide with that of the electronic circuit component placed on the circuit board. This situation occurs also in the placement head described in JP-A-10-163677, but there is a unique circumstance in the present embodiment. There will be explained this circumstance.

As is evident from Fig. 52, the inclined portions 1064 of the respective guide passages 1058 do not extend along a plane including the rotation axis of the rotation shaft 1010 and the rotation axis 1052 at each stop position of the pickup nozzle 1018, and angles of inclination with respect to the plane differ from each other among the inclined portions 1064. Thus, rotational positions of the component 472 supplied from the supply portion 1060 of each guide passage 1058 to the pickup nozzle 1018, relative to the pickup nozzle 1018 in a plane perpendicular to the rotation axis 1052 differ from each other according to the stop positions of the pickup nozzle 1018, that is, the angles at which the pickup nozzle 1018 holds the component 472 differ from each other according to the stop positions of the pickup nozzle 1018. Accordingly, this fact needs to be considered when placing the electronic circuit components onto the circuit board and obtaining an error in the holding angle at which the electronic circuit component is held, based on a result of the image taking of the image taking device 1070, and this is the unique circumstance in the present embodiment.

It is noted that the nozzle holder rotating device may be designed to rotate the plurality of nozzle holders 1016 individually. This applies to the above-described embodiments.

A component receiver moving device may be provided to automatically move the component receiver for collecting the electronic circuit components in the bulk feeder, to the non-accommodating position and the accommodating position. In this construction, for example, the component receiver is positioned at the non-accommodating position, and the stopper is positioned at the stop position to stop the electronic circuit component at the component taking position when the electronic circuit components are transferred, while the component receiver is positioned at the accommodating position, and the stopper is positioned at the exposing position when the electronic circuit component is taken out by the pickup nozzle, resulting in reduction of friction between the electronic circuit component to be taken out by the pickup nozzle and the electronic circuit component next to the electronic circuit component on an upstream side thereof in the component transferring direction. After the electronic circuit component is taken out, the component receiver is moved to the non-accommodating position, and the stopper is positioned at the stop position. A stopper moving device may be provided together with or instead of the component receiver moving device to automatically move the stopper to the stop position and the exposing position with respect to the component receiver.

The component conveying portion of the bulk feeder may be designed to use an electric motor as a drive source to convey the electronic circuit components and may be designed to use magnets to arrange the electronic circuit components in a row. For example, the component transferring device using the electric motor as the drive source includes an endless belt as a component conveying member and a belt rotating device using the electric motor as the drive source and is designed to convey the electronic circuit components arranged in a row on the belt.

In the case where the shutter is provided on the component loading device to open and close the component output opening, the urging force of the spring for urging the shutter toward its closing position and the urging force of the spring for urging the shutter for the casing of the bulk feeder toward its closing position may be equal to each other to open and close the shutter for the component loading device and the shutter for the casing of the bulk feeder at the same time.

The direction of movement of the plurality of component suppliers on the placement-unit body is not limited to the Y-axis direction and may be other directions. For example, the plurality of component suppliers may be moved in the X-axis direction or a direction inclining with respect to the X-axis direction and the Y-axis direction.

In the case where the first component supplier includes a plurality of the component feeders, all the component feeders may have the same structure, and at least two component feeders may have different structures. This applies to the second component supplier.

### EXPLANATION OF REFERENCE NUMERALS

10: placement module, 132: placement head, 134: head moving device, 170: nozzle holder, 172: pickup nozzle, 186: head body, 240: component-image taking device, 400: component supply device, 402: bulk feeder, 412: casing, 472: chip component, 700: component loading device, 722: component conveyor, 900: component loading device, 902: shutter, 950: bulk feeder, 952: electromagnet, 980: bulk feeder, 1000: placement head, 1016: nozzle holder, 1018: pickup nozzle, 1050: bulk feeder

## Claims

1. An electronic-circuit-component placement machine (10), comprising:
a placement-machine body (18);
a circuit substrate holder (22) which holds a circuit substrate (40) in a stationary state with respect to the placement-machine body (18) at least during a placement operation for placing the electronic circuit component;
a placement unit (132; 1000) which places the electronic circuit component onto the circuit substrate (40) held by the circuit substrate holder (22); and
a first relative-movement device (134) capable of moving the placement unit (132; 1000) relative to the circuit substrate holder (22) to a position in a plane extending parallel to a component-placement surface of the circuit substrate (40) held by the circuit substrate holder (22),
the electronic-circuit-component placement machine (10) being configured to cause the placement unit (132; 1000) to place the electronic circuit component onto the component-placement surface of the circuit substrate (40) held by the circuit substrate holder (22),
wherein the placement unit (132; 1000) comprises:
a placement-unit body (186; 1002);
a pickup nozzle (162, 172; 1018) held by the placement-unit body (186; 1002) and advanceable and retractable in an axial direction of the pickup nozzle (162, 172; 1018), the pickup nozzle (162, 172; 1018) comprising a pickup portion (197) at a front end portion thereof;
a component supplier (402; 950; 980; 1050) held by the placement-unit body (186; 1002) and comprising: an accommodating portion (412; 960; 1056) which accommodates a plurality of electronic circuit components (472); a supply portion (410; 1060) which supplies the plurality of electronic circuit components (472) one by one; and a component transferring portion (414) which transfers the plurality of electronic circuit components (472) from the accommodating portion (412; 960; 1056) to the supply portion (410; 1060);
a second relative-movement device (170, 180, 190; 1014, 1016, 1020, 1022) held by the placement-unit body (186; 1002) and capable of moving the pickup nozzle (162, 172; 1018) and the supply portion (410; 1060) of the component supplier (402; 950; 980; 1050) relative to each other in a direction intersecting the axial direction of the pickup nozzle (162, 172; 1018); and
a first move-toward/away device (262) held by the placement-unit body (186; 1002) and capable of moving the pickup nozzle (162, 172; 1018) and the supply portion (410; 1060) of the component supplier (402; 950; 980; 1050) toward and away from each other,
wherein the electronic-circuit-component placement machine (10) further comprises a second move-toward/away device (260) which moves the pickup nozzle (162, 172; 1018) and the circuit substrate (40) held by the circuit substrate holder (22) toward and away from each other,
wherein the second relative-movement device (170, 180, 190; 1014, 1016, 1020, 1022) comprises:
a nozzle holder (170; 1016) which holds the pickup nozzle (162, 172; 1018);
a movable member (180; 1014) which holds the nozzle holder (170; 1016) such that the nozzle holder (170; 1016) is advanceable and retractable in the axial direction of the pickup nozzle (162, 172; 1018) held by the nozzle holder (170; 1016); and
a movable-member driving device (190; 1020, 1022) which moves the movable member (180; 1014) to move the pickup nozzle (162, 172; 1018) held by the nozzle holder (170; 1016) selectively to one of a component receiving position at which the pickup nozzle (162, 172; 1018) is opposed to the supply portion (410; 1060) of the component supplier (402; 950; 980; 1050) and a deviated position deviating from the component receiving position in a direction intersecting the axial direction of the pickup nozzle (162, 172; 1018),
wherein the first move-toward/away device (262) comprises a nozzle holder advancing and retracting device (262) which advances and retracts the pickup nozzle (162, 172; 1018) held by the nozzle holder (170; 1016) to move the pickup nozzle (162, 172; 1018) toward and away from the supply portion (410; 1060) of the component supplier (402; 950; 980; 1050),
wherein the movable member (180; 1014) comprises a rotary body (180; 1014) rotatable about a rotation axis of the rotary body (180; 1014) and comprising a peripheral portion which holds the nozzle holder (170; 1016) such that the nozzle holder (170; 1016) is advanceable and retractable in the axial direction of the pickup nozzle (162, 172; 1018) held by the nozzle holder (170; 1016), and
wherein the movable-member driving device (190; 1020, 1022) comprises a rotary-body driving device (190; 1020, 1022) which rotates the rotary body (180; 1014) to move the pickup nozzle (162, 172; 1018) selectively one of the component receiving position and the deviated position.

2. The electronic-circuit-component placement machine (10) according to claim 1, further comprising:
a second component supplier (50) different from the component supplier (402; 950; 980; 1050) as a first component supplier (402; 950; 980; 1050) and held by the placement-machine body (18) without being held by the placement-unit body (186; 1002), the second component supplier (50) comprising: an accommodating portion (86) which accommodates a plurality of electronic circuit components (66); a supply portion (50) which supplies the electronic circuit components (66) one by one; and a component transferring portion (82) which transfers the electronic circuit components (66) from the accommodating portion (86) to the supply portion (50); and
a third move-toward/away device (260) configured to move the supply portion (50) of the second component supplier (50) and the pickup nozzle (162, 172; 1018) toward and away from each other.

3. The electronic-circuit-component placement machine (10) according to claim 1 or 2, further comprising a component-image taking device (240; 1070) held by the placement-unit body (186) and configured to take an image of the electronic circuit component picked up by the pickup portion (197) of the pickup nozzle (162, 172; 1018), in the axial direction of the pickup nozzle (162, 172; 1018).

4. The electronic-circuit-component placement machine (10) according to any one of claims 1 through 3,
wherein a plurality of component suppliers (402; 950; 980; 1050) each as the component supplier (402; 950; 980; 1050) are provided such that a plurality of supply portions (410; 1060) thereof each as the supply portion (410; 1060) are arranged along one straight line touching a curve opposing a path of turning of the pickup nozzle (162, 172; 1018) which is caused by the rotation of the rotary body (180), and
wherein the placement unit (132) comprises a third relative-movement device (420) configured to move the plurality of component suppliers (402; 950; 980; 1050) relative to the placement-unit body (186) in a direction parallel to the one straight line to selectively position the plurality of supply portions (410; 1060) of the plurality of component suppliers (402; 950; 980; 1050) one by one to a component supply position opposing the path of turning of the pickup nozzle (162, 172; 1018).

5. The electronic-circuit-component placement machine (10) according to any one of claims 1 through 3, wherein a plurality of component suppliers (402; 950; 980; 1050) each as the component supplier (402; 950; 980; 1050) are provided such that a plurality of supply portions (410; 1060) thereof each as the supply portion (410; 1060) are arranged along a curve opposing a path of turning of the pickup nozzle (162, 172; 1018) which is caused by the rotation of the rotary body (180).

6. The electronic-circuit-component placement machine (10) according to any one of claims 1 through 5, further comprising a distance increasing unit (220, 230) which increases a distance between the pickup portion (197) of the pickup nozzle (162, 172; 1018) and the circuit substrate holder (22) with the rotation of the rotary body (180),
wherein the component supplier (402; 950; 980; 1050) is disposed such that the supply portion (410; 1060) is located at a position which faces the pickup portion (197) of the pickup nozzle (162, 172; 1018) in the state in which the distance has been increased by the distance increasing unit (220, 230).

7. The electronic-circuit-component placement machine (10) according to any one of claims 1 through 6, wherein the component supplier (402; 950; 980; 1050) comprises a bulk feeder (402; 950; 980; 1050) in which the accommodating portion (412; 960; 1056) accommodates the plurality of electronic circuit components (472) in an unjoined state, and the component transferring portion (414) arranges the plurality of electronic circuit components (472) in a row and moves the plurality of electronic circuit components (472) to the supply portion (410; 1060).

8. The electronic-circuit-component placement machine (10) according to claim 7, further comprising a component loading device (700; 900) held by the placement-machine body (18) and configured to load the plurality of electronic circuit components (472) in the unjoined state into the accommodating portion (412; 960; 1056) of the bulk feeder (402; 950; 980; 1050) held by the placement-unit body (186).

9. The electronic-circuit-component placement machine (10) according to claim 8, wherein the circuit substrate holder (22) is configured to be kept in the stationary state at least during the placement operation for placing the electronic circuit component, wherein the first relative-movement device (134) is configured to move the placement-unit body (186) relative to the circuit substrate holder (22) being in the stationary state, to a position in the plane extending parallel to the component-placement surface of the circuit substrate (40) held by the circuit substrate holder (22), and wherein the electronic-circuit-component placement machine (10) further comprises a component loading controller (32) configured to control the first relative-movement device (134) to move the placement-unit body (186) selectively to one of a component loading position at which a component receiving opening (476) of the bulk feeder (402; 950; 980; 1050) opposes a component output opening (814; 904) of the component loading device (700; 900) and a spaced position at which the component receiving opening (476) is spaced apart from the component output opening (814; 904).

10. The electronic-circuit-component placement machine (10) according to claim 8 or 9, further comprising:
a target-loading-amount setting unit (120) configured to set a target loading amount which is an amount of electronic circuit components (472) to be loaded into the accommodating portion (412; 960; 1056) of the bulk feeder (402; 950; 980; 1050) held by the placement-unit body (186);
an actual-loading-amount detecting device (822) which detects an actual loading amount which is an amount of electronic circuit components (472) loaded from the component loading device (700; 900); and
at least one of (a) a loading completion notifier (120) which, when the actual loading amount detected by the actual-loading-amount detecting device (822) has reached the target loading amount set by the target-loading-amount setting unit (120), notifies the fact and (b) an automatic loading stopper (822) which automatically stops the loading of the component loading device (700; 900) when the actual loading amount detected by the actual-loading-amount detecting device (822) has reached the target loading amount set by the target-loading-amount setting unit (120).

## Patentansprüche

1. Maschine (10) zur Bestückung mit elektronischen Schaltungsbauteilen, die umfasst:
einen Bestückungsmaschinen-Körper (18);
einen Schaltungssubstrat-Halter (22), der ein Schaltungssubstrat (40) wenigstens während eines Bestückungsvorgangs zum Bestücken mit dem elektronischen Schaltungsbauteil in einem stationären Zustand in Bezug auf den Bestückungsmaschinen-Körper (18) hält;
eine Bestückungs-Einheit (132; 1000), die das von dem Schaltungssubstrat-Halter (22) gehaltene Schaltungssubstrat (40) mit dem Schaltungsbauteil bestückt; und
eine erste Einrichtung (134) für relative Bewegung, die in der Lage ist, die Bestückungs-Einheit (132; 1000) relativ zu dem Schaltungssubstrat-Halter (22) an eine Position in einer Ebene zu bewegen, die sich parallel zu einer Bauteil-Bestückungsfläche des durch den Schaltungssubstrat-Halter (22) gehaltenen Schaltungssubstrats (40) erstreckt,
wobei die Maschine (10) zur Bestückung mit elektronischen Schaltungsbauteilen so eingerichtet ist, dass sie die Bestückungs-Einheit (132; 1000) veranlasst, die Bauteil-Bestückungsfläche des durch den Schaltungssubstrat-Halter (22) gehaltenen Schaltungssubstrats (40) mit dem elektronischen Schaltungsbauteil zu bestücken,
und die Bestückungs-Einheit (132; 100) umfasst:
einen Körper (186;1002) der Bestückungs-Einheit;
eine Aufnahme-Düse (162, 172; 1018), die von dem Körper (186; 1002) der Bestückungs-Einheit gehalten wird und in einer axialen Richtung der Aufnahme-Düse (162, 172; 1018) ausgefahren und eingefahren werden kann, wobei die Aufnahme-Düse (162, 172; 1018) einen Aufnahme-Abschnitt (197) an ihrem vorderen Endabschnitt umfasst;
eine Bauteil-Zuführeinrichtung (402; 950; 980; 1050), die von dem Körper (186; 1002) der Bestückungs-Einheit gehalten wird und einen Aufnahme-Abschnitt (412; 960; 1056), der eine Vielzahl elektronischer Schaltungsbauteile (472) aufnimmt, einen Zuführ-Abschnitt (410; 1060), der die Vielzahl elektronischer Schaltungsbauteile (472) einzeln zuführt, sowie einen Abschnitt (414) zum Überführen von Bauteilen umfasst, der die Vielzahl elektronischer Schaltungsbauteile (472) von dem Aufnahme-Abschnitt (412; 960; 1056) zu dem Zuführ-Abschnitt (410; 1060) überführt;
eine zweite Einrichtung (170, 180, 190; 1014, 1016, 1020, 1022) für relative Bewegung, die von dem Körper (186; 1002) der Bestückungs-Einheit gehalten wird und in der Lage ist, die Aufnahme-Düse (162, 172; 1018) sowie den Zuführ-Abschnitt (410; 1060) der Bauteil-Zuführeinrichtung (402; 950; 980; 1050) relativ zueinander in einer Richtung zu bewegen, die die axiale Richtung der Aufnahme-Düse (162, 172; 1018) schneidet; sowie
eine erste Einrichtung (262) zum Bewegen aufeinander zu und voneinander weg, die von dem Körper (186; 1002) der Bestückungs-Einheit gehalten wird und in der Lage ist, die Aufnahme-Düse (162, 172; 1018) sowie den Zuführ-Abschnitt (410; 1060) der Bauteil-Zuführeinrichtung (402; 950; 980; 1050) aufeinander zu und voneinander weg zu bewegen,
wobei die Maschine (10) zur Bestückung mit elektronischen Schaltungsbauteilen des Weiteren eine zweite Einrichtung (260) zum Bewegen aufeinander zu und voneinander weg umfasst, die die Aufnahme-Düse (162, 172; 1018) und das von dem Schaltungssubstrat-Halter (22) gehaltene Schaltungssubstrat (40) aufeinander zu und voneinander weg zu bewegen,
und die zweite Einrichtung (170, 180, 190; 1014, 1016, 1020, 1022) für relative Bewegung umfasst:
einen Düsen-Halter (170; 1016), der die Aufnahme-Düse (162, 172; 1018) hält;
ein bewegliches Element (180; 1014), das den Düsen-Halter (170; 1016) so hält, dass der Düsen-Halter (170; 1016) in der axialen Richtung der von dem Düsen-Halter (170; 1016) gehaltenen Aufnahme-Düse (162, 172; 1018) ausgefahren und eingefahren werden kann; sowie
eine Einrichtung (190; 1020, 1022) zum Antreiben des beweglichen Elementes, die das bewegliche Element (180; 1014) bewegt, um die von dem Düsen-Halter (170; 1016) gehaltene Aufnahme-Düse (162, 172; 1018) selektiv an eine Position zum Aufnehmen von Bauteilen, an der die Aufnahme-Düse (162, 172; 1018) dem Zuführ-Abschnitt (410; 1060) der Bauteil-Zuführeinrichtung (402; 950; 980; 1050) gegenüberliegt, und eine abweichende Position zu bewegen, die von der Position zum Aufnehmen von Bauteilen in einer Richtung abweicht, die die axiale Richtung der Aufnahme-Düse (162, 172; 1018) schneidet,
wobei die erste Einrichtung (262) zum Bewegen aufeinander zu und voneinander weg eine Einrichtung (262) zum Ausfahren und Einfahren des Düsen-Halters umfasst, mit der die von dem Düsen-Halter (170; 1016) gehaltene Aufnahme-Düse (162, 172; 1018) ausgefahren und eingefahren wird, um die Aufnahme-Düse (162, 172; 1018) auf den Zuführ-Abschnitt (410; 1060) der Bauteil-Zuführeinrichtung (402; 950; 980; 1050) zu und von ihm weg zu bewegen,
wobei das bewegliche Element (180; 1014) einen Dreh-Körper (180; 1014) umfasst, der um eine Drehachse des Dreh-Körpers (180; 1014) herum gedreht werden kann und einen Umfangsabschnitt umfasst, mit dem der Düsen-Halter (170; 1016) so gehalten wird, dass der Düsen-Halter (170; 1016) in der axialen Richtung der von dem Düsen-Halter (170; 1016) gehaltenen Aufnahme-Düse (162, 172; 1018) ausgefahren und eingefahren werden kann, und
die Einrichtung (190; 1020, 1022) zum Antreiben des beweglichen Elementes eine Einrichtung (190; 1020, 1022) zum Antreiben des Dreh-Körpers umfasst, die den Dreh-Körper (180; 1014) dreht, um die Aufnahme-Düse (162, 172; 1018) selektiv an die Position zum Aufnehmen von Bauteilen und die abweichende Position zu bewegen.

2. Maschine (10) zum Bestücken mit elektronischen Bauteilen nach Anspruch 1, die des Weiteren umfasst:
eine zweite Bauteil-Zuführeinrichtung (50), die sich von der Bauteil-Zuführeinrichtung (402; 950; 980; 1050) als einer ersten Bauteil-Zuführeinrichtung (402; 950; 980; 1050) unterscheidet und von dem Bestückungsmaschinen-Körper (18) gehalten wird, ohne von dem Körper (186; 1002) der Bestückungs-Einheit gehalten zu werden, wobei die zweite Bauteil-Zuführeinrichtung (50) einen Aufnahme-Abschnitt (86), der eine Vielzahl elektronischer Schaltungsbauteile (66) aufnimmt, einen Zuführ-Abschnitt (50), der die elektronischen Schaltungsbauteile (66) einzeln zuführt, und einen Abschnitt (82) zum Überführen von Bauteilen umfasst, der die elektronischen Schaltungsbauteile (66) von dem Aufnahme-Abschnitt (86) zu dem Zuführ-Abschnitt (50) überführt; sowie
eine dritte Einrichtung (260) zum Bewegen aufeinander zu und voneinander weg, die so eingerichtet ist, dass sie den Zuführ-Abschnitt (50) der zweiten Bauteil-Zuführeinrichtung (50) und die Aufnahme-Düse (162, 172; 1018) aufeinander zu und voneinander weg bewegt.

3. Maschine (10) zum Bestücken mit elektronischen Bauteilen nach Anspruch 1 oder 2, die des Weiteren eine Einrichtung (240; 1070) zum Aufnehmen eines Bauteil-Bildes umfasst, die von dem Körper (186) der Bestückungs-Einheit gehalten wird und so eingerichtet ist, dass sie ein Bild des von dem Aufnahme-Abschnitt (197) der Aufnahme-Düse (162, 172; 1018) aufgenommenen elektronischen Schaltungsbauteils in der axialen Richtung der Aufnahme-Düse (162, 172; 1018) aufnimmt.

4. Maschine (10) zum Bestücken mit elektronischen Bauteilen nach einem der Ansprüche 1 bis 3,
wobei eine Vielzahl von Bauteil-Zuführeinrichtungen (402; 950; 980; 1050), die jeweils der Bauteil-Zuführeinrichtung (402; 950; 980; 1050) entsprechen, so eingerichtet sind, dass eine Vielzahl von Zuführ-Abschnitten (410; 1060) derselben, die jeweils dem Zuführ-Abschnitt (410; 1060) entsprechen, entlang einer geraden Linie angeordnet sind, die eine Kurve berührt, die einem Weg der Drehung der Aufnahme-Düse (162, 172; 1018) gegenüberliegt, die durch die Drehung des Dreh-Körpers (180) verursacht wird, und
die Bestückungs-Einheit (132) eine dritte Einrichtung (420) für relative Bewegung umfasst, die so eingerichtet ist, dass sie die Vielzahl von Bauteil-Zuführeinrichtungen (402; 950; 980; 1050) relativ zu dem Körper (186) der Bestückungs-Einheit in einer Richtung parallel zu der einen geraden Linie bewegt, um die Vielzahl von Zuführ-Abschnitten (410; 1060) der Vielzahl von Bauteil-Zuführeinrichtungen (402; 950; 980; 1050) einzeln selektiv an eine Position zum Zuführen von Bauteilen zu bringen, die dem Weg der Drehung der Aufnahme-Düse (162, 172; 1018) gegenüberliegt.

5. Maschine (10) zum Bestücken mit elektronischen Bauteilen nach einem der Ansprüche 1 bis 3, wobei eine Vielzahl von Bauteil-Zuführeinrichtungen (402; 950; 980; 1050), die jeweils der Bauteil-Zuführeinrichtung (402; 950; 980; 1050) entsprechen, so eingerichtet sind, dass eine Vielzahl von Zuführ-Abschnitten (410; 1060) derselben, die jeweils dem Zuführ-Abschnitt (410; 1060) entsprechen, entlang einer Kurve angeordnet sind, die einem Weg der Drehung der Aufnahme-Düse (162, 172; 1018) gegenüberliegt, die durch die Drehung des Dreh-Körpers (180) verursacht wird.

6. Maschine (10) zum Bestücken mit elektronischen Bauteilen nach einem der Ansprüche 1 bis 5, die des Weiteren eine Einheit (220, 230) zum Vergrößern eines Abstandes umfasst, die einen Abstand zwischen dem Aufnahme-Abschnitt (197) der Aufnahme-Düse (162, 172; 1018) und dem Schaltungssubstrat-Halter (22) mit der Drehung des Dreh-Körpers (180) vergrößert,
wobei die Bauteil-Zuführeinrichtung (402; 950; 980; 1050) so angeordnet ist, dass sich der Zuführ-Abschnitt (410; 1060) in dem Zustand, in dem der Abstand durch die Einheit (220, 230) zum Vergrößern eines Abstandes vergrößert worden ist, an einer dem Aufnahme-Abschnitt (197) der Aufnahme-Düse (162, 172; 1018) zugewandten Position befindet.

7. Maschine (10) zum Bestücken mit elektronischen Bauteilen nach einem der Ansprüche 1 bis 6, wobei die Bauteil-Zuführeinrichtung (402; 950; 980; 1050) eine Massen-Zuführeinrichtung (402; 950; 980; 1050) umfasst und der Aufnahme-Abschnitt (412; 960; 1056) die Vielzahl elektronischer Schaltungsbauteile (472) in einem losen Zustand aufnimmt ,und der Abschnitt (414) zum Überführen von Bauteilen die Vielzahl elektronischer Schaltungsbauteile (472) in einer Reihe anordnet und die Vielzahl elektronischer Schaltungsbauteile (472) zu dem Zuführ-Abschnitt (410; 1060) bewegt.

8. Maschine (10) zum Bestücken mit elektronischen Bauteilen nach Anspruch 7, die des Weiteren eine Bauteil-Einfülleinrichtung (700; 900) umfasst, die von dem Bestückungsmaschinen-Körper (18) gehalten wird und so eingerichtet ist, dass sie die Vielzahl elektronischer Schaltungsbauteile (472) in dem losen Zustand in den Aufnahme-Abschnitt (412; 960; 1056) der von dem Körper (186) der Bestückungs-Einheit gehaltenen Massen-Zuführeinrichtung (402; 950; 980; 1050) einfüllt.

9. Maschine (10) zum Bestücken mit elektronischen Bauteilen nach Anspruch 8, wobei der Schaltungssubstrat-Halter (22) so eingerichtet ist, dass er wenigstens während des Bestückungsvorgangs zum Bestücken mit dem elektronischen Schaltungsbauteil in dem stationären Zustand gehalten wird, die erste Einrichtung (134) für relative Bewegung so eingerichtet ist, dass sie den Körper (186) der Bestückungs-Einheit relativ zu dem in dem stationären Zustand befindlichen Schaltungssubstrat-Halter (22) an eine Position in der Ebene bewegt, die sich parallel zu der Bauteil-Bestückungsfläche des durch den Schaltungssubstrat-Halter (22) gehaltenen Schaltungssubstrats (40) erstreckt, und die Maschine (10) zum Bestücken mit elektronischen Bauteilen des Weiteren eine Einrichtung (32) zum Steuern von Füllen mit Bauteilen umfasst, die so eingerichtet ist, dass sie die erste Einrichtung (134) für relative Bewegung so steuert, dass sie den Körper (186) der Bestückungs-Einheit selektiv an eine Position zum Füllen mit Bauteilen, an der eine Bauteil-Aufnahmeöffnung (476) der Massen-Zuführeinrichtung (402; 950; 980; 1050) einer Bauteil-Ausgabeöffnung (814; 904) der Bauteil-Einfülleinrichtung (700; 900) gegenüberliegt, und eine beabstandete Position bewegt, an der die Bauteil-Aufnahmeöffnung (476) von der Bauteil-Ausgabeöffnung (814; 904) beabstandet ist.

10. Maschine (10) zum Bestücken mit elektronischen Bauteilen nach Anspruch 8 oder 9, die des Weiteren umfasst:
eine Einheit (120) zum Einstellen einer Soll-Einfüllmenge, die so eingerichtet ist, dass sie eine Soll-Einfüllmenge einstellt, die eine Menge elektronischer Schaltungsbauteile (472) ist, die in den Aufnahme-Abschnitt (412; 960; 1056) der von dem Körper (186) der Bestückungs-Einheit gehaltenen Massen-Zuführeinrichtung (402; 950; 980; 1050) einzufüllen ist;
eine Einrichtung (822) zum Erfassen einer Ist-Einfüllmenge, die eine Ist-Einfüllmenge erfasst, die eine von der Bauteil-Einfülleinrichtung (700; 900) eingefüllte Menge elektronischer Schaltungsbauteile (472) ist; und
a) eine Einrichtung (120) zum Benachrichtigen über Abschluss des Einfüllens, die, wenn die durch die Einrichtung (822) zum Erfassen einer Ist-Einfüllmenge erfasste Ist-Einfüllmenge die durch die Einheit (120) zum Einstellen einer Soll-Einfüllmenge eingestellte Soll-Einfüllmenge erreicht hat, über die Tatsache benachrichtigt oder/und b) eine Einrichtung (822) zum automatischen Unterbrechen des Einfüllens, die das Einfüllen durch die Bauteil-Einfülleinrichtung (700; 900) automatisch unterbricht, wenn die durch die Einrichtung (822) zum Erfassen einer Ist-Einfüllmenge erfasste Ist-Einfüllmenge die durch die Einheit (120) zum Einstellen einer Soll-Einfüllmenge eingestellte Soll-Einfüllmenge erreicht hat.

## Revendications

1. Machine de placement de composants de circuit électronique (10), comprenant :
un corps de machine de placement (18) ;
un support de substrat de circuit (22) qui maintient un substrat de circuit (40) dans un état fixe par rapport au corps de machine placement (18) au moins pendant une opération de placement permettant de placer le composant de circuit électronique ;
un module de placement (132; 1000) qui place le composant de circuit électronique sur le substrat de circuit (40) maintenu par le support de substrat de circuit (22) ; et
un premier dispositif de déplacement relatif (134) capable de déplacer le module de placement (132; 1000) par rapport au support de substrat de circuit (22) vers une position dans un plan s'étendant parallèlement à une surface de placement de composants du substrat de circuit (40) maintenu par le support de substrat de circuit (22),
la machine de placement de composants de circuit électronique (10) étant conçue pour amener le module de placement (132; 1000) à placer le composant de circuit électronique sur la surface de placement de composants du substrat de circuit (40) maintenu par le support de substrat de circuit (22),
dans laquelle le module de placement (132; 1000) comprend :
un corps de module de placement (186; 1002) ;
une buse de prélèvement (162, 172; 1018) supportée par le corps de module de placement (186; 1002) et pouvant être avancée et rétractée dans une direction axiale de la buse de prélèvement (162, 172; 1018), la buse de prélèvement (162, 172; 1018) comprenant une partie de prélèvement (197) au niveau d'une partie de son extrémité frontale ;
un dispositif d'alimentation de composants (402; 950; 980; 1050) supporté par le corps de module de placement (186; 1002) et comprenant une partie formant logement (412; 960; 1056) qui contient une pluralité de composants de circuit électronique (472) ; une partie d'alimentation (410; 1060) qui alimente la pluralité de composants de circuit électronique (472) un par un ; et une partie de transfert de composants (414) qui transfère la pluralité de composants de circuit électronique (472) de la partie formant logement (412; 960; 1056) vers la partie d'alimentation (410; 1060) ;
un second dispositif de déplacement relatif (170, 180, 190; 1014, 1016, 1020, 1022) supporté par le corps de module de placement (186; 1002) et capable de déplacer la buse de prélèvement (162, 172; 1018) et la partie d'alimentation (410; 1060) du dispositif d'alimentation de composants (402; 950; 980; 1050) l'une par rapport à l'autre dans une direction coupant la direction axiale de la buse de prélèvement (162, 172; 1018) ; et
un premier dispositif de rapprochement/éloignement (262) supporté par le corps de module de placement (186; 1002) et capable de rapprocher et éloigner la buse de prélèvement (162, 172; 1018) et la partie d'alimentation (410; 1060) du dispositif d'alimentation de composants (402; 950; 980; 1050) l'une de l'autre,
dans laquelle la machine de placement de composants de circuit électronique (10) comprend, en outre, un deuxième dispositif de rapprochement/éloignement (260) qui rapproche et éloigne la buse de prélèvement (162, 172; 1018) et le substrat de circuit (40) maintenu par le support de substrat de circuit (22) l'un de l'autre,
dans laquelle le second dispositif de déplacement relatif (170, 180, 190; 1014, 1016, 1020, 1022) comprend :
un support de buse (170; 1016) qui supporte la buse de prélèvement (162, 172; 1018);
un élément mobile (180; 1014) qui supporte le support de buse (170; 1016) de façon que le support de buse (170; 1016) puisse être avancé et rétracté dans la direction axiale de la buse de prélèvement (162, 172; 1018) tenue par le support de buse (170; 1016) ; et
un dispositif d'entraînement d'élément mobile (190; 1020, 1022) qui déplace l'élément mobile (180; 1014) pour déplacer la buse de prélèvement (162, 172; 1018) tenue par le support de buse (170; 1016) de manière sélective vers une position de réception de composant où la buse de prélèvement (162, 172; 1018) est opposée à la partie d'alimentation (410; 1060) du dispositif d'alimentation de composants (402; 950; 980; 1050) ou une position déviée s'écartant de la position de réception de composant dans une direction coupant la direction axiale de la buse de prélèvement (162, 172; 1018),
dans laquelle le premier dispositif de rapprochement/éloignement (262) comprend un dispositif d'avance et de rétraction de support de buse (262) qui avance et rétracte la buse de prélèvement (162, 172; 1018) tenue par le support de buse (170; 1016) pour rapprocher et éloigner la buse de prélèvement (162, 172; 1018) de la partie d'alimentation (410; 1060) du dispositif d'alimentation de composants (402; 950; 980; 1050),
dans laquelle l'élément mobile (180; 1014) comprend un corps rotatif (180; 1014) pouvant tourner autour d'un axe de rotation du corps rotatif (180; 1014) et comportant une partie périphérique qui supporte le support de buse (170; 1016) de façon que le support de buse (170; 1016) puisse être avancé et rétracté dans la direction axiale de la buse de prélèvement (162, 172; 1018) tenue par le support de buse (170; 1016), et
dans laquelle le dispositif d'entraînement d'élément mobile (190; 1020, 1022) comprend un dispositif d'entraînement de corps rotatif (190; 1020, 1022) qui fait tourner le corps rotatif (180; 1014) pour déplacer la buse de prélèvement (162, 172; 1018) de manière sélective vers la position de réception de composant ou la position déviée.

2. Machine de placement de composants de circuit électronique (10) selon la revendication 1, comprenant, en outre :
un second dispositif d'alimentation de composants (50) différent du dispositif d'alimentation de composants (402; 950; 980; 1050), formant le premier dispositif d'alimentation de composants (402; 950; 980; 1050), et supporté par le corps de machine de placement (18) sans être supporté par le corps de module de placement (186; 1002), le second dispositif d'alimentation de composants (50) comprenant une partie formant logement (86) qui contient une pluralité de composants de circuit électronique (66) ; une partie d'alimentation (50) qui alimente les composants de circuit électronique (66) un par un ; et une partie de transfert de composants (82) qui transfère les composants de circuit électronique (66) de la partie formant logement (86) vers la partie d'alimentation (50) ; et
un troisième dispositif de rapprochement/éloignement (260) conçu pour rapprocher et éloigner la partie d'alimentation (50) du second dispositif d'alimentation de composants (50) et la buse de prélèvement (162, 172; 1018) l'une de l'autre.

3. Machine de placement de composants de circuit électronique (10) selon la revendication 1 ou 2, comprenant, en outre, un dispositif de prise d'image de composant (240; 1070) supporté par le corps de module de placement (186) et conçu pour prendre une image du composant de circuit électronique prélevé par la partie de prélèvement (197) de la buse de prélèvement (162, 172; 1018), dans la direction axiale de la buse de prélèvement (162, 172; 1018).

4. Machine de placement de composants de circuit électronique (10) selon l'une quelconque des revendications 1 à 3,
dans laquelle une pluralité de dispositifs d'alimentation de composants (402; 950; 980; 1050), formant chacun le dispositif d'alimentation de composants (402; 950; 980; 1050), est fournie de façon qu'une pluralité de parties d'alimentation (410; 1060) de ce dispositif, formant chacune la partie d'alimentation (410; 1060), soient disposées le long d'une ligne droite touchant une courbe opposée à une trajectoire de rotation de la buse de prélèvement (162, 172; 1018) qui résulte de la rotation du corps rotatif (180), et
dans laquelle le module de placement (132) comprend un troisième dispositif de déplacement relatif (420) conçu pour déplacer la pluralité de dispositifs d'alimentation de composants (402; 950; 980; 1050) par rapport au corps de module de placement (186) dans une direction parallèle à la ligne droite pour positionner de manière sélective la pluralité de parties d'alimentation (410; 1060) de la pluralité de dispositifs d'alimentation de composants (402; 950; 980; 1050) une par une dans une position d'alimentation de composant opposée à la trajectoire de rotation de la buse de prélèvement (162, 172; 1018).

5. Machine de placement de composants de circuit électronique (10) selon l'une quelconque des revendications 1 à 3, dans laquelle une pluralité de dispositifs d'alimentation de composants (402; 950; 980; 1050), formant chacun le dispositif d'alimentation de composants (402; 950; 980; 1050), est fournie de façon qu'une pluralité de parties d'alimentation (410; 1060) de ce dispositif, formant chacune la partie d'alimentation (410; 1060), soient disposées le long d'une courbe opposée à une trajectoire de rotation de la buse de prélèvement (162, 172; 1018) résultant de la rotation du corps rotatif (180).

6. Machine de placement de composants de circuit électronique (10) selon l'une quelconque des revendications 1 à 5, comprenant, en outre, un module d'augmentation de distance (220, 230) qui augmente une distance entre la partie de prélèvement (197) de la buse de prélèvement (162, 172; 1018) et le support de substrat de circuit (22) avec la rotation du corps rotatif (180),
dans laquelle le dispositif d'alimentation de composants (402; 950; 980; 1050) est disposé de façon que la partie d'alimentation (410; 1060) soit située dans une position qui fait face à la partie de prélèvement (197) de la buse de prélèvement (162, 172; 1018) dans l'état dans lequel la distance a été augmentée par le module d'augmentation de distance (220, 230).

7. Machine de placement de composants de circuit électronique (10) selon l'une quelconque des revendications 1 à 6, dans laquelle le dispositif d'alimentation de composants (402; 950; 980; 1050) comprend un dispositif d'alimentation en vrac (402; 950; 980; 1050) dans lequel la partie formant logement (412; 960; 1056) contient la pluralité de composants de circuit électronique (472) à l'état non joints, et la partie de transfert de composants (414) agence la pluralité de composants de circuit électronique (472) en une rangée et déplace la pluralité de composants de circuit électronique (460) vers la partie d'alimentation (410; 1060).

8. Machine de placement de composants de circuit électronique (10) selon la revendication 7, comprenant, en outre, un dispositif de chargement de composants (700; 900) supporté par le corps de machine de placement (18) et conçu pour charger la pluralité de composants de circuit électronique (472) à l'état non joints dans la partie formant logement (412; 960; 1056) du dispositif d'alimentation en vrac (402; 950; 980; 1050) supporté par le corps de module de placement (186).

9. Machine de placement de composants de circuit électronique (10) selon la revendication 8, dans laquelle le support de substrat de circuit (22) est conçu pour être maintenu à l'état fixe au moins pendant l'opération de placement permettant de placer le composant de circuit électronique, dans laquelle le premier dispositif de déplacement relatif (134) est conçu pour déplacer le corps de module de placement (186) par rapport au support de substrat de circuit (22) à l'état fixe, vers une position dans le plan s'étendant parallèlement à la surface de placement de composants du substrat de circuit (40) maintenu par le support de substrat de circuit (22), et dans laquelle la machine de placement de composants de circuit électronique (10) comprend, en outre, un dispositif de commande de chargement de composants (32) conçu pour commander le premier dispositif de déplacement relatif (134) pour déplacer le corps de module de placement (186) de manière sélective vers une position de chargement de composants dans laquelle une ouverture de réception de composants (476) du dispositif d'alimentation en vrac (402; 950, 980; 1050) est opposée à une ouverture de sortie de composants (814; 904) du dispositif de chargement de composants (700; 900) ou une position écartée dans laquelle l'ouverture de réception de composants (476) est écartée de l'ouverture de sortie de composants (814; 904).

10. Machine de placement de composants de circuit électronique (10) selon la revendication 8 ou 9, comprenant, en outre :
un module de réglage de quantité de chargement cible (120) conçu pour fixer une quantité de chargement cible qui est une quantité de composants de circuit électronique (472) devant être chargés dans la partie formant logement (412; 960; 1056) du dispositif d'alimentation en vrac (402; 950; 980; 1050) supporté par le corps de module de placement (186) ;
un dispositif de détection de quantité de chargement réelle (822) qui détecte une quantité de chargement réelle qui est une quantité de composants de circuit électronique (472) chargés depuis le dispositif de chargement de composants (700; 900) ; et
au moins (a) un dispositif de notification de fin de chargement (120) qui, une fois que la quantité de chargement réelle détectée par le dispositif de détection de quantité de chargement réelle (822) a atteint la quantité de chargement cible fixée par le module de réglage de quantité de chargement cible (120), notifie ce fait, et/ou (b) un dispositif d'arrêt automatique de chargement (822) qui stoppe automatiquement le chargement du dispositif de chargement de composants (700; 900) quand la quantité de chargement réelle détectée par le dispositif de détection de quantité de chargement réelle (822) a atteint la quantité de chargement cible fixée par le module de réglage de quantité de chargement cible (120).
